(19) Europäisches Patentamt / European Patent Office / Office européen des brevets

(11) **EP 4 080 246 A1**

(12) **EUROPEAN PATENT APPLICATION**
published in accordance with Art. 153(4) EPC

(43) Date of publication:
26.10.2022 Bulletin 2022/43

(21) Application number: 20911293.7

(22) Date of filing: 31.12.2020

(51) International Patent Classification (IPC):
$G01S\ 17/894^{(2020.01)}$    $G01S\ 7/481^{(2006.01)}$
$H01S\ 5/42^{(2006.01)}$

(52) Cooperative Patent Classification (CPC):
G01S 7/481; G01S 17/08; G01S 17/894; H01S 5/42

(86) International application number:
PCT/CN2020/142433

(87) International publication number:
WO 2021/136527 (08.07.2021 Gazette 2021/27)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 03.01.2020 CN 202010006472

(71) Applicant: Huawei Technologies Co., Ltd. Longgang
Shenzhen, Guangdong 518129 (CN)

(72) Inventors:
• GUO, Banghui
Shenzhen, Guangdong 518129 (CN)
• SONG, Xiaogang
Shenzhen, Guangdong 518129 (CN)
• GAO, Shaorui
Shenzhen, Guangdong 518129 (CN)
• WU, Jushuai
Shenzhen, Guangdong 518129 (CN)
• LI, Xuan
Shenzhen, Guangdong 518129 (CN)
• LUO, Weicheng
Shenzhen, Guangdong 518129 (CN)
• QIU, Meng
Shenzhen, Guangdong 518129 (CN)

(74) Representative: Gill Jennings & Every LLP
The Broadgate Tower
20 Primrose Street
London EC2A 2ES (GB)

(54) **TOF DEPTH SENSOR MODULE AND IMAGE GENERATION METHOD**

(57) Disclosed are a TOF depth sensing module and an image generation method. The TOF depth sensing module (100) includes an array light source (110), a beam splitter (130), a collimation lens group (120), a receiving unit (140), and a control unit (150). The array light source (110) includes N light emitting regions. The N light emitting regions do not overlap each other. Each light emitting region is used to generate a beam. The collimation lens group (120) is located between the array light source (110) and the beam splitter (130). The control unit (150) is configured to control M light emitting regions of the N light emitting regions of the array light source (110) to emit light. The collimation lens group (120) is configured to perform collimation processing on beams from the M light emitting regions. The beam splitter (130) is configured to perform beam splitting processing on beams obtained after the collimation lens group (120) performs collimation processing. The receiving unit (140) is configured to receive reflected beams of a target object. By means of the TOF depth sensing module (100), high spatial resolution and a high frame rate can be implemented in a process of scanning the target object.

FIG. 3

## Description

This application claims priority to Chinese Patent Application No. 202010006472.3, filed with the China National Intellectual Property Administration on January 3, 2020 and entitled "TOF DEPTH SENSING MODULE AND IMAGE GENERATION METHOD", which is incorporated herein by reference in its entirety.

## TECHNICAL FIELD

This application relates to the field of TOF technologies, and more specifically, to a TOF depth sensing module and an image generation method.

## BACKGROUND

A time of flight (time of flight, TOF) technology is a frequently-used depth or distance measurement technology. A basic principle thereof is as follows: A transmit end emits continuous light or pulse light, the continuous light or the pulse light is reflected after the continuous light or the pulse light is irradiated to a to-be-measured object, and then a receive end receives reflected light of the to-be-measured object. Next, a time of flight of light from the transmit end to the receive end is determined, so that a distance or a depth from the to-be-measured object to a TOF system can be calculated.

A conventional TOF depth sensing module generally performs scanning in a manner of single-point scanning, multi-point scanning, or line scanning, and the conventional TOF depth sensing module generally simultaneously emits 1, 8, 16, 32, 64, or 128 emergent beams during scanning. However, a quantity of beams emitted by the TOF depth sensing module at a same moment is still limited, and high spatial resolution and a high frame rate cannot be implemented.

## SUMMARY

This application provides a TOF depth sensing module and an image generation method, so that a depth map obtained through scanning has high spatial resolution and a high frame rate.

According to a first aspect, a TOF depth sensing module is provided, where the TOF depth sensing module includes an array light source, a beam splitter, a collimation lens group, a receiving unit, and a control unit, the array light source includes N light emitting regions, the N light emitting regions do not overlap each other, each light emitting region is used to generate a beam, and the collimation lens group is located between the array light source and the beam splitter.

A function of each module or unit in the TOF depth sensing module is specifically as follows:

The control unit is configured to control M light emitting regions of the N light emitting regions of the array light source to emit light.

The collimation lens group is configured to perform collimation processing on beams emitted by the M light emitting regions.

The beam splitter is configured to perform beam splitting processing on beams obtained after the collimation lens group performs collimation processing.

The receiving unit is configured to receive reflected beams of a target object.

M is less than or equal to N, M is a positive integer, and N is a positive integer greater than 1. The beam splitter is specifically configured to split each received beam of light into a plurality of beams of light. The reflected beam of the target object is a beam obtained by the target object by reflecting a beam from the beam splitter. The beams emitted by the M light emitting regions may also be referred to as beams from the M light emitting regions.

The beam splitter can split one incident beam of light into a plurality of beams of light. Therefore, the beam splitter may also be referred to as a beam replicator.

The N light emitting regions may be N independent light emitting regions, that is, each light emitting region of the N light emitting regions may independently emit light without being affected by another light emitting region. For each light emitting region of the N light emitting regions, each light emitting region generally includes a plurality of light emitting units. In the N light emitting regions, different light emitting regions include different light emitting units, that is, one light emitting unit belongs only to one light emitting region. For each light emitting region, when the control unit controls the light emitting region to emit light, all light emitting units in the light emitting region may emit light.

A total quantity of light emitting regions of the array light source may be N. When M=N, the control unit may control all light emitting regions of the array light source to emit light simultaneously or through time division.

Optionally, the control unit is configured to control the M light emitting regions of the N light emitting regions of the array light source to simultaneously emit light.

For example, the control unit may control the M light emitting regions of the N light emitting regions of the array light source to simultaneously emit light at a moment T0.

Optionally, the control unit is configured to control the M light emitting regions of the N light emitting regions of the array light source to respectively emit light at M different moments.

For example, M=3. The control unit may control three light emitting regions of the array light source to respectively emit light at a moment T0, a moment T1, and a moment T2, that is, a first light emitting region of the three light emitting regions emits light at the moment T0, a second light emitting region emits light at the moment T1, and a third light emitting region emits light at the moment T2.

Optionally, the control unit is configured to control the M light emitting regions of the N light emitting regions of the array light source to separately emit light at M0 different moments, where M0 is a positive integer greater than 1 and less than M.

For example, M=3 and M0=2. The control unit may control one light emitting region of three light emitting regions of the array light source to emit light at a moment T0, and control the other two light emitting regions of the three light emitting regions of the array light source to emit light at a moment T1.

In this embodiment of this application, different light emitting regions of the array light source are controlled to emit light through time division, and the beam splitter is controlled to perform beam splitting processing on a beam, so that a quantity of beams emitted by the TOF depth sensing module in a time period can be improved, and high spatial resolution and a high frame rate can be implemented in a process of scanning the target object.

With reference to the first aspect, in some implementations of the first aspect, the receiving unit includes a receiving lens group and a sensor, and the receiving lens group is configured to converge the reflected beams to the sensor.

The sensor may also be referred to as a sensor array, and the sensor array may be a two-dimensional sensor array.

With reference to the first aspect, in some implementations of the first aspect, resolution of the sensor is greater than or equal to $P \times Q$, and a quantity of beams obtained after the beam splitter performs beam splitting on a beam from one light emitting region of the array light source is $P \times Q$, where both P and Q are positive integers.

The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

With reference to the first aspect, in some implementations of the first aspect, a beam receiving surface of the beam splitter is parallel to a beam emission surface of the array light source.

When the beam receiving surface of the beam splitter is parallel to the beam emission surface of the array light source, it is convenient to assemble the TOF depth sensing module, and an optical power of an emergent beam of the beam splitter may also be increased.

With reference to the first aspect, in some implementations of the first aspect, the beam splitter is any one of a cylindrical lens array, a microlens array, and a diffractive optical device.

With reference to the first aspect, in some implementations of the first aspect, the array light source is a vertical cavity surface emitting laser (vertical cavity surface emitting laser, VCSEL).

Optionally, the array light source is a Fabry-Perot laser (which may be briefly referred to as an FP laser).

Compared with a single VCSEL, a single FP laser may implement a larger power, and has higher electro-optic conversion efficiency than the VCSEL, so that a scanning effect of the TOF depth sensing module can be improved.

Optionally, a wavelength of a beam emitted by the array light source is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of a beam emitted by the array light source is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

With reference to the first aspect, in some implementations of the first aspect, a light emitting area of the array light source is less than or equal to $5 \times 5$ mm$^2$; an area of a beam incident end face of the beam splitter is less than $5 \times 5$ mm$^2$; and a clear aperture of the collimation lens group is less than or equal to 5 mm

Because sizes of the array light source, the beam splitter, and the collimation lens group are small, the TOF depth sensing module that includes the foregoing devices (the array light source, the beam splitter, and the collimation lens group) is easy to be integrated into a terminal device, so that space occupied in the terminal device can be reduced to an extent.

With reference to the first aspect, in some implementations of the first aspect, an average output optical power of the TOF depth sensing module is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

According to a second aspect, a TOF depth sensing module is provided, where the TOF depth sensing module includes an array light source, a beam splitter, a collimation lens group, a receiving unit, and a control unit, the array light source includes N light emitting regions, the N light emitting regions do not overlap each other, each light emitting region is used to generate a beam, and the beam splitter is located between the array light source and the collimation lens group.

A function of each module or unit in the TOF depth sensing module is specifically as follows:

The control unit is configured to control M light emitting regions of the N light emitting regions of the array light source to emit light, where M is less than or equal to N, M is a positive integer, and N is a positive integer greater than 1.

The beam splitter is configured to perform beam splitting processing on beams emitted by the M light emitting regions, where the beam splitter is specifically configured to split each received beam of light into a plurality of beams of light.

The collimation lens group is configured to perform collimation processing on beams from the beam splitter.

The receiving unit is configured to receive reflected beams of a target object, where the reflected beam of the target object is a beam obtained by the target object by reflecting a beam from the collimation lens group.

The beams emitted by the M light emitting regions may also be referred to as beams from the M light emitting regions.

In this embodiment of this application, different light emitting regions of the array light source are controlled to emit light through time division, and the beam splitter is controlled to perform beam splitting processing on a beam, so that a quantity of beams emitted by the TOF depth sensing module in a time period can be improved, and high spatial resolution and a high frame rate can be implemented in a process of scanning the target object.

A main difference between the TOF depth sensing module in the second aspect and the TOF depth sensing module in the first aspect is that locations of the collimation lens group are different. The collimation lens group in the TOF depth sensing module in the first aspect is located between the array light source and the beam splitter, and the beam splitter in the TOF depth sensing module in the second aspect is located between the array light source and the collimation lens group (which is equivalent to that the collimation lens group is located in a direction of an emergent beam of the beam splitter).

Optionally, the control unit is configured to control the M light emitting regions of the N light emitting regions of the array light source to simultaneously emit light.

Optionally, the control unit is configured to control the M light emitting regions of the N light emitting regions of the array light source to respectively emit light at M different moments.

Optionally, the control unit is configured to control the M light emitting regions of the N light emitting regions of the array light source to separately emit light at M0 different moments, where M0 is a positive integer greater than 1 and less than M.

With reference to the second aspect, in some implementations of the second aspect, the receiving unit includes a receiving lens group and a sensor, and the receiving lens group is configured to converge the reflected beams to the sensor.

The sensor may also be referred to as a sensor array, and the sensor array may be a two-dimensional sensor array.

With reference to the second aspect, in some implementations of the second aspect, resolution of the sensor is greater than or equal to P×Q, and a quantity of beams obtained after the beam splitter performs beam splitting on a beam from one light emitting region of the array light source is P×Q, where both P and Q are positive integers.

The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

With reference to the second aspect, in some implementations of the second aspect, a beam receiving surface of the beam splitter is parallel to a beam emission surface of the array light source.

When the beam receiving surface of the beam splitter is parallel to the beam emission surface of the array light source, it is convenient to assemble the TOF depth sensing module, and an optical power of an emergent beam of the beam splitter may also be increased.

With reference to the second aspect, in some implementations of the second aspect, the beam splitter is any one of a cylindrical lens array, a microlens array, and a diffractive optical device.

With reference to the second aspect, in some implementations of the second aspect, the array light source is a vertical cavity surface emitting laser (vertical cavity surface emitting laser, VCSEL).

Optionally, the array light source is a Fabry-Perot laser (which may be briefly referred to as an FP laser).

Compared with a single VCSEL, a single FP laser may implement a larger power, and has higher electro-optic conversion efficiency than the VCSEL, so that a scanning effect of the TOF depth sensing module can be improved.

Optionally, a wavelength of a beam emitted by the array light source is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of a beam emitted by the array light source is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

With reference to the second aspect, in some implementations of the second aspect, a light emitting area of the array light source is less than or equal to $5 \times 5$ mm$^2$; an area of a beam incident end face of the beam splitter is less than $5 \times 5$ mm$^2$; and a clear aperture of the collimation lens group is less than or equal to 5 mm.

Because sizes of the array light source, the beam splitter, and the collimation lens group are small, the TOF depth sensing module that includes the foregoing devices (the array light source, the beam splitter, and the collimation lens group) is easy to be integrated into a terminal device, so that space occupied when the TOF depth sensing module is integrated into the terminal device can be reduced to an extent.

With reference to the second aspect, in some implementations of the second aspect, an average output optical power of the TOF depth sensing module is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

According to a third aspect, an image generation method is provided, where the image generation method is applied to a terminal device that includes the TOF depth sensing module in the first aspect, and the image generation method includes: controlling, by using a control unit, M light emitting regions of N light emitting regions of an array light source to respectively emit light at M different moments; performing, by using a collimation lens group, collimation processing on beams that are respectively generated by the M light emitting regions at the M different moments, to obtain beams obtained after collimation processing is performed; performing, by using a beam splitter, beam splitting processing on the beams obtained after collimation processing is performed; receiving reflected beams of a target object by using a receiving unit; generating M depth maps based on TOFs corresponding to the beams that are respectively emitted by the M light emitting regions of the array light source at the M different moments; and obtaining a final depth map of the target object based on the M depth maps.

M is less than or equal to N, M is a positive integer, and N is a positive integer greater than 1. The beam splitter is specifically configured to split each received beam of light into a plurality of beams of light. The reflected beam of the target object is a beam obtained by the target object by reflecting a beam from the beam splitter.

The controlling, by using a control unit, M light emitting regions of N light emitting regions of an array light source to respectively emit light at M different moments may specifically mean respectively controlling, by using the control unit, the M light emitting regions to successively emit light at the M different moments.

The performing, by using a collimation lens group, collimation processing on beams that are respectively generated by the M light emitting regions at the M different moments may specifically mean respectively performing, by using the collimation lens group, collimation processing on the beams generated by the M light emitting regions at the M different moments.

For example, the control unit controls a light emitting region 1 to emit light at a moment T0, controls a light emitting region 2 to emit light at a moment T1, and controls a light emitting region 2 to emit light at a moment T2. In this case, the collimation lens group may perform, at the moment T0, collimation processing on a beam emitted by the light emitting region 1, perform, at the moment T1, collimation processing on a beam emitted by the light emitting region 2, and perform, at the moment T2, collimation processing on a beam emitted by the light emitting region 3.

Optionally, the method further includes: obtaining the TOFs corresponding to the beams that are respectively emitted by the M light emitting regions at the M different moments.

Optionally, the obtaining the TOFs corresponding to the beams that are respectively emitted by the M light emitting regions at the M different moments includes: determining, based on emission moments of the beams that are respectively emitted by the M light emitting regions at the M different moments and receiving moments of the corresponding reflected beams, the TOFs corresponding to the beams that are respectively emitted by the M light emitting regions at the M different moments.

The TOFs corresponding to the beams that are respectively emitted by the M light emitting regions of the array light source at the M different moments may be specifically time difference information between the emission moments of the beams that are respectively emitted by the M light emitting regions of the array light source at the M different moments and the receiving moments of the corresponding reflected beams.

For example, the array light source includes three light emitting regions A, B, and C, the light emitting region A emits a beam at a moment T0, the light emitting region B emits a beam at a moment T1, and the light emitting region C emits a beam at a moment T2. In this case, a TOF corresponding to the beam emitted by the light emitting region A at the moment T0 may be specifically time difference information between the moment T0 and a moment at which the beam emitted by the light emitting region A at the moment T0 finally arrives at the receiving unit (or is received by the receiving unit) after the beam is subject to collimation processing of the collimation lens group and beam splitting processing of the beam splitter, arrives at the target object, and is reflected by the target object. A TOF corresponding to the beam emitted by the light emitting region B at the moment T1 and a TOF corresponding to the beam emitted by the light emitting region C at the moment T2 also have similar meanings.

Optionally, the obtaining a final depth map of the target object based on the M depth maps may be splicing or combining the M depth maps to obtain the final depth map of the target object.

In addition, an approximately parallel beam can be obtained by performing collimation processing on a beam by using the collimation lens group, so that a power density of the beam can be improved, and an effect of subsequently performing scanning by using the beam can be improved.

In this embodiment of this application, different light emitting regions of the array light source are controlled to emit light through time division, and the beam splitter is controlled to perform beam splitting processing on a beam, so that a quantity of beams emitted by the TOF depth sensing module in a time period can be improved, to obtain a plurality of depth maps, and a final depth map obtained through splicing based on the plurality of depth maps has high spatial resolution and a high frame rate.

With reference to the third aspect, in some implementations of the third aspect, the M depth maps are respectively depth maps corresponding to M region sets of the target object, and there is no overlapping region between any two region sets in the M region sets.

With reference to the third aspect, in some implementations of the third aspect, the receiving unit includes a receiving lens group and a sensor, and the receiving reflected beams of a target object by using a receiving unit includes: converging the reflected beams of the target object to the sensor by using the receiving lens group.

The sensor may also be referred to as a sensor array, and the sensor array may be a two-dimensional sensor array.

With reference to the third aspect, in some implementations of the third aspect, resolution of the sensor is greater than or equal to P×Q, and a quantity of beams obtained after the beam splitter performs beam splitting on a beam from one light emitting region of the array light source is P×Q.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

With reference to the third aspect, in some implementations of the third aspect, the performing, by using a beam splitter, beam splitting processing on the beams generated after collimation processing is performed includes: performing, by using the beam splitter, one-dimensional or two-dimensional beam splitting processing on the beams generated after collimation processing is performed.

According to a fourth aspect, an image generation method is provided, where the image generation method is applied to a terminal device that includes the TOF depth sensing module in the third aspect, and the image generation method includes: controlling, by using a control unit, M light emitting regions of N light emitting regions of an array light source to respectively emit light at M different moments; performing, by using a beam splitter, beam splitting processing on beams that are respectively generated by the M light emitting regions at the M different moments; performing collimation processing on beams from the beam splitter by using a collimation lens group; receiving reflected beams of a target object by using a receiving unit, where the reflected beam is a beam by the target object obtained by reflecting a beam from the collimation lens group; generating M depth maps based on TOFs corresponding to the beams that are respectively emitted by the M light emitting regions of the array light source at the M different moments; and obtaining a final depth map of the target object based on the M depth maps.

The N light emitting regions do not overlap each other, M is less than or equal to N, M is a positive integer, and N is a positive integer greater than 1. The beam splitter is specifically configured to split each received beam of light into a plurality of beams of light.

The controlling, by using a control unit, M light emitting regions of N light emitting regions of an array light source to respectively emit light at M different moments may specifically mean respectively controlling, by using the control unit, the M light emitting regions to successively emit light at the M different moments.

The performing, by using a beam splitter, beam splitting processing on beams that are respectively generated by the M light emitting regions at the M different moments may specifically mean respectively performing, by using the beam splitter, beam splitting processing on the beams generated by the M light emitting regions at the M different moments.

For example, the control unit controls three light emitting regions of the array light source to respectively emit light at a moment T0, a moment T1, and a moment T2. Specifically, the light emitting region 1 emits light at the moment T0, the light emitting region 2 emits light at the moment T1, and the light emitting region 2 emits light at the moment T2. In this case, the beam splitter may perform, at the moment T0, beam splitting processing on a beam emitted by the light emitting region 1, perform, at the moment T1, beam splitting processing on a beam emitted by the light emitting region 2, and perform, at the moment T2, beam splitting processing on a beam emitted by the light emitting region 3.

Optionally, the method further includes: obtaining the TOFs corresponding to the beams that are respectively emitted by the M light emitting regions at the M different moments.

Optionally, the obtaining the TOFs corresponding to the beams that are respectively emitted by the M light emitting regions at the M different moments includes: determining, based on emission moments of the beams that are respectively emitted by the M light emitting regions at the M different moments and receiving moments of the corresponding reflected beams, the TOFs corresponding to the beams that are respectively emitted by the M light emitting regions at the M different moments.

The TOFs corresponding to the beams that are respectively emitted by the M light emitting regions of the array light source at the M different moments may be specifically time difference information between the emission moments of the beams that are respectively emitted by the M light emitting regions of the array light source at the M different moments and the receiving moments of the corresponding reflected beams.

For example, the array light source includes three light emitting regions A, B, and C, the light emitting region A emits a beam at a moment T0, the light emitting region B emits a beam at a moment T1, and the light emitting region C emits a beam at a moment T2. In this case, a TOF corresponding to the beam emitted by the light emitting region A at the moment T0 may be specifically time difference information between the moment T0 and a moment at which the beam emitted by the light emitting region A at the moment T0 finally arrives at the receiving unit (or is received by the receiving unit) after the beam is subject to collimation processing of the collimation lens group and beam splitting processing of the beam splitter, arrives at the target object, and is reflected by the target object. A TOF corresponding to the beam emitted by the light emitting region B at the moment T1 and a TOF corresponding to the beam emitted by the light emitting region C at the moment T2 also have similar meanings.

In this embodiment of this application, different light emitting regions of the array light source are controlled to emit light through time division, and the beam splitter is controlled to perform beam splitting processing on a beam, so that a quantity of beams emitted by the TOF depth sensing module in a time period can be improved, to obtain a plurality of depth maps, and a final depth map obtained through splicing based on the plurality of depth maps has high spatial resolution and a high frame rate.

With reference to the fourth aspect, in some implementations of the fourth aspect, the M depth maps are respectively depth maps corresponding to M region sets of the target object, and there is no overlapping region between any two region sets in the M region sets.

With reference to the fourth aspect, in some implementations of the fourth aspect, the receiving unit includes a receiving lens group and a sensor, and the receiving reflected beams of a target object by using a receiving unit includes: converging the reflected beams of the target object to the sensor by using the receiving lens group.

The sensor may also be referred to as a sensor array, and the sensor array may be a two-dimensional sensor array.

With reference to the fourth aspect, in some implementations of the fourth aspect, resolution of the sensor is greater than or equal to P×Q, and a quantity of beams obtained after the beam splitter performs beam splitting on a beam from one light emitting region of the array light source is P×Q.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

With reference to the fourth aspect, in some implementations of the fourth aspect, the respectively performing, by using a beam splitter, beam splitting processing on beams that are generated by the M light emitting regions at the M different moments includes: respectively performing, by using the beam splitter, one-dimensional or two-dimensional beam splitting processing on the beams that are generated by the M light emitting regions at the M different moments.

According to a fifth aspect, an image generation method is provided, where the image generation method is applied to a terminal device that includes the TOF depth sensing module in the first aspect, and the image generation method includes: determining a working mode of the terminal device, where the working mode of the terminal device includes a first working mode and a second working mode.

When the terminal device works in the first working mode, the image generation method further includes: controlling L light emitting regions of N light emitting regions of an array light source to simultaneously emit light; performing, by using a collimation lens group, collimation processing on beams emitted by the L light emitting regions; performing, by using a beam splitter, beam splitting processing on beams generated after the collimation lens group performs collimation processing; receiving reflected beams of a target object by using a receiving unit; and obtaining a final depth map of the target object based on TOFs corresponding to the beams emitted by the L light emitting regions.

L is less than or equal to N, L is a positive integer, and N is a positive integer greater than 1. The beam splitter is specifically configured to split each received beam of light into a plurality of beams of light. The reflected beam of the target object is a beam obtained by the target object by reflecting a beam from the beam splitter.

Optionally, when the terminal device works in the second working mode, the method further includes: obtaining the TOFs corresponding to the beams emitted by the L light emitting regions.

Optionally, the obtaining the TOFs corresponding to the beams emitted by the L light emitting regions includes: determining, based on emission moments of the beams emitted by the L light emitting regions and receiving moments of the corresponding reflected beams, the TOFs corresponding to the beams emitted by the L light emitting regions.

The TOFs corresponding to the beams emitted by the L light emitting regions may be specifically time difference information between the emission moments of the beams emitted by the L light emitting regions of the array light source and the receiving moments of the corresponding reflected beams.

When the terminal device works in the second working mode, the image generation method further includes: controlling M light emitting regions of N light emitting regions of an array light source to emit light at M different moments; performing, by using a collimation lens group, collimation processing on beams that are respectively generated by the M light emitting regions at the M different moments, to obtain beams obtained after collimation processing is performed; performing, by using a beam splitter, beam splitting processing on the beams obtained after collimation processing is performed; receiving reflected beams of a target object by using a receiving unit; generating M depth maps based on TOFs corresponding to the beams that are respectively emitted by the M light emitting regions at the M different moments; and obtaining a final depth map of the target object based on the M depth maps.

M is less than or equal to N, and both M and N are positive integers. The beam splitter is specifically configured to split each received beam of light into a plurality of beams of light. The reflected beam of the target object is a beam obtained by the target object by reflecting a beam from the beam splitter.

In the second working mode, the performing, by using a collimation lens group, collimation processing on beams that are respectively generated by the M light emitting regions at the M different moments may specifically mean respectively performing, by using the collimation lens group, collimation processing on the beams generated by the M light emitting regions at the M different moments.

For example, the control unit controls a light emitting region 1 to emit light at a moment T0, controls a light emitting region 2 to emit light at a moment T1, and controls a light emitting region 2 to emit light at a moment T2. In this case, the collimation lens group may perform, at the moment T0, collimation processing on a beam emitted by the light emitting region 1, perform, at the moment T1, collimation processing on a beam emitted by the light emitting region 2, and perform, at the moment T2, collimation processing on a beam emitted by the light emitting region 3.

The TOFs corresponding to the beams that are respectively emitted by the M light emitting regions of the array light source at the M different moments may be specifically time difference information between emission moments of the beams that are respectively emitted by the M light emitting regions of the array light source at the M different moments and receiving moments of the corresponding reflected beams.

In addition, an approximately parallel beam can be obtained by performing collimation processing on a beam by using the collimation lens group, so that a power density of the beam can be improved, and an effect of subsequently performing scanning by using the beam can be improved.

In this embodiment of this application, the image generation method has different working modes. Therefore, the depth map of the target object may be generated by selecting the first working mode or the second working mode based on different cases, so that flexibility of generating the depth map of the target object can be improved, and a high-resolution depth map of the target object can be obtained in the two working modes.

With reference to the fifth aspect, in some implementations of the fifth aspect, the M depth maps are respectively depth maps corresponding to M region sets of the target object, and there is no overlapping region between any two region sets in the M region sets.

With reference to the fifth aspect, in some implementations of the fifth aspect, the receiving unit includes a receiving lens group and a sensor, and the receiving reflected beams of a target object by using a receiving unit in the first working mode or the second working mode includes: converging the reflected beams of the target object to the sensor by using the receiving lens group.

The sensor may also be referred to as a sensor array, and the sensor array may be a two-dimensional sensor array.

With reference to the fifth aspect, in some implementations of the fifth aspect, resolution of the sensor is greater than or equal to $P \times Q$, and a quantity of beams obtained after the beam splitter performs beam splitting on a beam from one light emitting region of the array light source is $P \times Q$.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

With reference to the fifth aspect, in some implementations of the fifth aspect, in the first working mode, the obtaining a final depth map of the target object based on TOFs corresponding to the beams emitted by the L light emitting regions includes: generating depth maps of L regions of the target object based on the TOFs corresponding to the beams emitted by the L light emitting regions; and synthesizing the depth map of the target object based on the depth maps of the L regions of the target object.

With reference to the fifth aspect, in some implementations of the fifth aspect, in the second working mode, distances between M regions of the target object and the TOF depth sensing module are determined based on the TOFs corresponding to the beams that are respectively emitted by the M light emitting regions at the M different moments; depth maps of the M regions of the target object are generated based on the distances between the M regions of the target object and the TOF depth sensing module; and the depth map of the target object is synthesized based on the depth maps of the M regions of the target object.

With reference to the fifth aspect, in some implementations of the fifth aspect, the determining a working mode of the terminal device includes: determining the working mode of the terminal device based on working mode selection information of a user.

The working mode selection information of the user is used to select one of the first working mode and the second working mode as the working mode of the terminal device.

Specifically, when the image generation method is performed by the terminal device, the terminal device may obtain the working mode selection information of the user from the user. For example, the user may enter the working mode selection information of the user by using an operation interface of the terminal device.

The working mode of the terminal device is determined based on the working mode selection information of the user, so that the user can flexibly select and determine the working mode of the terminal device.

With reference to the fifth aspect, in some implementations of the fifth aspect, the determining a working mode of the terminal device includes: determining the working mode of the terminal device based on a distance between the terminal device and the target object.

With reference to the fifth aspect, in some implementations of the fifth aspect, the determining a working mode of the terminal device includes: determining the working mode of the terminal device based on a scenario in which the target object is located.

The working mode of the terminal device can be flexibly determined based on the distance between the terminal device and the target object or the scenario in which the target object is located, so that the terminal device works in a proper working mode.

With reference to the fifth aspect, in some implementations of the fifth aspect, the determining the working mode of the terminal device based on a distance between the terminal device and the target object includes: when the distance between the terminal device and the target object is less than or equal to a preset distance, determining that the terminal device works in the first working mode; or when the distance between the terminal device and the target object is greater than a preset distance, determining that the terminal device works in the second working mode.

When the distance between the terminal device and the target object is small, the array light source has a sufficient light emitting power to simultaneously emit a plurality of beams that arrive at the target object. Therefore, when the distance between the terminal device and the target object is small, the first working mode is used, so that a plurality of light emitting regions of the array light source can simultaneously emit light, to help subsequently obtain depth information of more regions of the target object, and improve a frame rate of the depth map of the target object when resolution of the depth map of the target object is fixed.

When the distance between the terminal device and the target object is large, because a total power of the array light source is limited, the depth map of the target object may be obtained by using the second working mode. Specifically, the array light source is controlled to emit beams through time division, so that the beams emitted by the array light source through time division can also arrive at the target object. Therefore, when the terminal device is far away from the target object, depth information of different regions of the target object can also be obtained through time division, to obtain the depth map of the target object.

With reference to the fifth aspect, in some implementations of the fifth aspect, the determining the working mode of the terminal device based on a scenario in which the target object is located includes: when the terminal device is in an indoor scenario, determining that the terminal device works in the first working mode; or when the terminal device is in an outdoor scenario, determining that the terminal device works in the second working mode.

When the terminal device is in the indoor scenario, because the distance between the terminal device and the target object is small, and external noise is weak, the array light source has a sufficient light emitting power to simultaneously emit a plurality of beams that arrive at the target object. Therefore, when the distance between the terminal device and the target object is small, the first working mode is used, so that a plurality of light emitting regions of the array light source can simultaneously emit light, to help subsequently obtain depth information of more regions of the target object, and improve a frame rate of the depth map of the target object when resolution of the depth map of the target object is fixed.

When the terminal device is in the outdoor scenario, because the distance between the terminal device and the target object is large, external noise is large, and a total power of the array light source is limited, the depth map of the target object may be obtained by using the second working mode. Specifically, the array light source is controlled to emit beams through time division, so that the beams emitted by the array light source through time division can also arrive at the target object. Therefore, when the terminal device is far away from the target object, depth information of different regions of the target object can also be obtained through time division, to obtain the depth map of the target object.

According to a sixth aspect, an image generation method is provided, where the image generation method is applied to a terminal device that includes the TOF depth sensing module in the second aspect, and the image generation method includes: determining a working mode of the terminal device, where the working mode of the terminal device includes a first working mode and a second working mode.

When the terminal device works in the first working mode, the image generation method further includes: controlling L light emitting regions of N light emitting regions of an array light source to simultaneously emit light; performing, by using a beam splitter, beam splitting processing on beams from the L light emitting regions; performing collimation processing on beams from the beam splitter by using a collimation lens group, to obtain beams obtained after collimation processing is performed; receiving reflected beams of a target object by using a receiving unit; and obtaining a final depth map of the target object based on TOFs corresponding to the beams emitted by the L light emitting regions.

L is less than or equal to N, L is a positive integer, and N is a positive integer greater than 1. The beam splitter is specifically configured to split each received beam of light into a plurality of beams of light. The reflected beam of the target object is a beam obtained by the target object by reflecting the beam obtained after collimation processing is performed.

Optionally, when the terminal device works in the second working mode, the method further includes: obtaining the TOFs corresponding to the beams emitted by the L light emitting regions.

Optionally, the obtaining the TOFs corresponding to the beams emitted by the L light emitting regions includes: determining, based on emission moments of the beams emitted by the L light emitting regions and receiving moments of the corresponding reflected beams, the TOFs corresponding to the beams emitted by the L light emitting regions.

The TOFs corresponding to the beams emitted by the L light emitting regions may be specifically time difference information between the emission moments of the beams emitted by the L light emitting regions of the array light source and the receiving moments of the corresponding reflected beams.

When the terminal device works in the second working mode, the image generation method further includes: controlling M light emitting regions of N light emitting regions of an array light source to emit light at M different moments; performing, by using a beam splitter, beam splitting processing on beams that are respectively generated by the M light emitting regions at the M different moments; performing collimation processing on beams from the beam splitter by using a collimation lens group; receiving reflected beams of a target object by using a receiving unit; generating M depth maps based on TOFs corresponding to the beams that are respectively emitted by the M light emitting regions at the M different moments; and obtaining a final depth map of the target object based on the M depth maps.

M is less than or equal to N, and both M and N are positive integers. The beam splitter is specifically configured to split each received beam of light into a plurality of beams of light. The reflected beam of the target object is a beam obtained by the target object by reflecting a beam from the collimation lens group.

In the second working mode, the performing, by using a beam splitter, beam splitting processing on beams that are respectively generated by the M light emitting regions at the M different moments may specifically mean respectively performing, by using the beam splitter, beam splitting processing on the beams generated by the M light emitting regions at the M different moments.

For example, the control unit controls three light emitting regions of the array light source to respectively emit light at a moment T0, a moment T1, and a moment T2. Specifically, the light emitting region 1 emits light at the moment T0, the light emitting region 2 emits light at the moment T1, and the light emitting region 2 emits light at the moment T2. In this case, the beam splitter may perform, at the moment T0, beam splitting processing on a beam emitted by the light emitting region 1, perform, at the moment T1, beam splitting processing on a beam emitted by the light emitting region 2, and perform, at the moment T2, beam splitting processing on a beam emitted by the light emitting region 3.

The TOFs corresponding to the beams that are respectively emitted by the M light emitting regions of the array light source at the M different moments may be specifically time difference information between emission moments of the beams that are respectively emitted by the M light emitting regions of the array light source at the M different moments and receiving moments of the corresponding reflected beams.

In addition, an approximately parallel beam can be obtained by performing collimation processing on a beam by using the collimation lens group, so that a power density of the beam can be improved, and an effect of subsequently performing scanning by using the beam can be improved.

In this embodiment of this application, the image generation method has different working modes. Therefore, the depth map of the target object may be generated by selecting the first working mode or the second working mode based on different cases, so that flexibility of generating the depth map of the target object can be improved.

With reference to the sixth aspect, in some implementations of the sixth aspect, the M depth maps are respectively depth maps corresponding to M region sets of the target object, and there is no overlapping region between any two region sets in the M region sets.

With reference to the sixth aspect, in some implementations of the sixth aspect, the receiving unit includes a receiving lens group and a sensor, and the receiving reflected beams of a target object by using a receiving unit in the first working mode or the second working mode includes: converging the reflected beams of the target object to the sensor by using the receiving lens group.

The sensor may also be referred to as a sensor array, and the sensor array may be a two-dimensional sensor array.

With reference to the sixth aspect, in some implementations of the sixth aspect, resolution of the sensor is greater than or equal to P×Q, and a quantity of beams obtained after the beam splitter performs beam splitting on a beam from one light emitting region of the array light source is P×Q.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

With reference to the sixth aspect, in some implementations of the sixth aspect, in the first working mode, the obtaining a final depth map of the target object based on TOFs corresponding to the beams emitted by the L light emitting regions includes: generating depth maps of L regions of the target object based on the TOFs corresponding to the beams emitted by the L light emitting regions; and synthesizing the depth map of the target object based on the depth maps of the L regions of the target object.

With reference to the sixth aspect, in some implementations of the sixth aspect, in the second working mode, distances between M regions of the target object and the TOF depth sensing module are determined based on the TOFs corresponding to the beams that are respectively emitted by the M light emitting regions at the M different moments; depth maps of the M regions of the target object are generated based on the distances between the M regions of the target object and the TOF depth sensing module; and the depth map of the target object is synthesized based on the depth maps of the M regions of the target object.

With reference to the sixth aspect, in some implementations of the sixth aspect, the determining a working mode of the terminal device includes: determining the working mode of the terminal device based on working mode selection information of a user.

The working mode selection information of the user is used to select one of the first working mode and the second working mode as the working mode of the terminal device.

Specifically, when the image generation method is performed by the terminal device, the terminal device may obtain the working mode selection information of the user from the user. For example, the user may enter the working mode selection information of the user by using an operation interface of the terminal device.

The working mode of the terminal device is determined based on the working mode selection information of the user, so that the user can flexibly select and determine the working mode of the terminal device.

With reference to the sixth aspect, in some implementations of the sixth aspect, the determining a working mode of the terminal device includes: determining the working mode of the terminal device based on a distance between the terminal device and the target object.

With reference to the sixth aspect, in some implementations of the sixth aspect, the determining a working mode of the terminal device includes: determining the working mode of the terminal device based on a scenario in which the target object is located.

The working mode of the terminal device can be flexibly determined based on the distance between the terminal device and the target object or the scenario in which the target object is located, so that the terminal device works in a proper working mode.

With reference to the sixth aspect, in some implementations of the sixth aspect, the determining the working mode of the terminal device based on a distance between the terminal device and the target object includes: when the distance between the terminal device and the target object is less than or equal to a preset distance, determining that the terminal device works in the first working mode; or when the distance between the terminal device and the target object is greater than a preset distance, determining that the terminal device works in the second working mode.

When the distance between the terminal device and the target object is small, the array light source has a sufficient light emitting power to simultaneously emit a plurality of beams that arrive at the target object. Therefore, when the distance between the terminal device and the target object is small, the first working mode is used, so that a plurality of light emitting regions of the array light source can simultaneously emit light, to help subsequently obtain depth information of more regions of the target object, and improve a frame rate of the depth map of the target object when resolution of the depth map of the target object is fixed.

When the distance between the terminal device and the target object is large, because a total power of the array light source is limited, the depth map of the target object may be obtained by using the second working mode. Specifically, the array light source is controlled to emit beams through time division, so that the beams emitted by the array light source through time division can also arrive at the target object. Therefore, when the terminal device is far away from the target object, depth information of different regions of the target object can also be obtained through time division, to obtain the depth map of the target object.

With reference to the sixth aspect, in some implementations of the sixth aspect, the determining the working mode of the terminal device based on a scenario in which the target object is located includes: when the terminal device is in an indoor scenario, determining that the terminal device works in the first working mode; or when the terminal device is in an outdoor scenario, determining that the terminal device works in the second working mode.

When the terminal device is in the indoor scenario, because the distance between the terminal device and the target object is small, and external noise is weak, the array light source has a sufficient light emitting power to simultaneously emit a plurality of beams that arrive at the target object. Therefore, when the distance between the terminal device and the target object is small, the first working mode is used, so that a plurality of light emitting regions of the array light source can simultaneously emit light, to help subsequently obtain depth information of more regions of the target object, and improve a frame rate of the depth map of the target object when resolution of the depth map of the target object is fixed.

When the terminal device is in the outdoor scenario, because the distance between the terminal device and the target object is large, external noise is large, and a total power of the array light source is limited, the depth map of the target object may be obtained by using the second working mode. Specifically, the array light source is controlled to emit beams through time division, so that the beams emitted by the array light source through time division can also arrive at the target object. Therefore, when the terminal device is far away from the target object, depth information of different regions of the target object can also be obtained through time division, to obtain the depth map of the target object.

According to a seventh aspect, a terminal device is provided, where the terminal device includes the TOF depth sensing module in the first aspect.

The terminal device in the seventh aspect may perform the image generation method in the third aspect or the fifth aspect.

According to an eighth aspect, a terminal device is provided, where the terminal device includes the TOF depth sensing module in the second aspect.

The terminal device in the eighth aspect may perform the image generation method in the fourth aspect or the sixth aspect.

The terminal device in the seventh aspect or the eighth aspect may be specifically a smartphone, a tablet, a computer, a game device, and the like.

## BRIEF DESCRIPTION OF DRAWINGS

FIG. 1 is a schematic diagram of a distance measurement principle of a laser radar;
FIG. 2 is a schematic diagram of performing distance measurement by using a TOF depth sensing module according to an embodiment of this application;
FIG. 3 is a schematic block diagram of a TOF depth sensing module according to an embodiment of this application;
FIG. 4 is a schematic diagram of a VCSEL;
FIG. 5 is a schematic diagram of an array light source;
FIG. 6 is a schematic diagram of performing, by using a beam splitter, beam splitting on a beam emitted by an array light source;
FIG. 7 is a schematic diagram of a projection region obtained by performing, by using a beam splitter, beam splitting on a beam emitted by an array light source;
FIG. 8 is a schematic diagram of a projection region obtained by performing, by using a beam splitter, beam splitting on a beam emitted by an array light source;
FIG. 9 is a schematic diagram of a projection region obtained by performing, by using a beam splitter, beam splitting on a beam emitted by an array light source;
FIG. 10 is a schematic diagram of a projection region obtained by performing, by using a beam splitter, beam splitting on a beam emitted by an array light source;
FIG. 11 is a schematic diagram of a structure of a TOF depth sensing module according to an embodiment of this application;

FIG. 12 is a schematic diagram of performing beam splitting processing by using a beam splitter;

FIG. 13 is a schematic diagram of a structure of a TOF depth sensing module according to an embodiment of this application;

FIG. 14 is a schematic diagram of a structure of a TOF depth sensing module according to an embodiment of this application;

FIG. 15 is a schematic working diagram of a TOF depth sensing module according to an embodiment of this application;

FIG. 16 is a schematic diagram of a light emitting region of an array light source;

FIG. 17 is a schematic diagram of performing, by using a beam splitter, beam splitting processing on a beam emitted by the array light source shown in FIG. 16;

FIG. 18 is a schematic flowchart of an image generation method according to an embodiment of this application;

FIG. 19 shows depth maps of a target object at moments t0 to t3;

FIG. 20 is a schematic flowchart of an image generation method according to an embodiment of this application;

FIG. 21 is a schematic flowchart of an image generation method according to an embodiment of this application;

FIG. 22 is a schematic flowchart of obtaining a final depth map of a target object in a first working mode;

FIG. 23 is a schematic flowchart of obtaining a final depth map of a target object in a first working mode;

FIG. 24 is a schematic flowchart of obtaining a final depth map of a target object in a second working mode;

FIG. 25 is a schematic flowchart of obtaining a final depth map of a target object in a second working mode;

FIG. 26 is a schematic diagram of performing distance measurement by using a TOF depth sensing module according to an embodiment of this application;

FIG. 27 is a schematic block diagram of a TOF depth sensing module according to an embodiment of this application;

FIG. 28 is a schematic diagram of a space angle of a beam;

FIG. 29 is a schematic block diagram of a TOF depth sensing module according to an embodiment of this application;

FIG. 30 is a schematic diagram of scanning a target object by a TOF depth sensing module according to an embodiment of this application;

FIG. 31 is a schematic diagram of a scanning track of a TOF depth sensing module according to an embodiment of this application;

FIG. 32 is a schematic diagram of a scanning manner of a TOF depth sensing module according to an embodiment of this application;

FIG. 33 is a schematic block diagram of a TOF depth sensing module according to an embodiment of this application;

FIG. 34 is a schematic block diagram of a TOF depth sensing module according to an embodiment of this application;

FIG. 35 is a schematic diagram of a structure of a liquid crystal polarization grating according to an embodiment of this application;

FIG. 36 is a schematic diagram of a structure of a TOF depth sensing module according to an embodiment of this application;

FIG. 37 is a schematic diagram of changing a physical characteristic of a liquid crystal polarization grating by using a periodic control signal;

FIG. 38 is a schematic diagram of controlling a direction of an input beam by a liquid crystal polarization grating;

FIG. 39 is a schematic diagram of a voltage signal applied to a liquid crystal polarization grating;

FIG. 40 is a schematic diagram of a scanning track of a TOF depth sensing module according to an embodiment of this application;

FIG. 41 is a schematic diagram of a to-be-scanned region;

FIG. 42 is a schematic diagram of a to-be-scanned region;

FIG. 43 is a schematic diagram of a structure of a TOF depth sensing module according to an embodiment of this application;

FIG. 44 is a schematic diagram of controlling a direction of a beam by an electro-optic crystal;

FIG. 45 is a schematic diagram of a voltage signal applied to an electro-optic crystal;

FIG. 46 is a schematic diagram of a scanning track of a TOF depth sensing module according to an embodiment of this application;

FIG. 47 is a schematic diagram of a structure of a TOF depth sensing module according to an embodiment of this application;

FIG. 48 is a schematic diagram of controlling a direction of a beam by an acousto-optic device;

FIG. 49 is a schematic diagram of a structure of a TOF depth sensing module according to an embodiment of this application;

FIG. 50 is a schematic diagram of controlling a direction of a beam by an OPA device;

FIG. 51 is a schematic diagram of a structure of a TOF depth sensing module according to an embodiment of this application;

FIG. 52 is a schematic flowchart of an image generation method according to an embodiment of this application;

FIG. 53 is a schematic diagram of performing distance measurement by using a TOF depth sensing module according to an embodiment of this application;

FIG. 54 is a schematic diagram of a structure of a TOF depth sensing module according to an embodiment of this application;

FIG. 55 is a schematic block diagram of a TOF depth sensing module according to an embodiment of this application;

FIG. 56 is a schematic block diagram of a TOF depth sensing module according to an embodiment of this application;

FIG. 57 is a schematic flowchart of an image generation method according to an embodiment of this application;

FIG. 58 is a schematic block diagram of a TOF depth sensing module according to an embodiment of this application;

FIG. 59 is a schematic block diagram of a TOF depth sensing module according to an embodiment of this application;

FIG. 60 is a schematic block diagram of a TOF depth sensing module according to an embodiment of this application;

FIG. 61 is a schematic diagram of a structure of a TOF depth sensing module according to an embodiment of this application;

FIG. 62 is a schematic flowchart of an image generation method according to an embodiment of this application;

FIG. 63 is a schematic diagram of a structure of a TOF depth sensing module according to an embodiment of this application;

FIG. 64 is a schematic diagram of a structure of a liquid crystal polarization device according to an embodiment of this application;

FIG. 65 is a schematic diagram of a control time sequence;

FIG. 66 is a time sequence diagram of a voltage drive signal;

FIG. 67 is a schematic diagram of scanned regions of a TOF depth sensing module at different moments;

FIG. 68 is a schematic diagram of depth maps that are of a target object and that correspond to moments t0 to t3;

FIG. 69 is a schematic diagram of a final depth map of a target object;

FIG. 70 is a schematic working diagram of a TOF depth sensing module according to an embodiment of this application;

FIG. 71 is a schematic diagram of a structure of a TOF depth sensing module according to an embodiment of this application;

FIG. 72 is a schematic diagram of a structure of a TOF depth sensing module according to an embodiment of this application;

FIG. 73 is a schematic diagram of a structure of a TOF depth sensing module according to an embodiment of this application;

FIG. 74 is a schematic diagram of a structure of a TOF depth sensing module according to an embodiment of this application;

FIG. 75 is a schematic diagram of a structure of a TOF depth sensing module according to an embodiment of this application;

FIG. 76 is a schematic diagram of a structure of a TOF depth sensing module 500 according to an embodiment of this application;

FIG. 77 is a schematic diagram of a morphology of a microlens diffuser;

FIG. 78 is a schematic flowchart of an image generation method according to an embodiment of this application;

FIG. 79 is a schematic diagram of a structure of a TOF depth sensing module according to an embodiment of this application;

FIG. 80 is a schematic diagram of a specific structure of a TOF depth sensing module according to an embodiment of this application;

FIG. 81 is a schematic diagram of a specific structure of a TOF depth sensing module according to an embodiment of this application;

FIG. 82 is a schematic diagram of a specific structure of a TOF depth sensing module according to an embodiment of this application;

FIG. 83 is a schematic diagram of a specific structure of a TOF depth sensing module according to an embodiment of this application;

FIG. 84 is a schematic diagram of a structure of a TOF depth sensing module 600 according to an embodiment of this application;

FIG. 85 is a schematic diagram of a structure of a TOF depth sensing module 600 according to an embodiment of this application;

FIG. 86 is a schematic diagram of a structure of a TOF depth sensing module 600 according to an embodiment of this application;

FIG. 87 is a schematic diagram of a received polarized beam of a polarization filter;

FIG. 88 is a schematic flowchart of an image generation method according to an embodiment of this application;

FIG. 89 is a schematic diagram of a specific structure of a TOF depth sensing module according to an embodiment of this application;

FIG. 90 is a schematic diagram of a specific structure of a TOF depth sensing module according to an embodiment of this application;

FIG. 91 is a schematic diagram of a specific structure of a TOF depth sensing module according to an embodiment of this application;

FIG. 92 is a schematic diagram of a specific structure of a TOF depth sensing module according to an embodiment of this application;

FIG. 93 is a schematic diagram of a specific structure of a TOF depth sensing module according to an embodiment of this application;

FIG. 94 is a schematic diagram of a dive signal and a received signal of a TOF depth sensing module according to an embodiment of this application;

FIG. 95 is a schematic diagram of an angle and a state of a beam emitted by a TOF depth sensing module according to an embodiment of this application;

FIG. 96 is a schematic diagram of a structure of a TOF depth sensing module according to an embodiment of this application;

FIG. 97 is a schematic diagram of a structure of a TOF depth sensing module according to an embodiment of this application;

FIG. 98 is a schematic diagram of a structure of a TOF depth sensing module according to an embodiment of this application;

FIG. 99 is a schematic diagram of a beam deflection principle of a flat liquid crystal cell;

FIG. 100 is a schematic diagram of a beam deflection principle of a flat liquid crystal cell;

FIG. 101 is a schematic flowchart of an image generation method according to an embodiment of this application;

FIG. 102 is a schematic diagram of an FOV of a first beam;

FIG. 103 is a schematic diagram of a total FOV covered by emergent beams in M different direction;

FIG. 104 is a schematic diagram of performing scanning in M different directions by a TOF depth sensing module according to an embodiment of this application; and

FIG. 105 is a schematic flowchart of an entire solution design according to an embodiment of this application.

## DESCRIPTION OF EMBODIMENTS

The following describes technical solutions of this application with reference to accompanying drawings.

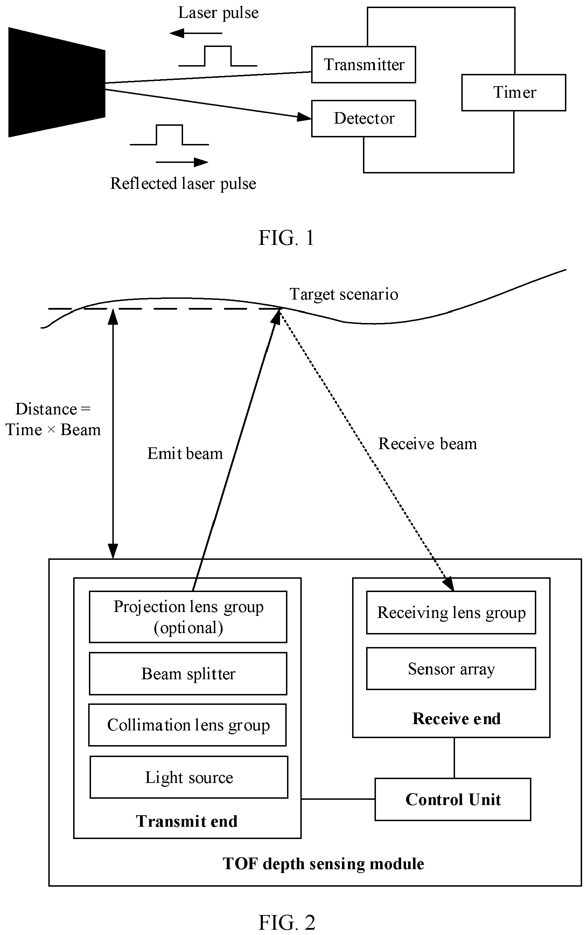

FIG. 1 is a schematic diagram of a distance measurement principle of a laser radar.

As shown in FIG. 1, a transmitter of the laser radar emits a laser pulse (a pulse width may be in the order of nanoseconds to picoseconds). At the same time, a timer starts timing. When the laser pulse is irradiated to a target region, a reflected laser pulse is generated due to reflection of a surface of the target region. When a detector of the laser radar receives the reflected laser pulse, the timer stops timing to obtain a time of flight (time of flight, TOF). Next, a distance between the laser radar and the target region may be calculated based on the TOF.

Specifically, the distance between the laser radar and the target region may be determined according to Formula (1):

$$L=c*T/2 \tag{1}$$

In the foregoing Formula (1), L is the distance between the laser radar and the target region, c is the speed of light, and T is a propagation time of light.

It should be understood that, in a TOF depth sensing module in embodiments of this application, after a light source emits a beam, the beam needs to be processed by another element (for example, a collimation lens group and a beam splitter) in the TOF depth sensing module, so that the beam is finally emitted from a transmit end. In the process, a beam from an element in the TOF depth sensing module may also be referred to as a beam emitted by the element.

For example, the light source emits a beam, and the beam is emitted after being subject to collimation processing of the collimation lens group. A beam emitted by the collimation lens group may also be actually referred to as a beam from the collimation lens group. The beam emitted by the collimation lens group herein does not represent a beam emitted by the collimation lens group, but is a beam emitted after a beam propagated by a previous element is processed.

Optionally, in the embodiments of this application, the light source may be a laser light source, an light emitting diode (light emitting diode, LED) light source, or another form of light source. This is not exhaustively described in the present invention.

Optionally, the light source is a laser light source, and the laser light source may be specifically an array light source.

In addition, in this application, a beam emitted by the laser light source or the array light source may also be referred to as a beam from the laser light source or the array light source. It should be understood that the beam from the laser light source may also be referred to as a laser beam. For ease of description, the laser beam is collectively referred to as a beam in this application.

The following first briefly describes the TOF depth sensing module in the embodiments of this application with reference to FIG. 2.

FIG. 2 is a schematic diagram of performing distance measurement by using a TOF depth sensing module according to an embodiment of this application.

As shown in FIG. 2, the TOF depth sensing module may include a transmit end (or may be referred to as a projection end), a receive end, and a control unit. The transmit end is configured to generate an emergent beam. The receive end is configured to receive a reflected beam (the reflected beam is a beam obtained by a target object by reflecting the emergent beam) of the target object. The control unit may control the transmit end and the receive end to respectively emit and receive a beam.

In FIG. 2, the transmit end may generally include a light source, a beam splitter, a collimation lens group, and a projection lens group (optional), the receive end may generally include a receiving lens group and a sensor, and the receiving lens group and the sensor may be collectively referred to as a receiving unit.

In FIG. 2, a TOF corresponding to the emergent beam may be recorded by using a timing apparatus, to calculate a distance between the TOF depth sensing module and a target region, and obtain a final depth map of the target object. The TOF corresponding to the emergent beam may be time difference information between a moment at which the reflected beam is received by the receiving unit and an emergent moment of the emergent beam.

The light source in FIG. 2 may be a laser light source, and the laser light source may be specifically an array light source.

The TOF depth sensing module in this embodiment of this application may be configured to obtain a three-dimensional (3 dimensions, 3D) image. The TOF depth sensing module in this embodiment of this application may be disposed in an intelligent terminal (for example, a mobile phone, a tablet, and a wearable device), is configured to obtain a depth image or a 3D image, and may also provide gesture and body recognition for 3D games or motion sensing games.

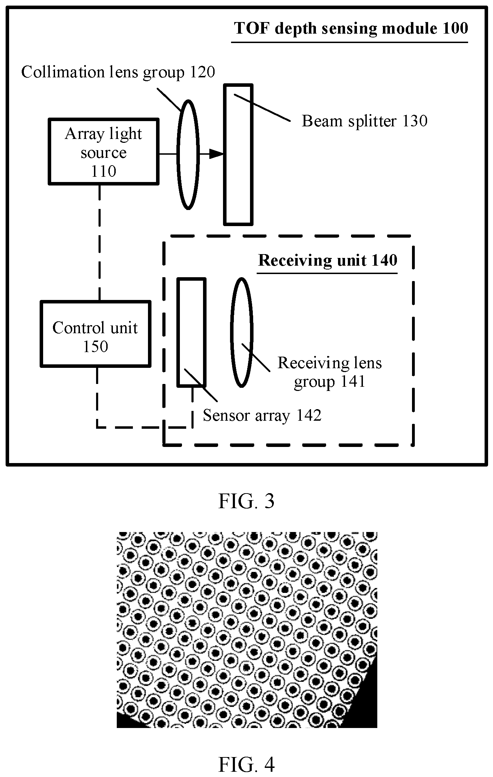

The following describes in detail the TOF depth sensing module in the embodiments of this application with reference to FIG. 3.

FIG. 3 is a schematic block diagram of a TOF depth sensing module according to an embodiment of this application.

A TOF depth sensing module 100 shown in FIG. 3 includes an array light source 110, a collimation lens group 120, a beam splitter 130, a receiving unit 140, and a control unit 150. The following describes in detail the modules or units in the TOF depth sensing module 100.

Array light source 110:

The array light source 110 is configured to generate (emit) a beam.
The array light source 110 includes N light emitting regions, each light emitting region may independently generate a beam, and N is a positive integer greater than 1.

Optionally, each light emitting region may independently generate a laser beam.

The control unit 150 is configured to control M light emitting regions of the N light emitting regions of the array light source 110 to emit light.

The collimation lens group 120 is configured to perform collimation processing on beams emitted by the M light emitting regions.

The beam splitter 130 is configured to perform beam splitting processing on beams obtained after the collimation lens group performs collimation processing.

The receiving unit 140 is configured to receive reflected beams of a target object.

M is less than or equal to N, M is a positive integer, and N is a positive integer greater than 1. The beam splitter is specifically configured to split each received beam of light into a plurality of beams of light. The reflected beam of the target object is a beam obtained by the target object by reflecting a beam from the beam splitter. The beams emitted by the M light emitting regions may also be referred to as beams from the M light emitting regions.

Because M is less than or equal to N, the control unit 150 may control some or all light emitting regions of the array light source 110 to emit light.

The N light emitting regions may be N independent light emitting regions, that is, each light emitting region of the N light emitting regions may independently emit light without being affected by another light emitting region. For each light emitting region of the N light emitting regions, each light emitting region generally includes a plurality of light emitting units. In the N light emitting regions, different light emitting regions include different light emitting units, that is, one light emitting unit belongs only to one light emitting region. For each light emitting region, when the control unit controls the light emitting region to emit light, all light emitting units in the light emitting region may emit light.

A total quantity of light emitting regions of the array light source may be N. When M=N, the control unit may control all light emitting regions of the array light source to emit light simultaneously or through time division.

Optionally, the control unit is configured to control the M light emitting regions of the N light emitting regions of the array light source to simultaneously emit light.

For example, the control unit may control the M light emitting regions of the N light emitting regions of the array light source to simultaneously emit light at a moment T0.

Optionally, the control unit is configured to control the M light emitting regions of the N light emitting regions of the array light source to respectively emit light at M different moments.

For example, M=3. The control unit may control three light emitting regions of the array light source to respectively emit light at a moment T0, a moment T1, and a moment T2, that is, a first light emitting region of the three light emitting regions emits light at the moment T0, a second light emitting region emits light at the moment T1, and a third light emitting region emits light at the moment T2.

Optionally, the control unit is configured to control the M light emitting regions of the N light emitting regions of the array light source to separately emit light at M0 different moments, where M0 is a positive integer greater than 1 and less than M.

For example, M=3 and M0=2. The control unit may control one light emitting region of three light emitting regions of the array light source to emit light at a moment T0, and control the other two light emitting regions of the three light emitting regions of the array light source to emit light at a moment T1.

In this embodiment of this application, different light emitting regions of the array light source are controlled to emit light through time division, and the beam splitter is controlled to perform beam splitting processing on a beam, so that a quantity of beams emitted by the TOF depth sensing module in a time period can be improved, and high spatial resolution and a high frame rate can be implemented in a process of scanning the target object.

Optionally, a light emitting area of the array light source 110 is less than or equal to $5 \times 5$ mm$^2$.

When the light emitting area of the array light source 110 is less than or equal to $5 \times 5$ mm$^2$, an area of the array light source 110 is small, and space occupied by the TOF depth sensing module 100 can be reduced, so that the TOF depth sensing module 100 is conveniently mounted in a terminal device with limited space.

Optionally, the array light source 110 may be a semiconductor laser light source.

The array light source 110 may be a vertical cavity surface emitting laser (vertical cavity surface emitting laser, VCSEL).

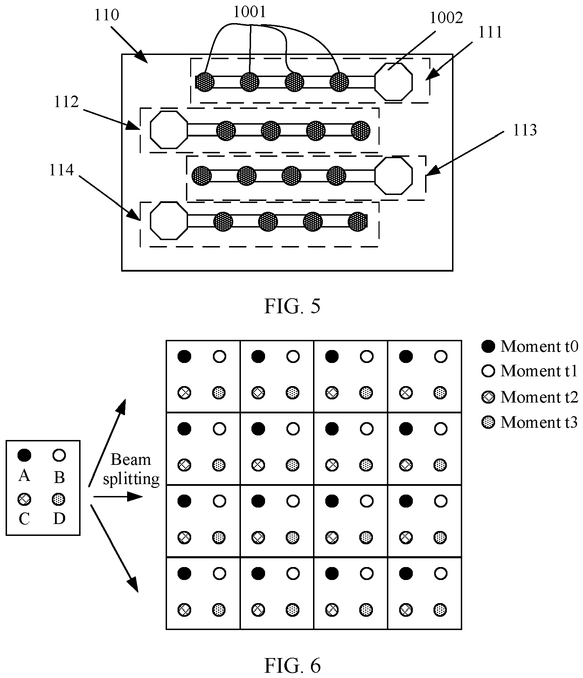

FIG. 5 is a schematic diagram of a VCSEL. As shown in FIG. 5, the VCSEL includes a plurality of light emitting points (a black point region in FIG. 5), and each light emitting point may emit light under the control of the control unit.

Optionally, the light source may be a Fabry-Perot laser (which may be briefly referred to as an FP laser).

Compared with a single VCSEL, a single FP laser may implement a larger power, and has higher electro-optic conversion efficiency than the VCSEL, so that a scanning effect can be improved.

Optionally, a wavelength of a beam emitted by the array light source 110 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of a beam emitted by the array light source 110 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

With reference to FIG. 5, the following describes in detail a case in which the array light source 110 includes a plurality of independent light emitting regions.

As shown in FIG. 5, the array light source 110 includes mutually independent light emitting regions 111, 112, 113, and 114, and there are several light emitting units 1001 in each region. The several light emitting units 1001 in each region are connected to each other by using a common electrode 1002, and light emitting units in different light emitting regions are connected to different electrodes, so that different regions are mutually independent.

For the array light source 110 shown in FIG. 5, the control unit 150 may respectively control the independent light emitting regions 111, 112, 113, and 114 to independently emit light at different moments. For example, the control unit 150 may control the light emitting regions 111, 112, 113, and 114 to respectively emit light at a moment t0, a moment t1, a moment t2, and a moment t3.

Optionally, the beam obtained after the collimation lens group 120 performs collimation processing may be quasi-parallel light whose divergence angle is less than 1 degree.

The collimation lens group 120 may include one or more lenses. When the collimation lens group 120 includes a plurality of lenses, the collimation lens group 120 can effectively reduce aberration generated in the collimation processing process.

The collimation lens group 120 may be made of a plastic material, a glass material, or both a plastic material and a glass material. When the collimation lens group 120 is made of the glass material, the collimation lens group can reduce an impact of a temperature on a back focal length of the collimation lens group 120 in a process of performing collimation processing on a beam.

Specifically, because a coefficient of thermal expansion of the glass material is small, when the glass material is used for the collimation lens group 120, the impact of the temperature on the back focal length of the collimation lens group 120 can be reduced.

Optionally, a clear aperture of the collimation lens group 120 is less than or equal to 5 mm.

When the clear aperture of the collimation lens group 120 is less than or equal to 5 mm, an area of the collimation lens group 120 is small, and space occupied by the TOF depth sensing module 100 can be reduced, so that the TOF depth sensing module 100 is conveniently mounted in a terminal device with limited space.

As shown in FIG. 3, the receiving unit 140 may include a receiving lens group 141 and a sensor 142, and the receiving lens group 141 is configured to converge the reflected beam to the sensor 142.

The sensor 142 may also be referred to as a sensor array, and the sensor array may be a two-dimensional sensor array.

Optionally, resolution of the sensor 142 is greater than or equal to P×Q, and a quantity of beams obtained after the beam splitter performs beam splitting on a beam emitted by one light emitting region of the array light source 110 is P×Q, where both P and Q are positive integers.

The resolution of the sensor is greater than or equal to the quantity of beams obtained after the beam splitter 130 performs beam splitting on a beam from one light emitting region of the array light source. Therefore, the sensor 142 can receive the reflected beam obtained by the target object by reflecting the beam from the beam splitter, so that the TOF depth sensing module can normally receive the reflected beam.

Optionally, the beam splitter 130 may be a one-dimensional beam splitting device or a two-dimensional beam splitting device.

In actual application, the one-dimensional beam splitting device or the two-dimensional beam splitting device may be selected as required.

Specifically, in actual application, the one-dimensional beam splitting device or the two-dimensional beam splitting device may be selected as required. When beam splitting needs to be performed on an emergent beam only in one dimension, the one-dimensional beam splitting device may be used. When beam splitting needs to be performed on an emergent beam in two dimensions, the two-dimensional beam splitting device needs to be used.

When the beam splitter 130 is a one-dimensional beam splitting device, the beam splitter 130 may be specifically a cylindrical lens array or a one-dimensional grating.

When the beam splitter 130 is a two-dimensional beam splitting device, the beam splitter 130 may be specifically a microlens array or a two-dimensional diffractive optical element (diffractive optical element, DOE).

The beam splitter 130 may be made of a resin material or a glass material, or may be made of both a resin material and a glass material.

When a component of the beam splitter 130 includes the glass material, an impact of a temperature on performance of the beam splitter 130 can be effectively reduced, so that the beam splitter 130 maintains stable performance. Specifically, when the temperature changes, a coefficient of thermal expansion of glass is lower than that of resin. Therefore, when the glass material is used for the beam splitter 130, performance of the beam splitter is stable.

Optionally, an area of a beam incident end face of the beam splitter 130 is less than $5×5$ mm$^2$.

When the area of the beam incident end face of the beam splitter 130 is less than $5×5$ mm$^2$, an area of the beam splitter 130 is small, and space occupied by the TOF depth sensing module 100 can be reduced, so that the TOF depth sensing module 100 is conveniently mounted in a terminal device with limited space.

Optionally, a beam receiving surface of the beam splitter 130 is parallel to a beam emission surface of the array light source 110.

When the beam receiving surface of the beam splitter 130 is parallel to the beam emission surface of the array light source 110, the beam splitter 130 can more efficiently receive a beam emitted by the array light source 110, and efficiency of receiving a beam by the beam splitter 130 can be improved.

As shown in FIG. 3, the receiving unit 140 may include the receiving lens group 141 and the sensor 142. A specific example is used below to describe a manner in which the receiving unit receives a beam.

For example, the array light source 110 includes four light emitting regions. In this case, the receiving lens group 141 may be separately configured to: receive a reflected beam 1, a reflected beam 2, a reflected beam 3, and a reflected beam 4 that are obtained by the target object by reflecting beams that are respectively generated by the beam splitter 130 at four different moments (t4, t5, t6, and t7), and propagate the reflected beam 1, the reflected beam 2, the reflected beam 3, and the reflected beam 4 to the sensor 142.

Optionally, the receiving lens group 141 may include one or more lenses.

When the receiving lens group 141 includes a plurality of lenses, aberration generated when the receiving lens group 141 receives a beam can be effectively reduced.

In addition, the receiving lens group 141 may be made of a resin material or a glass material, or may be made of both a resin material and a glass material.

When the receiving lens group 141 includes the glass material, an impact of a temperature on a back focal length of the receiving lens group 141 can be effectively reduced.

The sensor 142 may be configured to: receive a beam propagated from the lens group 141, and perform optical-to-electro conversion on the beam propagated from the receiving lens group 141, to convert an optical signal into an electrical signal. This helps subsequently calculate a time difference (the time difference may be referred to as a time of flight of a beam) between a moment at which a transmit end emits the beam and a moment at which a receive end receives the beam, and calculate a distance between the target object and the TOF depth sensing module based on the time difference, to obtain a depth image of the target object.

The sensor 142 may be a single-photon avalanche diode (single-photon avalanche diode, SPAD) array.

The SPAD is an avalanche photodiode that works in a Geiger mode (a bias voltage is higher than a breakdown voltage), and has a probability of an avalanche effect after a single photon is received, to instantaneously generate a pulse current signal to detect an arrival time of the photon. Because the SPAD array used in the TOF depth sensing module requires a complex quenching circuit, timing circuit, and storage and read unit, resolution of an existing SPAD array used for TOF depth sensing is limited.

When the distance between the target object and the TOF depth sensing module is large, intensity of reflected light that is of the target object and that is propagated by the receiving lens group to the sensor is generally very weak. The sensor needs to have very high detection sensitivity, and the SPAD has single-photon detection sensitivity and a response time in the order of picoseconds. Therefore, in this application, the SPAD is used as the sensor 142 to improve sensitivity of the TOF depth sensing module.

In addition to controlling the array light source 110, the control unit 150 may further control the sensor 142.

The control unit 150 may maintain an electrical connection to the array light source 110 and the sensor 142, to control the array light source 110 and the sensor 142.

Specifically, the control unit 150 may control a working manner of the sensor 142, so that at M different moments, corresponding regions of the sensor can respectively receive reflected beams obtained by the target object by reflecting beams emitted by corresponding light emitting regions of the array light source 110.

Specifically, a part that is of the reflected beam of the target object and that is located in a numerical aperture of the receiving lens group is received by the receiving lens group and propagated to the sensor. The receiving lens group is designed, so that each pixel of the sensor can receive reflected beams of different regions of the target object.

In this application, the array light source is controlled, through partitioning, to emit light, and beam splitting is performed by using the beam splitter, a quantity of beams emitted by the TOF depth sensing module at a same moment can be increased, and spatial resolution and a high frame rate of a finally obtained depth map of the target object can be improved.

It should be understood that, as shown in FIG. 2, for the TOF depth sensing module in this embodiment of this application, both the projection end and the receive end in the TOF depth sensing module may be located on a same side of the target object.

Optionally, an output optical power of the TOF depth sensing module 100 is less than or equal to 800 mw.

Specifically, a maximum output optical power or an average output power of the TOF depth sensing module 100 is less than or equal to 800 mw.

When the output optical power of the TOF depth sensing module 100 is less than or equal to 800 mw, power consumption of the TOF depth sensing module 100 is small, to help dispose the TOF depth sensing module in a device that is sensitive to power consumption, for example, a terminal device.

With reference to FIG. 6 to FIG. 10, the following describes in detail a process in which the TOF depth sensing module 100 in this embodiment of this application obtains the depth map of the target object.

As shown in FIG. 6, the left figure is a schematic diagram of the light emitting region of the array light source 110. The array light source 110 includes four light emitting regions (which may also be referred to as light emitting partitions) A, B, C, and D, and the four light emitting regions are respectively lit at a moment t0, a moment t1, a moment t2, and a moment t3. The right figure is a schematic diagram of a surface of the target object on which a beam generated by the array light source 110 is projected after the beam is subject to beam splitting of the beam splitter 130. Each point represents a projected light spot, and a region surrounded by each black solid-line box is a target region corresponding to one pixel of the sensor 142. In FIG. 6, a corresponding replication order of the beam splitter 130 is 4×4. To be specific, at each moment, a light emitting spot generated in one region of the array light source becomes 4×4 spots after being replicated by the beam splitter 130. Therefore, a quantity of light spots projected at a same moment can be greatly increased by using the beam splitter 130.

In FIG. 6, the four light emitting regions of the array light source 110 are respectively lit at the moment t0, the moment t1, the moment t2, and the moment t3, so that depth maps of the target object at different locations can be obtained.

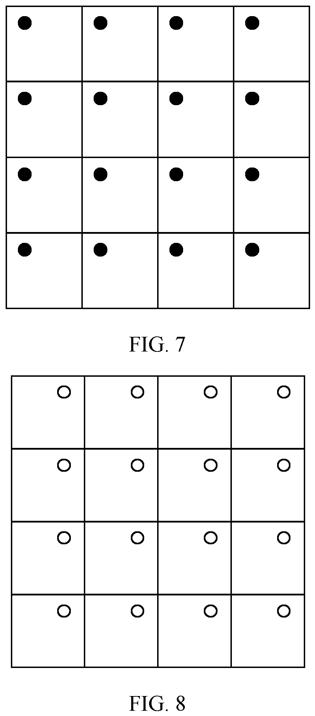

Specifically, FIG. 7 is a schematic diagram of a surface of the target object on which a beam emitted by the light emitting region a of the array light source 110 at the moment t0 is projected after the beam is subject to beam splitting processing of the beam splitter 130.

FIG. 8 is a schematic diagram of a surface of the target object on which a beam emitted by the light emitting region b of the array light source 110 at the moment t1 is projected after the beam is subject to beam splitting processing of the beam splitter 130.

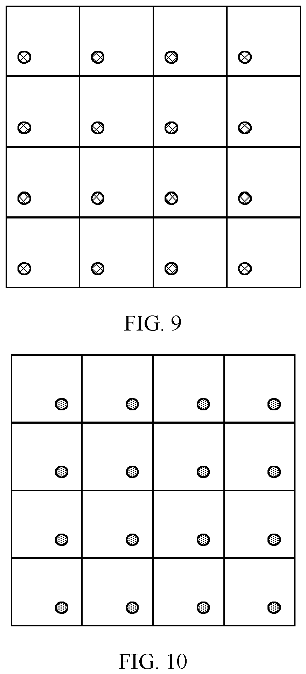

FIG. 9 is a schematic diagram of a surface of the target object on which a beam emitted by the light emitting region c of the array light source 110 at the moment t2 is projected after the beam is subject to beam splitting processing of the beam splitter 130.

FIG. 10 is a schematic diagram of a surface of the target object on which a beam emitted by the light emitting region d of the array light source 110 at the moment t3 is projected after the beam is subject to beam splitting processing of the beam splitter 130.

Based on beam projection cases shown in FIG. 7 to FIG. 10, depth maps corresponding to the target object at the moment t0, the moment t1, the moment t2, and the moment t3 may be obtained, and then the depth maps corresponding to the target object at the moment t0, the moment t1, the moment t2, and the moment t3 are superposed, so that a higher-resolution depth map of the target object can be obtained.

In the TOF depth sensing module 100 shown in FIG. 3, the collimation lens group 120 may be located between the array light source 110 and the beam splitter 130. The collimation lens group 120 needs to first perform collimation processing on a beam emitted by the array light source 110, and then the beam splitter processes a beam obtained after collimation processing is performed.

Optionally, for the TOF depth sensing module 100, the beam splitter 130 may directly perform beam splitting processing on a beam generated by the array light source 110, and then collimation lens group 120 performs collimation processing on a beam obtained after beam splitting processing is performed.

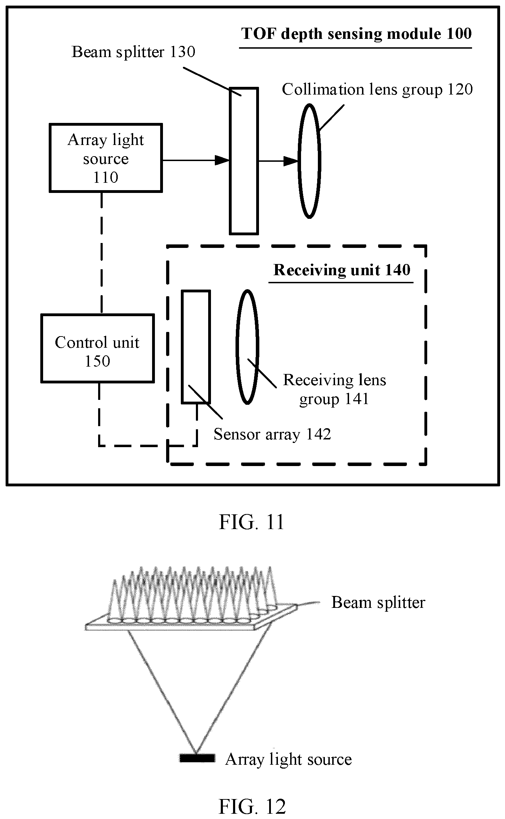

The following is described in detail with reference to FIG. 11. In a TOF depth sensing module 100 shown in FIG. 11, a specific function of each module or unit is as follows:

A control unit 150 is configured to control M light emitting regions of N light emitting regions of an array light source 110 to emit light.

A beam splitter 130 is configured to perform beam splitting processing on beams emitted by the M light emitting regions.

A collimation lens group 120 is configured to perform collimation processing on beams emitted by the beam splitter 130.

A receiving unit 140 is configured to receive reflected beams of a target object.

M is less than or equal to N, M is a positive integer, and N is a positive integer greater than 1. The beam splitter 130 is specifically configured to split each received beam of light into a plurality of beams of light. The reflected beam of the target object is a beam obtained by the target object by reflecting a beam emitted by the collimation lens group 120. The beams emitted by the M light emitting regions may also be referred to as beams from the M light emitting regions.

A main difference between the TOF depth sensing module shown in FIG. 11 and the TOF depth sensing module shown in FIG. 3 is that locations of the collimation lens group are different. The collimation lens group in the TOF depth sensing module shown in FIG. 3 is located between the array light source and the beam splitter, and the beam splitter in the TOF depth sensing module shown in FIG. 11 is located between the array light source and the collimation lens group (which is equivalent to that the collimation lens group is located in a direction of an emergent beam of the beam splitter).

The TOF depth sensing module 100 shown in FIG. 11 and the TOF depth sensing module 100 shown in FIG. 3 slightly differ in a manner of processing a beam emitted by the array light source 110. In the TOF depth sensing module 100 shown in FIG. 3, after the array light source 110 emits a beam, the collimation lens group 120 and the beam splitter 130 successively perform collimation processing and beam splitting processing. In the TOF depth sensing module 100 shown in FIG. 11, after the array light source 110 emits a beam, the beam splitter 130 and the collimation lens group 120 successively perform beam splitting processing and collimation processing.

With reference to the accompanying drawings, the following describes a process in which the beam splitter 130 performs beam splitting processing on the beam emitted by the array light source.

As shown in FIG. 12, after the beam splitter 130 performs beam splitting processing on a plurality of beams generated by the array light source 110, each beam generated by the array light source 110 may be split into a plurality of beams, and a larger quantity of beams are finally obtained after beam splitting is performed.

Based on the TOF depth sensing module shown in FIG. 11, the TOF depth sensing module 100 in this embodiment of this application may further include an optical element. A refractive index of the optical element is controllable. When the refractive index of the optical element varies, the optical element can adjust a beam in a single polarization state to different directions, so that a scanning region of interest can be quickly located by irradiating different beams to different directions without mechanical rotation and vibration.

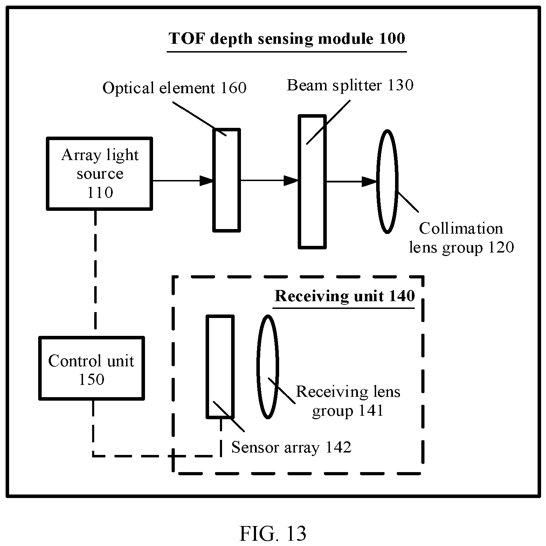

FIG. 13 is a schematic diagram of a structure of a TOF depth sensing module according to an embodiment of this application.

In a TOF depth sensing module 100 shown in FIG. 13, a specific function of each module or unit is as follows:

A control unit 150 is configured to control M light emitting regions of N light emitting regions of an array light source 110 to emit light.

The control unit 150 is further configured to control a birefringence parameter of an optical element 160 to change propagation directions of beams emitted by the M light emitting regions.

A beam splitter 130 is configured to: receive beams emitted by the optical element 160, and perform beam splitting processing on the beams emitted by the optical element 160.

Optionally, the beam splitter 130 is specifically configured to split each received beam of light into a plurality of beams of light, and a quantity of beams obtained after the beam splitter 130 may perform beam splitting on a beam emitted by one light emitting region of the array light source 110 is P×Q.

A collimation lens group 120 is configured to perform collimation processing on beams emitted by the beam splitter 130.

A receiving unit 140 is configured to receive reflected beams of a target object.

The reflected beam of the target object is a beam obtained by the target object by reflecting the beam emitted by the beam splitter 130. The beams emitted by the M light emitting regions may also be referred to as beams from the M light emitting regions.

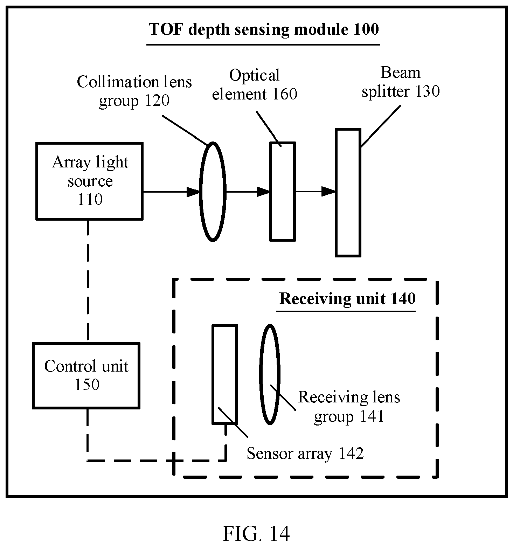

In FIG. 13, the optical element 160 is located between the array light source 110 and the beam splitter 130. In practice, the optical element 160 may be located between the collimation lens group 120 and the beam splitter 130. The following is described with reference to FIG. 14.

FIG. 14 is a schematic diagram of a structure of a TOF depth sensing module according to an embodiment of this application.

In a TOF depth sensing module 100 shown in FIG. 14, a specific function of each module or unit is as follows:

A control unit 150 is configured to control M light emitting regions of N light emitting regions of an array light source 110 to emit light.

A collimation lens group 120 is configured to perform collimation processing on beams emitted by the M light emitting regions.

The control unit 150 is further configured to control a birefringence parameter of an optical element 160 to change propagation directions of beams obtained after the collimation lens group 120 performs collimation processing.

A beam splitter 130 is configured to: receive beams emitted by the optical element 160, and perform beam splitting processing on the beams emitted by the optical element 160.

Optionally, the beam splitter 130 is specifically configured to split each received beam of light into a plurality of beams of light, and a quantity of beams obtained after the beam splitter 130 may perform beam splitting on a beam emitted by one light emitting region of the array light source 110 is P×Q.

The collimation lens group 120 is configured to perform collimation processing on beams emitted by the beam splitter 130.

A receiving unit 140 is configured to receive reflected beams of a target object.

The reflected beam of the target object is a beam obtained by the target object by reflecting the beam emitted by the beam splitter 130. The beams emitted by the M light emitting regions may also be referred to as beams from the M light emitting regions.

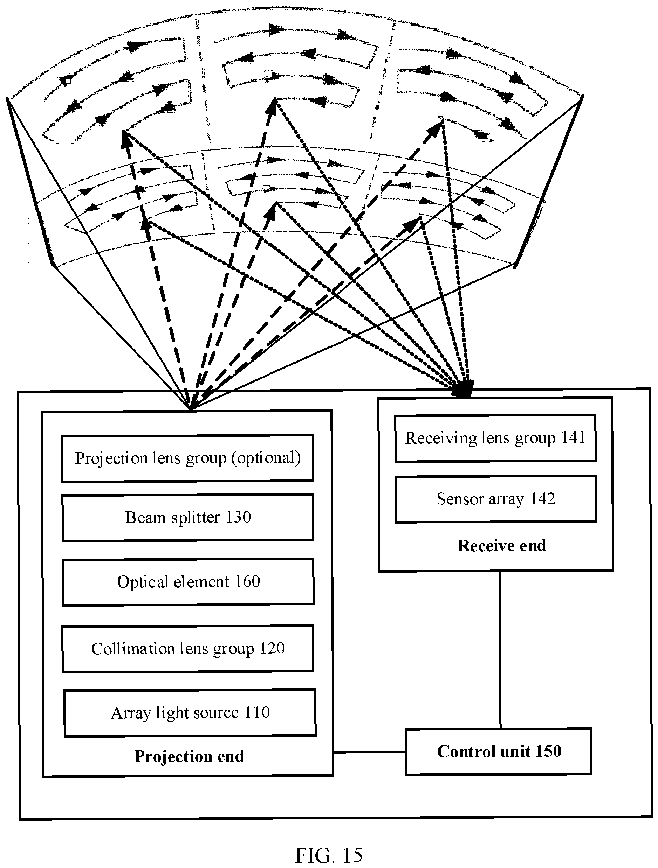

The following describes in detail a working process of the TOF depth sensing module in the embodiments of this application with reference to FIG. 15.

FIG. 15 is a schematic working diagram of a TOF depth sensing module according to an embodiment of this application.

As shown in FIG. 15, the TOF depth sensing module includes a projection end, a receive end, and a control unit. The control unit is configured to control the projection end to emit an emergent beam outward, to scan a target region. The control unit is further configured to control the receive end to receive a reflected beam obtained through reflection by the target scanning region.

The projection end includes an array light source 110, a collimation lens group 120, an optical element 160, a beam splitter 130, and a projection lens group (optional). The receive end includes a receiving lens group 141 and a sensor 142. The control unit 150 is further configured to control time sequences of the array light source 110, the optical element 160, and the sensor 142 to be synchronized.

The collimation lens group 140 in the TOF depth sensing module shown in FIG. 15 may include one to four lenses, and the collimation lens group 140 is configured to convert, into approximately parallel light, a first beam generated by the array light source 110.

A working process of the TOF depth sensing module shown in FIG. 15 is as follows:

(1) After the collimation lens group 120 performs collimation processing on a beam emitted by the array light source 110, a collimated beam is formed, and arrives at the optical element 160.

(2) The optical element 160 orderly deflects the beam based on time sequence control of the control unit, so that an angle of the emitted deflected beam implements two-dimensional scanning.

(3) The deflected beam emitted by the optical element 160 arrives at the beam splitter 130.

(4) The beam splitter 130 replicates a deflected beam at each angle to obtain emergent beams at a plurality of angles, so as to implement two-dimensional replication of the beam.

(5) In each scanning period, the receive end can perform imaging only for a target region illuminated by a light spot.

(6) After the optical element completes all S×T times of scanning, the two-dimensional array sensor of the receive end generates S×T images, and a processor finally splices the images into a higher-resolution image.

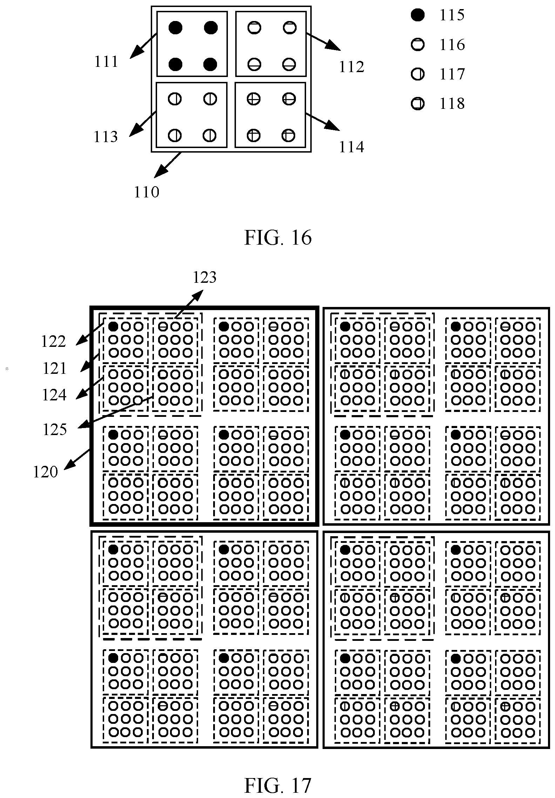

The array light source in the TOF depth sensing module in this embodiment of this application may be include a plurality of light emitting regions, and each light emitting region may independently emit light. With reference to FIG. 16, the following describes in detail the working process of the TOF depth sensing module when the array light source in the TOF depth sensing module in this embodiment of this application includes a plurality of light emitting regions.

FIG. 16 is a schematic diagram of a light emitting region of an array light source.

When the array light source 110 includes a plurality of light emitting regions, the working process of the TOF depth sensing module in this embodiment of this application is as follows:

(1) After the collimation lens group 120 processes beams emitted by different light emitting regions of the array light source 110 through time division, collimated beams are formed, and arrive at the beam splitter 130, the beam splitter 130 is controlled by a time sequence signal of the control unit, to orderly deflect the beam, so that an angle of an emergent beam can implement two-dimensional scanning.

(2) The beams obtained after the collimation lens group 120 performs collimation processing arrive at the beam splitter 130, and the beam splitter 130 replicates an incident beam at each angle to simultaneously generate emergent beams at a plurality of angles, so as to implement two-dimensional replication of the beam.

(3) In each scanning period, the receive end performs imaging only for a target region illuminated by a light spot.

(4) After the optical element completes all S×T times of scanning, the two-dimensional array sensor of the receive end generates S×T images, and a processor finally splices the images into a higher-resolution image.

The following describes a scanning working principle of the TOF depth sensing module in this embodiment of this application with reference to FIG. 16 and FIG. 17.

As shown in FIG. 16, 111, 112, 113, and 114 are independent light emitting regions of the array light source, and may be lit through time division, and 115, 116, 117, and 118 are light emitting holes in different independent working regions of the array light source.

FIG. 17 is a schematic diagram of performing, by using a beam splitter, beam splitting processing on a beam emitted by the array light source shown in FIG. 16.

As shown in FIG. 17, 120 is a replication order (black solid-line box in the upper left corner of FIG. 17) generated by the beam splitter, 121 is a target region corresponding to one pixel of the two-dimensional array sensor (121 includes 122, 123, 124, and 125), 122 is a light spot generated after the light emitting hole 115 performs scanning by using a beam and the beam splitter, 123 is a light spot generated after the light emitting hole 116 performs scanning by using a beam and the optical element, 124 is a light spot generated after the light emitting hole 117 performs scanning by using a beam and the optical element, and 125 is a light spot generated after the light emitting hole 118 performs scanning by using a beam and the optical element.

A specific scanning process of a TOF depth sensing module having the array light source shown in FIG. 16 is as follows:

Only 115 is lit, and the optical element separately performs scanning by using a beam to implement the light spot 122;
115 is extinguished, 116 is lit, and the optical element separately performs scanning by using a beam to implement the light spot 123;
116 is extinguished, 117 is lit, and the optical element separately performs scanning by using a beam to implement the light spot 124; and
117 is extinguished, 118 is lit, and the optical element separately performs scanning by using a beam to implement the light spot 125.

Light spots of a target region corresponding to one pixel of the two-dimensional array sensor may be scanned by using the foregoing four steps.

The optical element 160 in FIG. 13 to FIG. 15 may be any one of devices such as a liquid crystal polarization grating, an electro-optic device, an acousto-optic device, and an optical phased array device. For detailed descriptions of the devices such as the liquid crystal polarization grating, the electro-optic device, the acousto-optic device, and the optical phased array device, refer to related descriptions in Case 1 to Case 4 below.

The foregoing describes in detail the TOF depth sensing module in the embodiments of this application with reference to the accompanying drawings. The following describes an image generation method in the embodiments of this application with reference to the accompanying drawings.

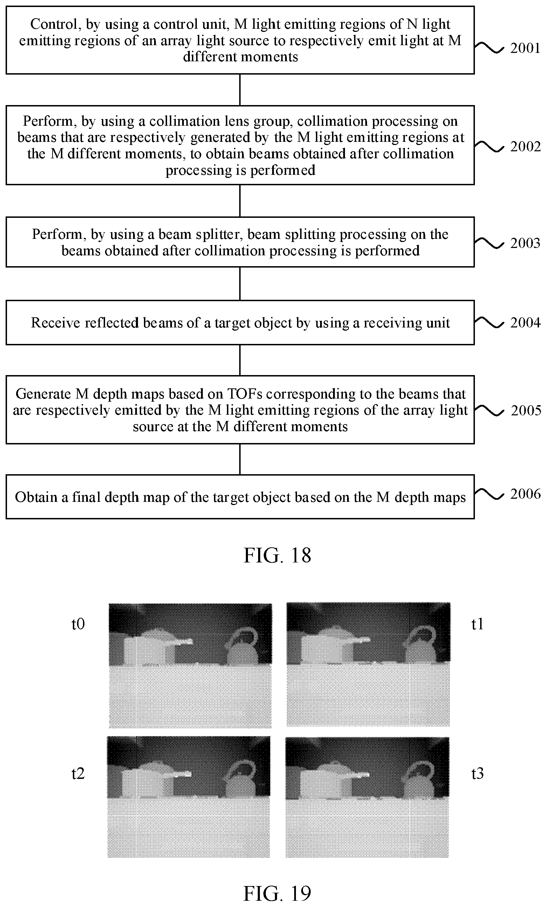

FIG. 18 is a schematic flowchart of an image generation method according to an embodiment of this application. The method shown in FIG. 18 may be performed by a terminal device including the TOF depth sensing module in the embodiments of this application. Specifically, the method shown in FIG. 18 may be performed by a terminal device including the TOF depth sensing module shown in FIG. 3. The method shown in FIG. 18 includes step 2001 to step 2006. The following separately describes the steps in detail.

2001. Control, by using a control unit, M light emitting regions of N light emitting regions of an array light source to respectively emit light at M different moments.

M is less than or equal to N, M is a positive integer, and N is a positive integer greater than 1.

In the foregoing step 2001, the control unit may control the array light source to emit light.

Specifically, the control unit may respectively send control signals to the M light emitting regions of the array light source at the M moments, to control the M light emitting regions to respectively emit light at the M different moments independently.

For example, as shown in FIG. 6, the array light source 110 includes four independent light emitting regions A, B, C, and D. In this case, the control unit may respectively send control signals to the four independent light emitting regions A, B, C, and D at a moment t0, a moment t1, a moment t2, and a moment t3, so that the four independent light emitting regions A, B, C, and D respectively emit light at the moment t0, the moment t1, the moment t2, and the moment t3.

2002. Perform, by using a collimation lens group, collimation processing on beams that are respectively generated by the M light emitting regions at the M different moments, to obtain beams obtained after collimation processing is performed.

FIG. 6 is still used as an example for description. When the four independent light emitting regions A, B, C, and D of the array light source respectively emit beams at the moment t0, the moment t1, the moment t2, and the moment t3, the collimation lens group may perform collimation processing on the beams that are respectively emitted by the light emitting regions A, B, C, and D at the moment t0, the moment t1, the moment t2, and the moment t3, to obtain beams obtained after collimation processing is performed.

2003. Perform, by using a beam splitter, beam splitting processing on the beams obtained after collimation processing is performed.

The beam splitter may specifically split each received beam of light into a plurality of beams of light, and a quantity of beams obtained after the beam splitter performs beam splitting on a beam from one light emitting region of the array light source may be P×Q.

As shown in FIG. 6, the light emitting regions A, B, C, and D of the array light source respectively emit beams at the moment t0, the moment t1, the moment t2, and the moment t3. In this case, after the beams that are respectively emitted by the light emitting regions A, B, C, and D at the moment t0, the moment t1, the moment t2, and the moment t3 are processed by the collimation lens group, the beams are incident into the beam splitter for processing. A result obtained after the beam splitter performs beam splitting processing on the light emitting regions A, B, C, and D may be shown at the right of FIG. 6.

Optionally, beam splitting processing in the foregoing step 2003 specifically includes: performing, by using the beam splitter, one-dimensional or two-dimensional beam splitting processing on the beams generated after collimation processing is performed.

2004. Receive reflected beams of a target object by using a receiving unit.

The reflected beam of the target object is a beam obtained by the target object by reflecting a beam from the beam splitter.

Optionally, the receiving unit in the foregoing step 2004 includes a receiving lens group and a sensor. The foregoing step 2004 of receiving reflected beams of a target object by using a receiving unit includes: converging the reflected beams of the target object to the sensor by using the receiving lens group. The sensor herein may also be referred to as a sensor array, and the sensor array may be a two-dimensional sensor array.

Optionally, resolution of the sensor is greater than or equal to P×Q, and a quantity of beams obtained after the beam splitter performs beam splitting on a beam from one light emitting region of the array light source is P×Q.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

2005. Generate M depth maps based on TOFs corresponding to the beams that are respectively emitted by the M light emitting regions of the array light source at the M different moments.

The TOFs corresponding to the beams that are respectively emitted by the M light emitting regions of the array light source at the M different moments may be specifically time difference information between emission moments of the beams that are respectively emitted by the M light emitting regions of the array light source at the M different moments and receiving moments of the corresponding reflected beams.

For example, the array light source includes three light emitting regions A, B, and C, the light emitting region A emits a beam at a moment T0, the light emitting region B emits a beam at a moment T1, and the light emitting region C emits a beam at a moment T2. In this case, a TOF corresponding to the beam emitted by the light emitting region A at the moment T0 may be specifically time difference information between the moment T0 and a moment at which the beam emitted by the light emitting region A at the moment T0 finally arrives at the receiving unit (or is received by the receiving unit) after the beam is subject to collimation processing of the collimation lens group and beam splitting processing of the beam splitter, arrives at the target object, and is reflected by the target object. A TOF corresponding to the beam emitted by the light emitting region B at the moment T1 and a TOF corresponding to the beam emitted by the light emitting region C at the moment T2 also have similar meanings. Optionally, the M depth maps are respectively depth maps corresponding to M region sets of the target object, and there is no overlapping region between any two region sets in the M region sets.

Optionally, the foregoing step 2005 of generating M depth maps of the target object specifically includes:

2005a. Determine distances between M regions of the target object and the TOF depth sensing module based on the TOFs corresponding to the beams that are respectively emitted by the M light emitting regions at the M different moments.
2005b. Generate depth maps of the M regions of the target object based on the distances between the M regions of the target object and the TOF depth sensing module.
2006. Obtain a final depth map of the target object based on the M depth maps.

Specifically, in step 2006, the M depth maps may be spliced to obtain the depth map of the target object.

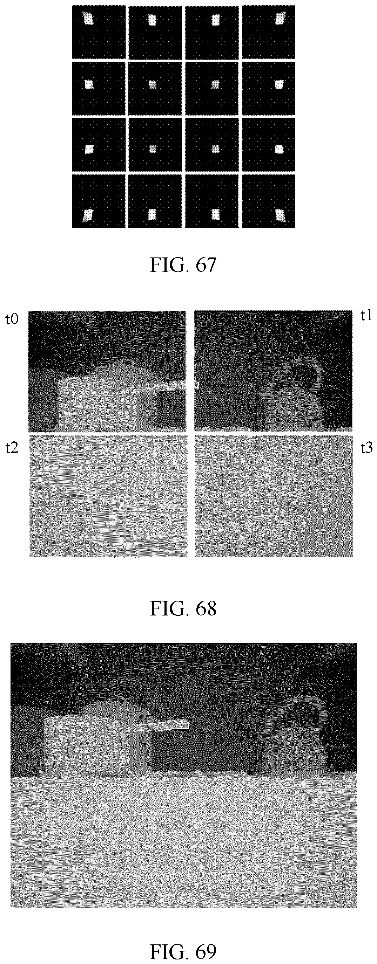

For example, depth maps of the target object at moments t0 to t3 are obtained by using the foregoing step 2001 to step 2005. The depths maps at the four moments are shown in FIG. 19. The final depth map that is of the target object and that is obtained by splicing the depth maps that are at the moments t0 to t3 and that are shown in FIG. 19 may be shown in FIG. 69.

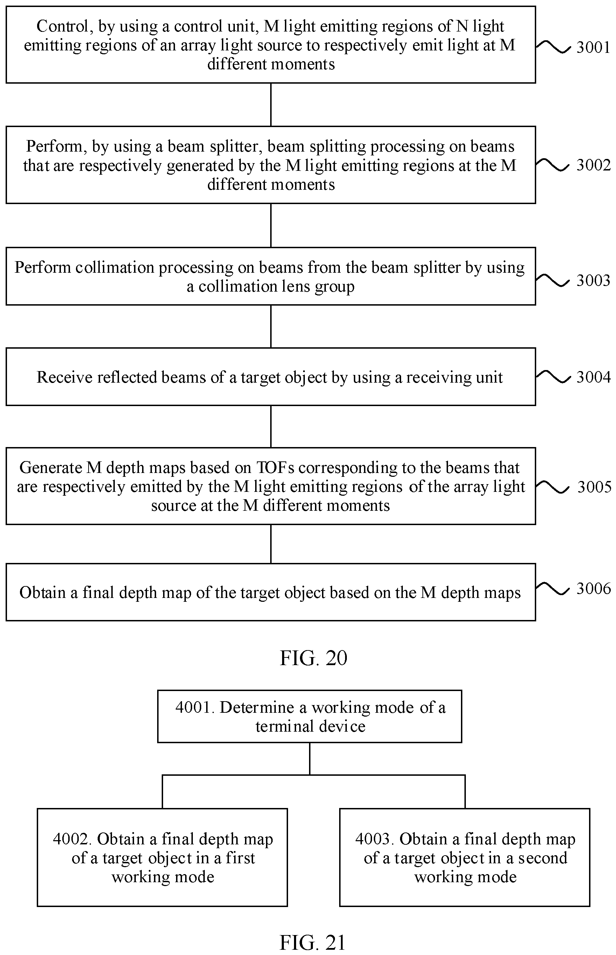

When the TOF depth sensing module has different structures, processes of corresponding image generation methods are also different. The following describes the image generation method in the embodiments of this application with reference to FIG. 20.

FIG. 20 is a schematic flowchart of an image generation method according to an embodiment of this application. The method shown in FIG. 20 may be performed by a terminal device including the TOF depth sensing module in the embodiments of this application. Specifically, the method shown in FIG. 20 may be performed by a terminal device including the TOF depth sensing module shown in FIG. 11. The method shown in FIG. 20 includes step 3001 to step 3006. The following separately describes the steps in detail.

3001. Control, by using a control unit, M light emitting regions of N light emitting regions of an array light source to respectively emit light at M different moments.

The N light emitting regions do not overlap each other, M is less than or equal to N, M is a positive integer, and N is a positive integer greater than 1.

The controlling, by using a control unit, M light emitting regions of N light emitting regions of an array light source to respectively emit light at M different moments may specifically mean respectively controlling, by using the control unit, the M light emitting regions to successively emit light at the M different moments.

For example, as shown in FIG. 16, the array light source includes four light emitting regions 111, 112, 113, and 114. In this case, the control unit may control 111, 112, and 113 to respectively emit light at a moment T0, a moment T1, and a moment T2. Alternatively, the control unit may control 111, 112, 113, and 114 to respectively emit light at a moment T0, a moment T1, a moment T2, and a moment T3.

3002. Perform, by using a beam splitter, beam splitting processing on beams that are respectively generated by the M light emitting regions at the M different moments.

The beam splitter is specifically configured to split each received beam of light into a plurality of beams of light.

The performing, by using a beam splitter, beam splitting processing on beams that are respectively generated by the M light emitting regions at the M different moments may specifically mean respectively performing, by using the beam splitter, beam splitting processing on the beams generated by the M light emitting regions at the M different moments.

For example, as shown in FIG. 16, the array light source includes four light emitting regions 111, 112, 113, and 114. The control unit may control 111, 112, and 113 to respectively emit light at a moment T0, a moment T1, and a moment T2. In this case, the beam splitter may perform, at the moment T0, beam splitting processing on a beam emitted by 111, perform, at the moment T1, beam splitting processing on a beam emitted by 112, and perform, at the moment T2, beam splitting processing on a beam emitted by 112 (it should be understood that a time required by the beam to arrive at the beam splitter from the light emitting region is ignored herein).

Optionally, beam splitting processing in the foregoing step 3002 specifically includes: respectively performing, by using the beam splitter, one-dimensional or two-dimensional beam splitting processing on the beams generated by the M light emitting regions at the M different moments.

3003. Perform collimation processing on beams from the beam splitter by using a collimation lens group.

For example, FIG. 16 is still used as an example. The beam splitter respectively performs, at the moment T0, the moment T1, and the moment T2, beam splitting processing on the beams emitted by 111, 112, and 113. In this case, the collimation lens group may perform, at the moment T0, collimation processing on a beam obtained after the beam splitter performs beam splitting processing on 111; perform, at the moment T1, collimation processing on a beam obtained after the beam splitter performs beam splitting processing on 112; and perform, at the moment T2, collimation processing on a beam obtained after the beam splitter performs beam splitting processing on 113.

3004. Receive reflected beams of a target object by using a receiving unit.

The reflected beam of the target object is a beam obtained by the target object by reflecting a beam from the collimation lens group.

Optionally, the receiving unit in the foregoing step 3004 includes a receiving lens group and a sensor. The foregoing step 3004 of receiving reflected beams of a target object by using a receiving unit includes: converging the reflected beams of the target object to the sensor by using the receiving lens group. The sensor herein may also be referred to as a sensor array, and the sensor array may be a two-dimensional sensor array.

Optionally, resolution of the sensor is greater than or equal to $P \times Q$, and a quantity of beams obtained after the beam splitter performs beam splitting on a beam from one light emitting region of the array light source is $P \times Q$.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

3005. Generate M depth maps based on TOFs corresponding to the beams that are respectively emitted by the M light emitting regions of the array light source at the M different moments.

The TOFs corresponding to the beams that are respectively emitted by the M light emitting regions of the array light source at the M different moments may be specifically time difference information between emission moments of the beams that are respectively emitted by the M light emitting regions of the array light source at the M different moments and receiving moments of the corresponding reflected beams.

For example, the array light source includes three light emitting regions A, B, and C, the light emitting region A emits a beam at a moment T0, the light emitting region B emits a beam at a moment T1, and the light emitting region C emits a beam at a moment T2. In this case, a TOF corresponding to the beam emitted by the light emitting region A at the moment T0 may be specifically time difference information between the moment T0 and a moment at which the beam emitted by the light emitting region A at the moment T0 finally arrives at the receiving unit (or is received by the receiving unit) after the beam is subject to collimation processing of the collimation lens group and beam splitting processing of the beam splitter, arrives at the target object, and is reflected by the target object. A TOF corresponding to the beam emitted by the light emitting region B at the moment T1 and a TOF corresponding to the beam emitted by the light emitting region C at the moment T2 also have similar meanings.

The M depth maps are respectively depth maps corresponding to M region sets of the target object, and there is no overlapping region between any two region sets in the M region sets.

Optionally, the foregoing step 3005 of generating M depth maps specifically includes:

3005a. Determine distances between M regions of the target object and the TOF depth sensing module based on the TOFs corresponding to the beams that are respectively emitted by the M light emitting regions at the M different moments.

3005b. Generate depth maps of the M regions of the target object based on the distances between the M regions of the target object and the TOF depth sensing module.

3006. Obtain a final depth map of the target object based on the M depth maps.

Optionally, the foregoing step 3006 of obtaining a final depth map of the target object includes: splicing the M depth maps to obtain the depth map of the target object.

For example, the depth maps obtained by using the process in step 3001 to step 3005 may be shown in FIG. 68. FIG. 68 shows depth maps corresponding to moments t0 to t3. A final depth map that is of the target object and that is shown in FIG. 69 may be obtained by splicing the depth maps corresponding to the moments t0 to t3.

In this embodiment of this application, different light emitting regions of the array light source are controlled to emit light through time division, and the beam splitter is controlled to perform beam splitting processing on a beam, so that a quantity of beams emittedthe TOF depth sensing module in a time period can be improved, to obtain a plurality of depth maps, and a final depth map obtained through splicing based on the plurality of depth maps has high spatial resolution and a high frame rate.

Main processing processes of the method shown in FIG. 20 and the method shown in FIG. 18 are similar. A main difference is as follows: In the method shown in FIG. 20, beam splitting processing is first performed, by using the beam splitter, on a beam emitted by the array light source, and then collimation processing is performed, by using the collimation lens group, on a beam obtained after beam splitting processing is performed. In the method shown in FIG. 18, collimation processing is first performed, by using the collimation lens group, on a beam emitted by the array light source, and then beam splitting processing is performed, by using the beam splitter, on a beam obtained after collimation processing is performed.

When the image generation method in the embodiments of this application is performed by a terminal device, the terminal device may have different working modes, light emitting manners of the array light source in different working modes and manners of subsequently generating the final depth map of the target object are different. With reference to the accompanying drawings, the following describes in detail how to obtain the final depth map of the target object in different working modes.

FIG. 21 is a schematic flowchart of an image generation method according to an embodiment of this application.

The method shown in FIG. 21 includes step 4001 to step 4003. The following separately describes the steps in detail.

4001. Determine a working mode of a terminal device.

The terminal device includes a first working mode and a second working mode. In the first working mode, a control unit may control L light emitting regions of N light emitting regions of an array light source to simultaneously emit light. In the second working mode, a control unit may control M light emitting regions of N light emitting regions of an array light source to emit light at M different moments.

It should be understood that when it is determined in the foregoing step 4001 that the terminal device works in the first working mode, step 4002 is performed; or when it is determined in the foregoing step 4001 that the terminal device works in the second working mode, step 4003 is performed.

The following describes in detail a specific process of determining the working mode of the terminal device in step 4001.

Optionally, the foregoing step 4001 of determining a working mode of a terminal device includes: determining the working mode of the terminal device based on working mode selection information of a user.

The working mode selection information of the user is used to select one of the first working mode and the second working mode as the working mode of the terminal device.

Specifically, when the image generation method is performed by the terminal device, the terminal device may obtain the working mode selection information of the user from the user. For example, the user may enter the working mode selection information of the user by using an operation interface of the terminal device.

The working mode of the terminal device is determined based on the working mode selection information of the user, so that the user can flexibly select and determine the working mode of the terminal device.

Optionally, the foregoing step 4001 of determining a working mode of a terminal device includes: determining the working mode of the terminal device based on a distance between the terminal device and a target object.

Specifically, when the distance between the terminal device and the target object is less than or equal to a preset distance, it may be determined that the terminal device works in the first working mode. When the distance between the terminal device and the target object is greater than a preset distance, it may be determined that the terminal device works in the second working mode.

When the distance between the terminal device and the target object is small, the array light source has a sufficient light emitting power to simultaneously emit a plurality of beams that arrive at the target object. Therefore, when the distance between the terminal device and the target object is small, the first working mode is used, so that a plurality of light emitting regions of the array light source can simultaneously emit light, to help subsequently obtain depth information of more regions of the target object, and improve a frame rate of a depth map of the target object when resolution of the depth map of the target object is fixed.

When the distance between the terminal device and the target object is large, because a total power of the array light source is limited, a depth map of the target object may be obtained by using the second working mode. Specifically, the array light source is controlled to emit beams through time division, so that the beams emitted by the array light source through time division can also arrive at the target object. Therefore, when the terminal device is far away from the target object, depth information of different regions of the target object can also be obtained through time division, to obtain the depth map of the target object.

Optionally, the foregoing step 4001 of determining a working mode of a terminal device includes: determining the working mode of the terminal device based on a scenario in which the target object is located.

Specifically, when the terminal device is in an indoor scenario, it may be determined that the terminal device works in the first working mode. When the terminal device is in an outdoor scenario, it may be determined that the terminal device works in the second working mode.

When the terminal device is in the indoor scenario, because the distance between the terminal device and the target object is small, and external noise is weak, the array light source has a sufficient light emitting power to simultaneously emit a plurality of beams that arrive at the target object. Therefore, when the distance between the terminal device and the target object is small, the first working mode is used, so that a plurality of light emitting regions of the array light source can simultaneously emit light, to help subsequently obtain depth information of more regions of the target object, and improve a frame rate of a depth map of the target object when resolution of the depth map of the target object is fixed.

When the terminal device is in the outdoor scenario, because the distance between the terminal device and the target object is large, external noise is large, and a total power of the array light source is limited, a depth map of the target object may be obtained by using the second working mode. Specifically, the array light source is controlled to emit beams through time division, so that the beams emitted by the array light source through time division can also arrive at the target object. Therefore, when the terminal device is far away from the target object, depth information of different regions of the target object can also be obtained through time division, to obtain the depth map of the target object.

The working mode of the terminal device can be flexibly determined based on the distance between the terminal device and the target object or the scenario in which the target object is located, so that the terminal device works in a proper working mode.

4002. Obtain a final depth map of the target object in the first working mode.

4003. Obtain a final depth map of the target object in the second working mode.

In this embodiment of this application, the image generation method has different working modes. Therefore, the depth map of the target object may be generated by selecting the first working mode or the second working mode based on different cases, so that flexibility of generating the depth map of the target object can be improved, and a high-resolution depth map of the target object can be obtained in the two working modes.

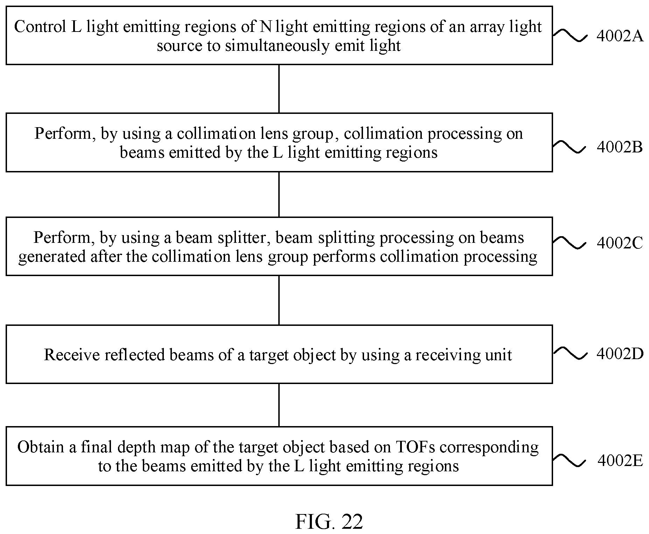

With reference to FIG. 22, the following describes in detail a process of obtaining the final depth map of the target object in the first working mode.

FIG. 22 is a schematic flowchart of obtaining a final depth map of a target object in a first working mode. The process shown in FIG. 22 includes step 4002A to step 4002E. The following separately describes the steps in detail.

4002A. Control L light emitting regions of N light emitting regions of an array light source to simultaneously emit light.

L is less than or equal to N, L is a positive integer, and N is a positive integer greater than 1.

In step 4002A, a control unit may control the L light emitting regions of the N light emitting regions of the array light source to simultaneously emit light. Specifically, the control unit may send control signals to the L light emitting regions of the N light emitting regions of the array light source at a moment T, to control the L light emitting regions to simultaneously emit light at the moment T.

For example, the array light source includes four independent light emitting regions A, B, C, and D. In this case, the control unit may send control signals to the four independent light emitting regions A, B, C, and D at the moment T, so that the four independent light emitting regions A, B, C, and D simultaneously emit light at the moment T.

4002B. Perform, by using a collimation lens group, collimation processing on beams emitted by the L light emitting regions.

It is assumed that the array light source includes four independent light emitting regions A, B, C, and D. In this case, the collimation lens group may perform collimation processing on the beams emitted by the light emitting regions A, B, C, and D of the array light source at the moment T, to obtain beams obtained after collimation processing is performed.

In step 4002B, an approximately parallel beam can be obtained by performing collimation processing on a beam by using the collimation lens group, so that a power density of the beam can be improved, and an effect of subsequently performing scanning by using the beam can be improved.

4002C. Perform, by using a beam splitter, beam splitting processing on beams generated after the collimation lens group performs collimation processing.

The beam splitter is specifically configured to split each received beam of light into a plurality of beams of light.

4002D. Receive reflected beams of a target object by using a receiving unit.

The reflected beam of the target object is a beam obtained by the target object by reflecting a beam from the beam splitter.

4002E. Obtain a final depth map of the target object based on TOFs corresponding to the beams emitted by the L light emitting regions.

The TOFs corresponding to the beams emitted by the L light emitting regions may be specifically time difference information between the moment T and receiving moments of the reflected beams corresponding to the beams that are separately emitted by the L light emitting regions of the array light source at the moment T.

Optionally, the receiving unit includes a receiving lens group and a sensor. The foregoing step 4002D of receiving reflected beams of a target object by using a receiving unit includes: converging the reflected beams of the target object to the sensor by using the receiving lens group.

The sensor may also be referred to as a sensor array, and the sensor array may be a two-dimensional sensor array.

Optionally, resolution of the sensor is greater than $P \times Q$, and a quantity of beams obtained after the beam splitter performs beam splitting on a beam from one light emitting region of the array light source is $P \times Q$.

Both P and Q are positive integers. The resolution of the sensor is greater than the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

Optionally, the foregoing step 4002E of generating a final depth map of the target object specifically includes:

(1) Generate depth maps of L regions of the target object based on the TOFs corresponding to the beams emitted by the L light emitting regions.
(2) Synthesize the depth map of the target object based on the depth maps of the L regions of the target object.

The method shown in FIG. 22 may be performed by the TOF depth sensing module shown in FIG. 3 or a terminal device including the TOF depth sensing module shown in FIG. 3.

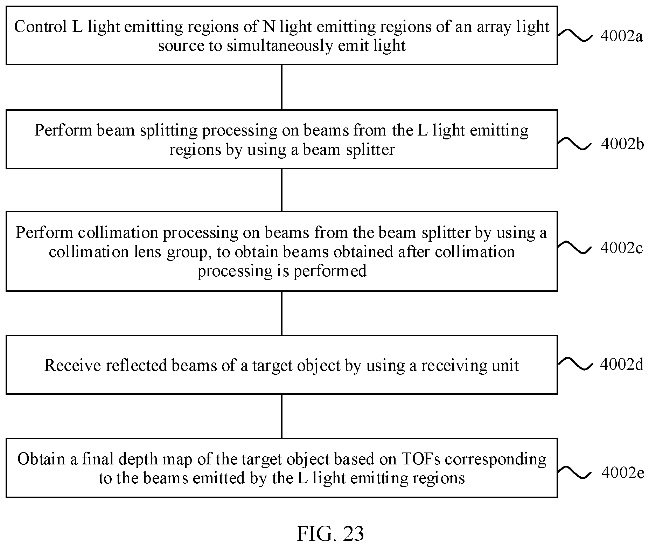

The process of obtaining the final depth map of the target object in the first working mode varies with a relationship between relative locations of the collimation lens group and the beam splitter in the TOF depth sensing module. With reference to FIG. 23, the following describes the process of obtaining the final depth map of the target object in the first working mode.

FIG. 23 is a schematic flowchart of obtaining a final depth map of a target object in a first working mode. The process shown in FIG. 23 includes step 4002a to step 4002e. The following separately describes the steps in detail.

4002a. Control L light emitting regions of N light emitting regions of an array light source to simultaneously emit light.

L is less than or equal to N, L is a positive integer, and N is a positive integer greater than 1.

In step 4002a, a control unit may control the L light emitting regions of the N light emitting regions of the array light source to simultaneously emit light. Specifically, the control unit may send control signals to the L light emitting regions of the N light emitting regions of the array light source at a moment T, to control the L light emitting regions to simultaneously emit light at the moment T.

For example, the array light source includes four independent light emitting regions A, B, C, and D. In this case, the control unit may send control signals to the four independent light emitting regions A, B, C, and D at the moment T, so that the four independent light emitting regions A, B, C, and D simultaneously emit light at the moment T.

4002b. Perform beam splitting processing on beams from the L light emitting regions by using a beam splitter.

The beam splitter is specifically configured to split each received beam of light into a plurality of beams of light.

4002c. Perform collimation processing on beams from the beam splitter by using a collimation lens group, to obtain beams obtained after collimation processing is performed.

4002d. Receive reflected beams of a target object by using a receiving unit.

The reflected beam of the target object is a beam obtained by the target object by reflecting the beam obtained after collimation processing is performed.

4002e. Obtain a final depth map of the target object based on TOFs corresponding to the beams emitted by the L light emitting regions.

The TOFs corresponding to the beams emitted by the L light emitting regions may be specifically time difference information between the moment T and receiving moments of the reflected beams corresponding to the beams that are separately emitted by the L light emitting regions of the array light source at the moment T.

Optionally, the receiving unit includes a receiving lens group and a sensor. The foregoing step 4002d of receiving reflected beams of a target object by using a receiving unit includes: converging the reflected beams of the target object to the sensor by using the receiving lens group.

The sensor may also be referred to as a sensor array, and the sensor array may be a two-dimensional sensor array.

Optionally, resolution of the sensor is greater than $P \times Q$, and a quantity of beams obtained after the beam splitter performs beam splitting on a beam from one light emitting region of the array light source is $P \times Q$.

Both P and Q are positive integers. The resolution of the sensor is greater than the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

Optionally, the foregoing step 4002e of generating a final depth map of the target object specifically includes:

(1) Generate depth maps of L regions of the target object based on the TOFs corresponding to the beams emitted by the L light emitting regions.
(2) Synthesize the depth map of the target object based on the depth maps of the L regions of the target object.

Both the process shown in FIG. 23 and the process shown in FIG. 22 are how to obtain the final depth map of the target object in the first working mode. A main difference is as follows: In FIG. 23, beam splitting processing is first performed, by using the beam splitter, on a beam emitted by the array light source, and then collimation processing is performed, by using the collimation lens group, on a beam obtained after beam splitting processing is performed. In FIG. 22, collimation processing is first performed, by using the collimation lens group, on a beam emitted by the array light source, and then beam splitting processing may be performed, by using the beam splitter, on a beam obtained after collimation processing is performed.

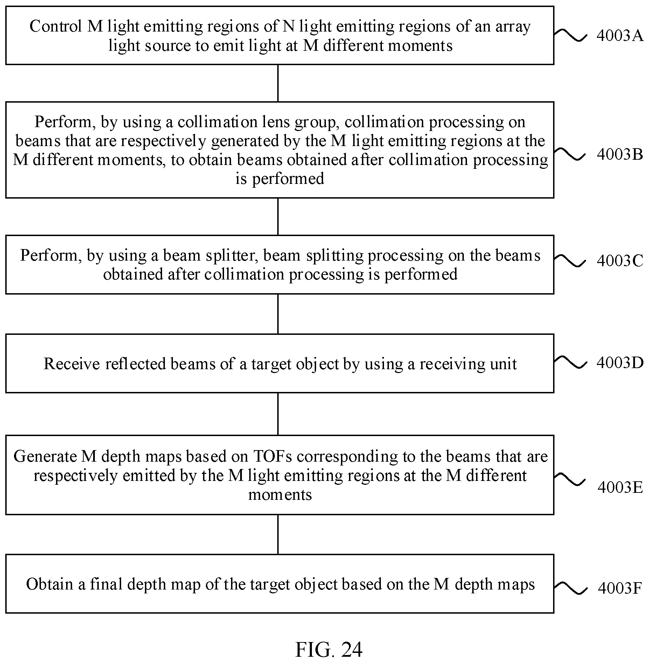

With reference to FIG. 24, the following describes in detail a process of obtaining the final depth map of the target object in the second working mode.

FIG. 24 is a schematic flowchart of obtaining a final depth map of a target object in a second working mode. The process shown in FIG. 24 includes step 4003A to step 4003E. The following separately describes the steps in detail.

4003A. Control M light emitting regions of N light emitting regions of an array light source to emit light at M different moments.

M is less than or equal to N, and both M and N are positive integers.

In step 4003A, a control unit may control the array light source to emit light. Specifically, the control unit may respectively send control signals to the M light emitting regions of the array light source at the M moments, to control the M light emitting regions to respectively emit light at the M different moments independently.

For example, the array light source includes four independent light emitting regions A, B, C, and D. In this case, the control unit may respectively send control signals to the four independent light emitting regions A, B, and C at a moment t0, a moment t1, and a moment t2, so that the three independent light emitting regions A, B, and C respectively emit light at the moment t0, the moment t1, and the moment t2.

4003B. Perform, by using a collimation lens group, collimation processing on beams that are respectively generated by the M light emitting regions at the M different moments, to obtain beams obtained after collimation processing is performed.

The foregoing step 4003B of performing, by using a collimation lens group, collimation processing on beams that are respectively generated by the M light emitting regions at the M different moments may specifically mean respectively performing, by using the collimation lens group, collimation processing on the beams generated by the M light emitting regions at the M different moments.

It is assumed that the array light source includes four independent light emitting regions A, B, C, and D, and the three independent light emitting regions A, B, and C of the array light source respectively emit light at a moment t0, a moment t1, and a moment t2 under the control of the control unit. In this case, the collimation lens group may perform collimation processing on beams that are respectively emitted by the light emitting regions A, B, and C at the moment t0, the moment t1, and the moment t2.

An approximately parallel beam can be obtained by performing collimation processing on a beam by using the collimation lens group, so that a power density of the beam can be improved, and an effect of subsequently performing scanning by using the beam can be improved.

4003C. Perform, by using a beam splitter, beam splitting processing on the beams obtained after collimation processing is performed.

4003D. Receive reflected beams of a target object by using a receiving unit.

The beam splitter is specifically configured to split each received beam of light into a plurality of beams of light. The reflected beam of the target object is a beam obtained by the target object by reflecting a beam from the beam splitter.

4003E. Generate M depth maps based on TOFs corresponding to the beams that are respectively emitted by the M light emitting regions at the M different moments.

The TOFs corresponding to the beams that are respectively emitted by the M light emitting regions of the array light source at the M different moments may be specifically time difference information between emission moments of the beams that are respectively emitted by the M light emitting regions of the array light source at the M different moments and receiving moments of the corresponding reflected beams.

4003F. Obtain a final depth map of the target object based on the M depth maps.

Optionally, the M depth maps are respectively depth maps corresponding to M region sets of the target object, and there is no overlapping region between any two region sets in the M region sets.

Optionally, the receiving unit includes a receiving lens group and a sensor. The foregoing step 4003D of receiving reflected beams of a target object by using a receiving unit includes: converging the reflected beams of the target object to the sensor by using the receiving lens group.

The sensor may also be referred to as a sensor array, and the sensor array may be a two-dimensional sensor array.

Optionally, resolution of the sensor is greater than or equal to P×Q, and a quantity of beams obtained after the beam splitter performs beam splitting on a beam from one light emitting region of the array light source is P×Q.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

Optionally, the foregoing step 4003E of generating M depth maps specifically includes:

(1) Determine distances between M regions of the target object and the TOF depth sensing module based on the TOFs corresponding to the beams that are respectively emitted by the M light emitting regions at the M different moments.

(2) Generate depth maps of the M regions of the target object based on the distances between the M regions of the target object and the TOF depth sensing module.

(3) Synthesize the depth map of the target object based on the depth maps of the M regions of the target object.

The method shown in FIG. 24 may be performed by the TOF depth sensing module shown in FIG. 3 or a terminal device including the TOF depth sensing module shown in FIG. 3.

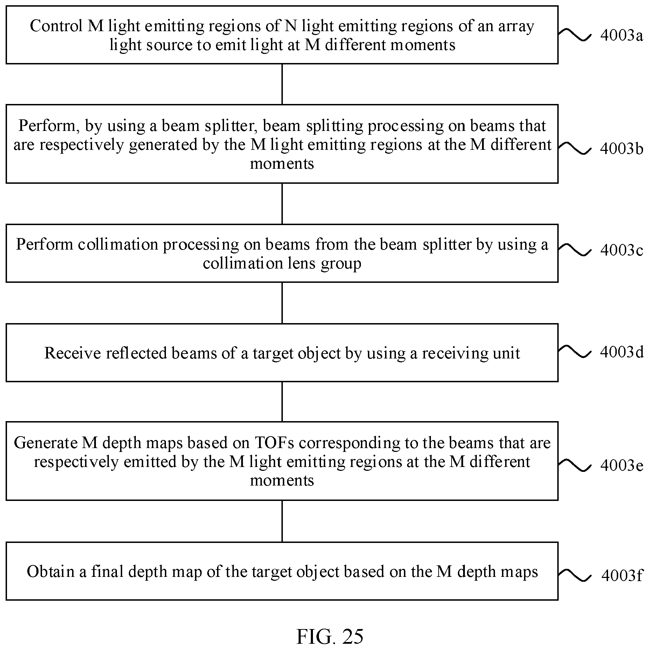

The process of obtaining the final depth map of the target object in the second working mode varies with a relationship between relative locations of the collimation lens group and the beam splitter in the TOF depth sensing module. With reference to FIG. 25, the following describes the process of obtaining the final depth map of the target object in the second working mode.

FIG. 25 is a schematic flowchart of obtaining a final depth map of a target object in a second working mode. The process shown in FIG. 25 includes step 4003a to step 4003f. The following separately describes the steps in detail.

4003a. Control M light emitting regions of N light emitting regions of an array light source to emit light at M different moments.

M is less than or equal to N, and both M and N are positive integers.

In step 4003a, a control unit may control the array light source to emit light. Specifically, the control unit may respectively send control signals to the M light emitting regions of the array light source at the M moments, to control the M light emitting regions to respectively emit light at the M different moments independently.

For example, the array light source includes four independent light emitting regions A, B, C, and D. In this case, the control unit may respectively send control signals to the four independent light emitting regions A, B, and C at a moment t0, a moment t1, and a moment t2, so that the three independent light emitting regions A, B, and C respectively emit light at the moment t0, the moment t1, and the moment t2.

4003b. Perform, by using a beam splitter, beam splitting processing on beams that are respectively generated by the M light emitting regions at the M different moments.

The beam splitter is specifically configured to split each received beam of light into a plurality of beams of light.

The performing, by using a beam splitter, beam splitting processing on beams that are respectively generated by the M light emitting regions at the M different moments may specifically mean respectively performing, by using the beam splitter, beam splitting processing on the beams generated by the M light emitting regions at the M different moments.

For example, the array light source includes four independent light emitting regions A, B, C, and D. Under the control of the control unit, the light emitting region A emits light at a moment T0, the light emitting region B emits light at a moment T1, and the light emitting region C emits light at a moment T2. In this case, the beam splitter may perform, at the moment T0, beam splitting processing on a beam emitted by the light emitting region A, perform, at the moment T1, beam splitting processing on a beam emitted by the light emitting region B, and perform, at the moment T2, beam splitting processing on a beam emitted by the light emitting region C.

4003c. Perform collimation processing on beams from the beam splitter by using a collimation lens group.

An approximately parallel beam can be obtained by performing collimation processing on a beam by using the collimation lens group, so that a power density of the beam can be improved, and an effect of subsequently performing scanning by using the beam can be improved.

4003d. Receive reflected beams of a target object by using a receiving unit.

The reflected beam of the target object is a beam obtained by the target object by reflecting a beam from the collimation lens group.

4003e. Generate M depth maps based on TOFs corresponding to the beams that are respectively emitted by the M light emitting regions at the M different moments.

The TOFs corresponding to the beams that are respectively emitted by the M light emitting regions of the array light source at the M different moments may be specifically time difference information between emission moments of the beams that are respectively emitted by the M light emitting regions of the array light source at the M different moments and receiving moments of the corresponding reflected beams.

4003f. Obtain a final depth map of the target object based on the M depth maps.

Optionally, the M depth maps are respectively depth maps corresponding to M region sets of the target object, and there is no overlapping region between any two region sets in the M region sets.

Optionally, the receiving unit includes a receiving lens group and a sensor. The foregoing step 4003d of receiving reflected beams of a target object by using a receiving unit includes: converging the reflected beams of the target object to the sensor by using the receiving lens group.

The sensor may also be referred to as a sensor array, and the sensor array may be a two-dimensional sensor array.

Optionally, resolution of the sensor is greater than or equal to P×Q, and a quantity of beams obtained after the beam splitter performs beam splitting on a beam from one light emitting region of the array light source is P×Q.

Both P and Q are positive integers. The resolution of the sensor is greater than or equal to the quantity of beams obtained after the beam splitter performs beam splitting on a beam from one light emitting region of the array light source. Therefore, the sensor can receive the reflected beam obtained by the target object by reflecting the beam from the beam splitter, so that the TOF depth sensing module can normally receive the reflected beam.

Optionally, the foregoing step 4003e of generating M depth maps specifically includes:

(1) Determine distances between M regions of the target object and the TOF depth sensing module based on the TOFs corresponding to the beams that are respectively emitted by the M light emitting regions at the M different moments.

(2) Generate depth maps of the M regions of the target object based on the distances between the M regions of the target object and the TOF depth sensing module.

(3) Synthesize the depth map of the target object based on the depth maps of the M regions of the target object.

Both the process shown in FIG. 25 and the process shown in FIG. 24 are how to obtain the final depth map of the target object in the second working mode. A main difference is as follows: In FIG. 25, beam splitting processing is first performed, by using the beam splitter, on a beam emitted by the array light source, and then collimation processing is performed, by using the collimation lens group, on a beam obtained after beam splitting processing is performed. In FIG. 24, collimation processing is first performed, by using the collimation lens group, on a beam emitted by the array light source, and then beam splitting processing may be performed, by using the beam splitter, on a beam obtained after collimation processing is performed.

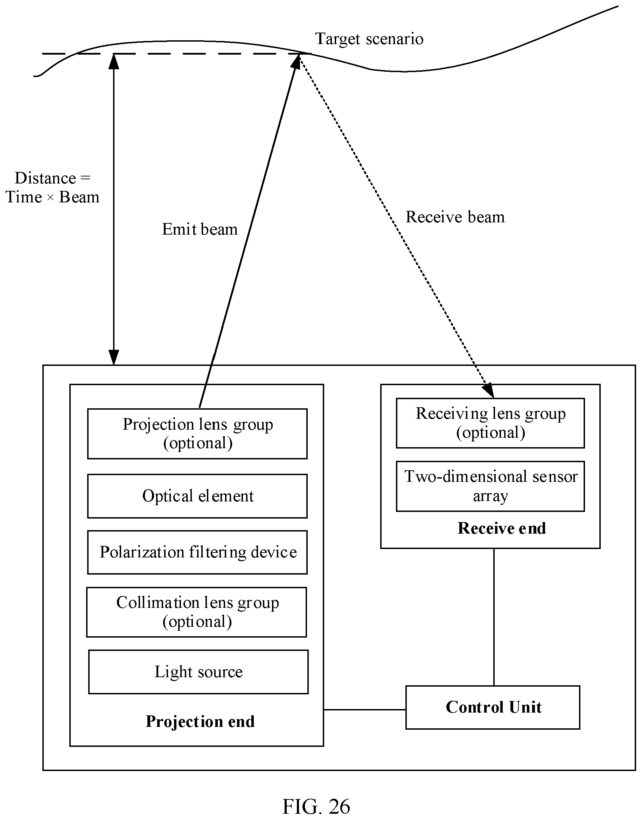

The foregoing describes in detail a TOF depth sensing module and an image generation method in the embodiments of this application with reference to FIG. 1 to FIG. 25. The following describes in detail another TOF depth sensing module and another image generation method in the embodiments of this application with reference to FIG. 26 to FIG. 52.

A conventional TOF depth sensing module generally changes a propagation direction of a beam in a manner in which a component is mechanically rotated or vibrated to drive an optical structure (for example, a reflector, a lens, and a prism) or a light emitting source rotates or vibrates, to scan different regions of a target object. However, the TOF depth sensing module has a large size, and is not suitable to be mounted in some devices (for example, mobile terminals) with limited space. In addition, the TOF depth sensing module generally performs scanning in a manner of continuous scanning. Generally, a generated scanning track is also continuous. When the target object is scanned, flexibility is poor, and a region of interest (region of interest, ROI) cannot be quickly located. Therefore, the embodiments of this application provides a TOF depth sensing module, so that a scanning region of interest can be quickly located in different directions by irradiating different beams to different directions without mechanical rotation and vibration. The following is specifically described with reference to the accompanying drawings.

The following first briefly describes the TOF depth sensing module in the embodiments of this application with reference to FIG. 26.

FIG. 26 is a schematic diagram of performing distance measurement by using a TOF depth sensing module according to an embodiment of this application.

As shown in FIG. 26, the TOF depth sensing module may include a transmit end (or may be referred to as a projection end), a receive end, and a control unit. The transmit end is configured to emit an emergent beam. The receive end is configured to receive a reflected beam (the reflected beam is a beam obtained by a target object by reflecting the emergent beam) of the target object. The control unit may control the transmit end and the receive end to respectively emit and receive a beam.

In FIG. 26, the transmit end may generally include a light source, a collimation lens group (optional), a polarization filtering device, an optical element, and a projection lens group (optional), the receive end may generally include a receiving lens group and a sensor, and the receiving lens group and the sensor may be collectively referred to as a receiving unit.

In FIG. 26, a TOF corresponding to the emergent beam may be recorded by using a timing apparatus, to calculate a distance between the TOF depth sensing module and a target region, and obtain a final depth map of the target object. The TOF corresponding to the emergent beam may be time difference information between a moment at which the reflected beam is received by the receiving unit and an emergent moment of the emergent beam.

The TOF depth sensing module in this embodiment of this application may be configured to obtain a 3D image. The TOF depth sensing module in this embodiment of this application may be disposed in an intelligent terminal (for example, a mobile phone, a tablet, and a wearable device), is configured to obtain a depth image or a 3D image, and may also provide gesture and body recognition for 3D games or motion sensing games.

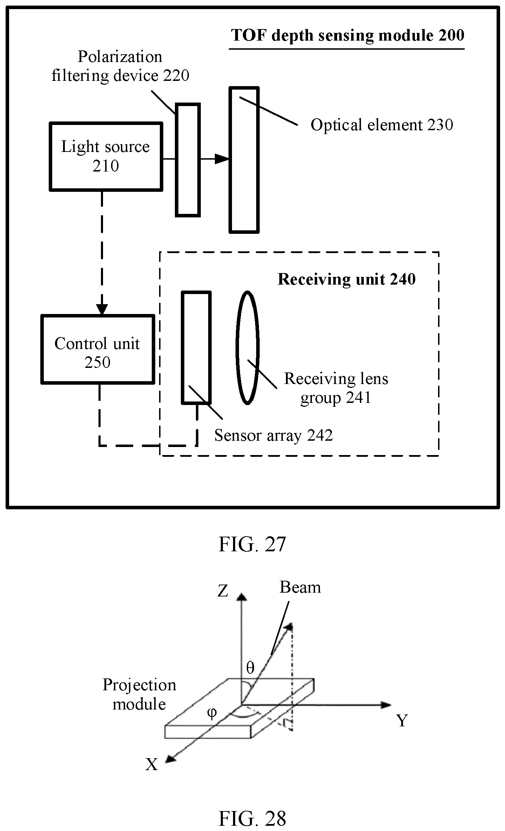

The following describes in detail the TOF depth sensing module in the embodiments of this application with reference to FIG. 27.

FIG. 27 is a schematic block diagram of a TOF depth sensing module according to an embodiment of this application.

A TOF depth sensing module 200 shown in FIG. 27 includes a light source 210, a polarization filtering device 220, an optical element 230, a receiving unit 240, and a control unit 250. The polarization filtering device 220 is located between the light source 210 and the optical element 230. The following describes in detail the modules or units in the TOF depth sensing module 200.

Light source 210:

The light source 210 is configured to generate a beam. Specifically, the light source 210 can generate light in a plurality of polarization states.

Optionally, the beam emitted by the light source 210 is a single beam of quasi-parallel light, and a divergence angle of the beam emitted by the light source 210 is less than 1°.

Optionally, the light source may be a semiconductor laser light source.

The light source may be a vertical cavity surface emitting laser (vertical cavity surface emitting laser, VCSEL).

Optionally, the light source may be a Fabry-Perot laser (which may be briefly referred to as an FP laser).

Compared with a single VCSEL, a single FP laser may implement a larger power, and has higher electro-optic conversion efficiency than the VCSEL, so that a scanning effect can be improved.

Optionally, a wavelength of the beam emitted by the light source 210 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of the beam emitted by the light source 210 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

Polarization filtering device 220:

The polarization filtering device 220 is configured to filter the beam to obtain a beam in a single polarization state.

The beam that is in the single polarization state and that is obtained by the polarization filtering device 220 through filtering is one of the beam that is in a plurality of polarization states and that is generated by the light source 210.

For example, the beam generated by the light source 210 includes linearly polarized light, left-handed circularly polarized light, and right-handed circularly polarized light in different directions. In this case, the polarization filtering device 220 may screen out the left-handed circularly polarized light and the right-handed polarized light in the beam, to obtain a beam whose polarization state is the linearly polarized light in a specified direction.

Optical element 230:

The optical element 230 is configured to adjust a direction of the beam in the single polarization state.

A refractive index parameter of the optical element 230 is controllable. When the refractive index of the optical element 230 varies, the optical element 230 can adjust the beam in the single polarization state to different directions.

The following describes a propagation direction of a beam with reference to the accompanying drawings. The propagation direction of the beam may be defined by using a space angle. As shown in FIG. 28, the space angle of the beam includes an angle θ between the beam and a direction of the Z-axis in a rectangular coordinate system of an emergent surface and an angle φ between a projection of the beam on a plane XY and a direction of the X-axis. The space angle θ or φ of the beam changes when the beam is used for scanning.

Control unit 250:

The control unit 250 is configured to control the refractive index parameter of the optical element 230 to change a propagation direction of the beam in the single polarization state.

The control unit 250 may generate a control signal. The control signal may be a voltage signal, or may be a radio frequency drive signal. The refractive index parameter of the optical element 230 may be changed by using the control signal, so that an emergent direction of the beam that is in the single polarization state and that is received by the optical element 20 can be changed.

Receiving unit 240:

The receiving unit 240 is configured to receive a reflected beam of a target object.

The reflected beam of the target object is a beam obtained by the target object by reflecting the beam in the single polarization state.

Specifically, after passing through the optical element 230, the beam in the single polarization state is irradiated to a surface of the target object. Due to reflection of the surface of the target object, the reflected beam is generated, and the reflected beam may be received by the receiving unit 240.

The receiving unit 240 may specifically include a receiving lens group 241 and a sensor 242. The receiving lens group 241 is configured to: receive the reflected beam, and converge the reflected beam to the sensor 242.

In this embodiment of this application, when a birefringence of the optical element varies, a beam can be adjusted to different directions. Therefore, a propagation direction of the beam can be adjusted by controlling the birefringence parameter of the optical element, so that the propagation direction of the beam is adjusted through nonmechanical rotation, discrete scanning can be implemented by using the beam, and a surrounding environment and a depth or a distance of the target object can be more flexibly measured.

In other words, in this embodiment of this application, a space angle of the beam in the single polarization state can be changed by controlling the refractive index parameter of the optical element 230, so that the optical element 230 can deflect the propagation direction of the beam in the single polarization state, an emergent beam whose scanning direction and scanning angle meet a requirement is output, discrete scanning can be implemented, flexibility during scanning is high, and an ROI can be quickly located.

Optionally, the control unit 250 is further configured to generate a depth map of the target object based on a TOF corresponding to the beam.

The TOF corresponding to the beam may be specifically time difference information between a moment at which the reflected beam corresponding to the beam is received by the receiving unit and a moment at which the light source emits the beam. The reflected beam corresponding to the beam may be specifically a beam generated after the beam is processed by the polarization filtering device and the optical element, then arrives at the target object, and is reflected by the target object.

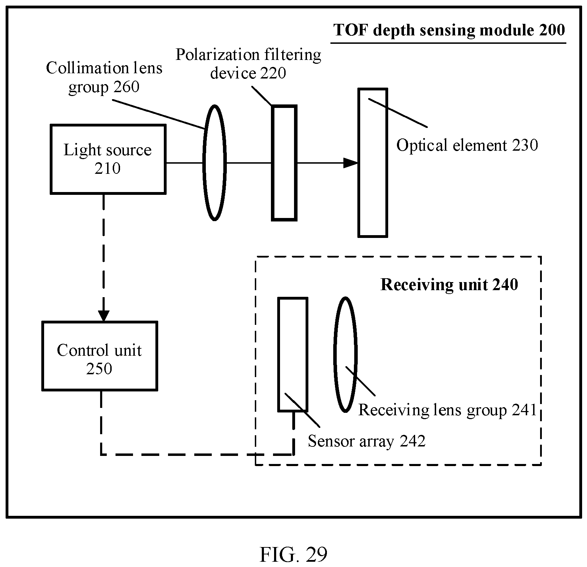

FIG. 29 is a schematic block diagram of a TOF depth sensing module according to an embodiment of this application.

As shown in FIG. 29, the TOF depth sensing module 200 further includes a collimation lens group 260. The collimation lens group 260 is located between the light source 210 and the polarization filtering device 220, and the collimation lens group 260 is configured to perform collimation processing on a beam. The polarization filtering device 220 is configured to filter a beam obtained after the collimation lens group performs collimation processing, to obtain a beam in a single polarization state.

Optionally, a light emitting area of the light source 210 is less than or equal to $5 \times 5$ mm$^2$.

Optionally, a clear aperture of the collimation lens group is less than or equal to 5 mm.

Because sizes of the light source and the collimation lens group are small, the TOF depth sensing module that includes the foregoing devices (the light source and the collimation lens group) is easy to be integrated into a terminal device, so that space occupied in the terminal device can be reduced to an extent.

Optionally, an average output optical power of the TOF depth sensing module 200 is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

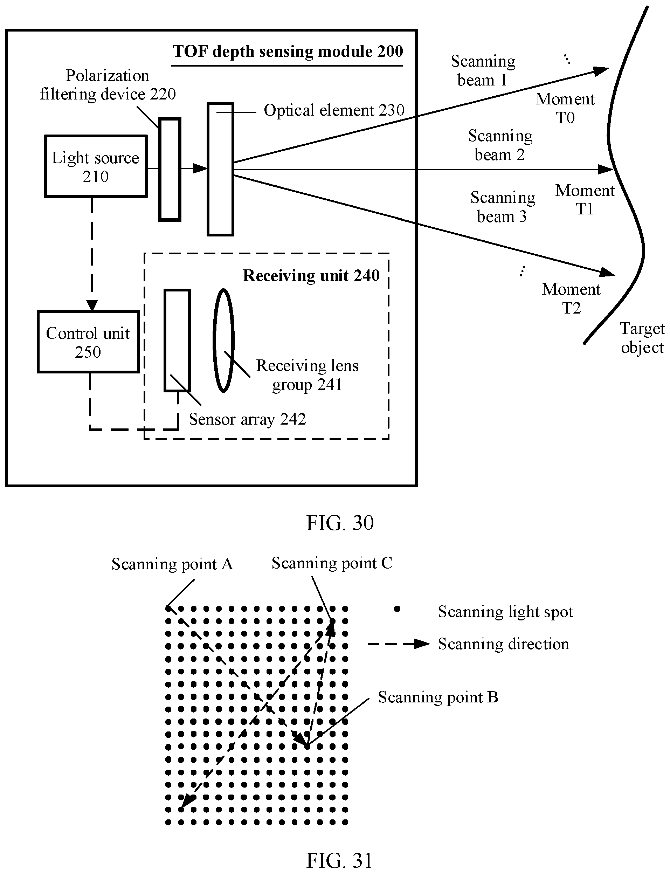

FIG. 30 is a schematic diagram of scanning a target object by a TOF depth sensing module according to an embodiment of this application.

As shown in FIG. 30, the optical element 230 may emit an emergent beam 1 at a moment T0. If a scanning direction and a scanning angle need to be changed at a moment T1, the optical element may be directly controlled to emit an emergent beam 2 at the moment T1. If the scanning direction and the scanning angle further need to be changed at a next moment T2, a control signal may be sent to control the optical element to emit an emergent beam 3 at the moment T2. The TOF depth sensing module 200 can directly output emergent beams in different directions at different moments, to scan the target object.

The following describes in detail an effect of implementing discrete scanning by the TOF depth sensing module 200 with reference to FIG. 31.

FIG. 31 is a schematic diagram of a scanning track of a TOF depth sensing module according to an embodiment of this application.

As shown in FIG. 31, the TOF depth sensing module may start scanning from a scanning point A. When scanning needs to be switched from the scanning point A to a scanning point B, the optical element 230 may be directly controlled by using the control unit 250, so that an emergent beam is directly irradiated to the scanning point B, and there is no need to gradually move from the scanning point A to the scanning point B (there is no need to move from A to B along a dashed line between A and B in the figure). Similarly, when scanning needs to be switched from the scanning point B to a scanning point C, the optical element 230 may also be controlled by using the control unit 250, so that the emergent beam is directly irradiated to the scanning point C, and there is no need to gradually move from the scanning point B to the scanning point C (there is no need to move from B to C along a dashed line between B and C in the figure).

Therefore, the TOF depth sensing module 200 can implement discrete scanning, has high scanning flexibility, and can quickly locate a region that needs to be scanned.

Because the TOF depth sensing module 200 can implement discrete scanning, during scanning, the TOF depth sensing module 200 may scan a region by using a plurality of scanning tracks, so that a scanning manner is more flexibly selected, and it also helps design time sequence control of the TOF depth sensing module 200.

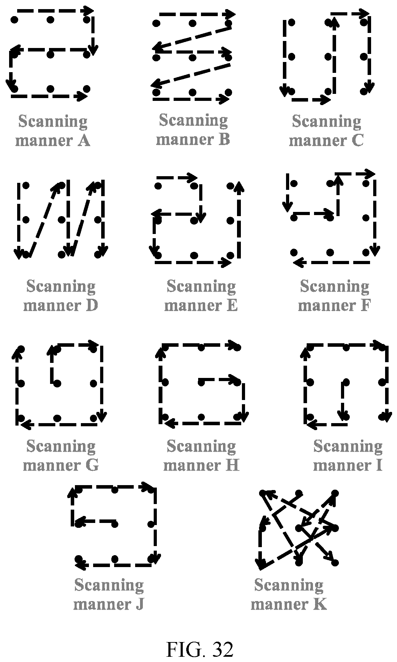

With reference to FIG. 32, the following uses a 3×3 two-dimensional dot matrix as an example to describe the scanning manner of the TOF depth sensing module 200.

FIG. 32 is a schematic diagram of a scanning manner of a TOF depth sensing module according to an embodiment of this application.

As shown in FIG. 32, the TOF depth sensing module 200 may start scanning from a point in the upper left corner of the two-dimensional dot matrix, and ends scanning at a point in the lower right corner of the two-dimensional dot matrix. Such a scanning manner includes a scanning manner A to a scanning manner F. In addition to starting scanning from the point in the upper left corner of the two-dimensional dot matrix, the TOF depth sensing module 200 may further start scanning from a center point of the two-dimensional dot matrix until all points of the two-dimensional dot matrix are scanned, to complete all scanning of the two-dimensional dot matrix. Such a scanning manner includes a scanning manner G to a scanning manner J.

In addition, the TOF depth sensing module 200 may also start scanning from any point of the two-dimensional array until scanning of all points of the two-dimensional array is completed. As shown by a scanning manner K in FIG. 32, scanning may be started from a point in the first row and the second column of the two-dimensional array until a center point of the two-dimensional array is scanned, to complete all scanning of the two-dimensional array dot matrix.

Optionally, the optical element 230 is any one of a liquid crystal polarization grating, an optical phased array, an electro-optic device, and an acousto-optic device.

With reference to the accompanying drawings, the following describes in detail specific composition of the optical element 230 by using different cases.

Case 1: The optical element 230 is a liquid crystal polarization grating (liquid crystal polarization grating, LCPG). In Case 1, a birefringence of the optical element 230 is controllable. When the birefringence of the optical element varies, the optical element can adjust a beam in a single polarization state to different directions.

The liquid crystal polarization grating is a novel grating device based on a geometric phase principle. The liquid crystal polarization grating acts on circularly polarized light, and has electro-optic tunability and polarization tunability.

The liquid crystal polarization grating is a grating formed by using periodic arrangement of liquid crystal molecules, and a production method thereof is generally controlling, by using a photoalignment technology, a director (a long-axis direction of the liquid crystal molecule) of the liquid crystal molecule to linearly and periodically change in one direction. The circularly polarized light can be diffracted to an order +1 or an order -1 by controlling a polarization state of incident light, and a beam can be deflected through switching between an added diffraction order and an order 0.

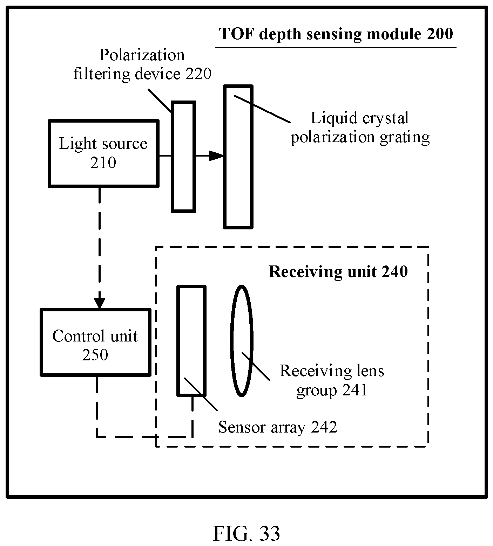

FIG. 33 is a schematic block diagram of a TOF depth sensing module according to an embodiment of this application.

As shown in FIG. 33, the optical element 230 is a liquid crystal polarization grating, and the control unit 250 can control the light source to emit a beam to the liquid crystal polarization grating, and control, by using a control signal, the liquid crystal polarization grating to deflect a direction of the beam, to obtain an emergent beam.

Optionally, the liquid crystal polarization grating includes a horizontal LCPG component and a vertical LCPG component.

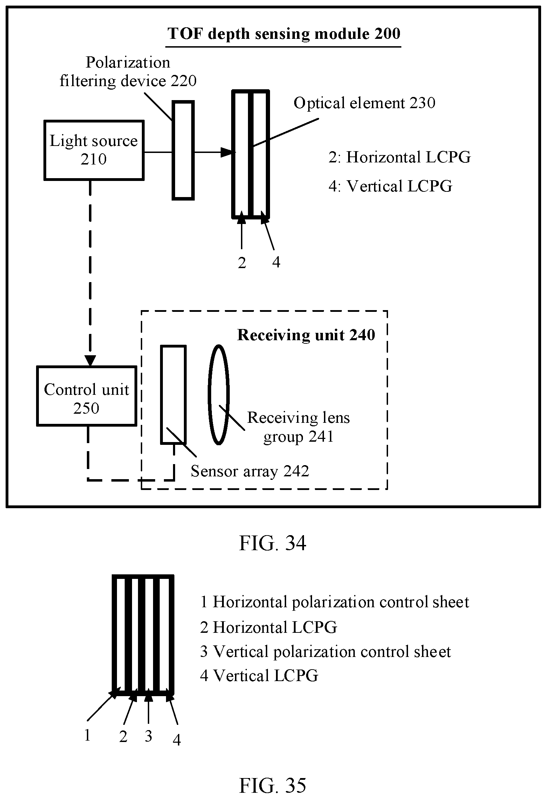

FIG. 34 is a schematic block diagram of a TOF depth sensing module according to an embodiment of this application.

As shown in FIG. 34, the liquid crystal polarization grating includes a horizontal LCPG component and a vertical LCPG component. Discrete random scanning can be implemented in a horizontal direction by using the horizontal LCPG component, and discrete random scanning can be implemented in a vertical direction by using the vertical LCPG component. When the horizontal LCPG component and the vertical LCPG component are combined, two-dimensional discrete random scanning can be implemented in the horizontal direction and the vertical direction.

It should be understood that FIG. 34 shows only a case in which the horizontal LCPG is in the front and the vertical LCPG is in the back (a distance between the horizontal LCPG and the light source is less than a distance between the vertical LCPG and the light source). In practice, in this application, in the liquid crystal polarization grating, the vertical LCPG may be in the front, and the horizontal LCPG is in the back (a distance between the vertical LCPG and the light source is less than a distance between the horizontal LCPG and the light source).

In this application, when the liquid crystal polarization grating includes the horizontal LCPG component and the vertical LCPG component, two-dimensional discrete random scanning can be implemented in the horizontal direction and the vertical direction.

Optionally, in Case 1, the liquid crystal polarization grating may further include a horizontal polarization control sheet and a vertical polarization control sheet.

When the liquid crystal polarization grating includes a polarization control sheet, a polarization state of a beam can be controlled.

FIG. 35 is a schematic diagram of a structure of a liquid crystal polarization grating according to an embodiment of this application.

As shown in FIG. 35, the liquid crystal polarization grating includes a horizontal LCPG and a vertical LCPG, and also includes a horizontal polarization control sheet and a vertical polarization control sheet. In FIG. 35, the horizontal LCPG is located between the horizontal polarization control sheet and the vertical polarization control sheet, and the vertical polarization control sheet is located between the horizontal LCPG and the vertical LCPG.

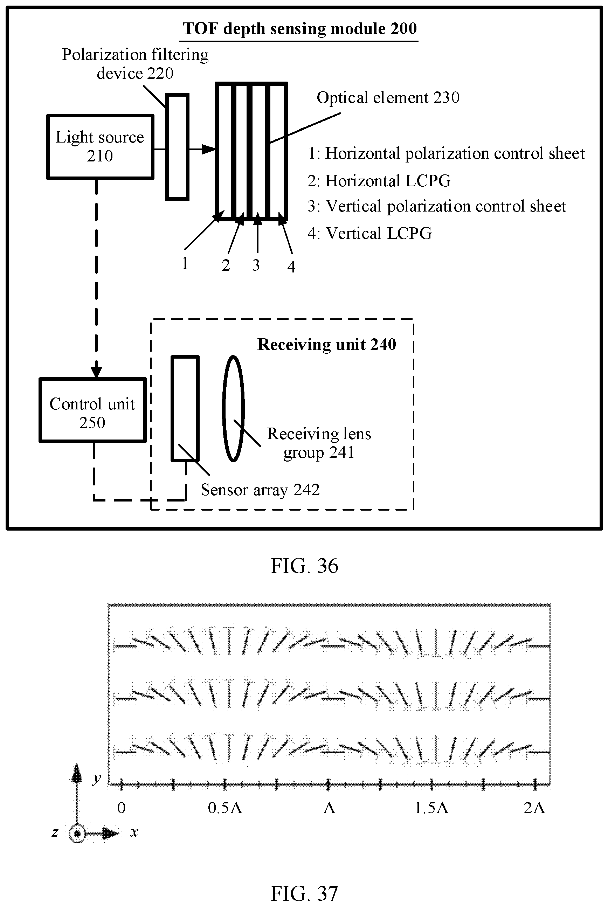

FIG. 36 is a schematic diagram of a structure of a TOF depth sensing module according to an embodiment of this application.

As shown in FIG. 36, a structure of the liquid crystal polarization grating in the TOF depth sensing module is shown in FIG. 35, and distances between the light source and all of the horizontal polarization control sheet, the horizontal LCPG, the vertical polarization control sheet, and the vertical LCPG are successively increased.

Optionally, the components in the liquid crystal polarization grating shown in FIG. 35 may have the following combination manners:

a combination manner 1: 124;
a combination manner 2: 342; and
a combination manner 3: 3412.

In the foregoing combination manner 1, 1 may represent the horizontal polarization control sheet and the vertical polarization control sheet that are tightly attached. In this case, the two tightly attached polarization control sheets are equivalent to one polarization control sheet. Therefore, in the combination manner 1, 1 is used to represent the horizontal polarization control sheet and the vertical polarization control sheet that are tightly attached. Similarly, in the foregoing combination manner 2, 3 may represent the horizontal polarization control sheet and the vertical polarization control sheet that are tightly attached. In this case, the two tightly attached polarization control sheets are equivalent to one polarization control sheet. Therefore, in the combination manner 2, 3 is used to represent the horizontal polarization control sheet and the vertical polarization control sheet that are tightly attached.

When the optical element 230 in the combination manner 1 or the combination manner 2 is placed in the TOF depth sensing module, both the horizontal polarization control sheet and the vertical polarization control sheet are located on a side close to the light source, and both the horizontal LCPG and the vertical LCPG are located on a side far away from the light source.

When the optical element 230 in the combination manner 3 is placed in the TOF depth sensing module, distances between the light source and all of the vertical polarization control sheet, the vertical LCPG, the horizontal polarization control sheet, and the horizontal LCPG are successively increased.

It should be understood that the foregoing three combination manners of the liquid crystal polarization grating and the combination manner in FIG. 35 are merely examples. In practice, the components in the optical element in this application may further have a different combination manner, provided that a distance between the horizontal polarization control sheet and the light source is less than a distance between the horizontal LCPG and the light source, and a distance between the horizontal polarization control sheet and the light source is less than a distance between the horizontal LCPG and the light source.

As shown in FIG. 37, a physical characteristic of the liquid crystal polarization grating may be periodically changed by inputting a periodic control signal (in FIG. 37, a period of the control signal is A) into the liquid crystal polarization grating. Specifically, an arrangement manner of liquid crystal molecules inside the liquid crystal polarization grating may be changed (the liquid crystal molecule is generally in a rod shape, and a direction of the liquid crystal molecule changes due to an impact of the control signal), to deflect a direction of a beam.

When the liquid crystal polarization grating and a polarizer are combined, different directions of a beam can be controlled.

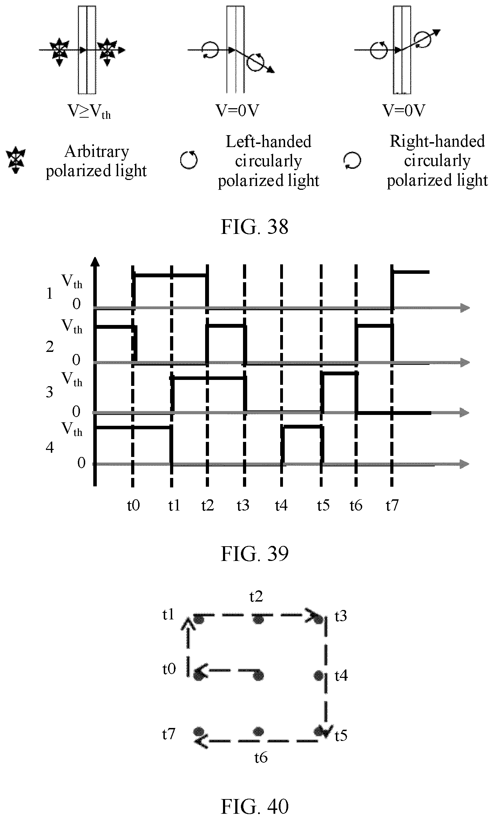

As shown in FIG. 38, incident light may be controlled by using voltages of a left-handed circularly polarizer, a right-handed circularly polarizer, and an LCPG, so that beams in three different directions can be controlled. A deflection angle of emergent light may be determined based on the following diffraction grating equation:

$$\sin \theta_m = (m \frac{\lambda}{\Lambda}) + \sin \theta$$

In the foregoing diffraction grating equation, $\theta_m$ is a direction angle of emergent light in an order m, $\lambda$ is a wavelength of a beam, A is a period of the LCPG, and $\theta$ is an incident angle of the incident light. It may be learned from the foregoing diffraction grating equation that a value of the deflection angle $\theta_m$ depends on a value of the period of the LCPG grating, the wavelength, and a value of the incident angle, and a value of m may be only 0 and $\pm 1$ herein. When the value of m is 0, it indicates that a direction is not deflected and is not changed. When the value of m is 1, it indicates that a direction is separately deflected to the left or counterclockwise relative to an incident direction. When the value of m is -1, it indicates that a direction is separately deflected to the right or clockwise relative to an incident direction (meanings existing when the value of m is +1 and the value of m is -1 may be reversed).

Deflection at three angles can be implemented by using a single LCPG, to obtain emergent beams at three angles. Therefore, emergent beams at more angles can be obtained by cascading a plurality of LCPGs. Therefore, $3^N$ deflection angles may be theoretically implemented by combining N polarization control sheets (the polarization control sheet is configured to control polarization of incident light, to implement conversion between left-handed light and right-handed light) and N LCPGs.

For example, as shown in FIG. 35, the optical element of the TOF depth sensing module includes devices 1, 2, 3, and 4. The devices 1, 2, 3, and 4 respectively represent a horizontal polarization control sheet, a horizontal LCPG, a vertical polarization control sheet, and a vertical LCPG. A deflection direction and an angle of a beam may be controlled by controlling voltages of each group of polarization control sheets and the LCPG.

3x3 point scanning is used as an example. Voltage signals shown in FIG. 39 are respectively applied to the devices 1, 2, 3, and 4 shown in FIG. 36 (1, 2, 3, and 4 in FIG. 39 respectively indicate the voltage signals applied to the devices 1, 2, 3, and 4 shown in FIG. 36), so that a beam emitted by the light source can be controlled to implement a scanning track shown in FIG. 40.

Specifically, it is assumed that incident light is left-handed circularly polarized light, the horizontal LCPG is deflected to the left due to the left-handed incident light, and the vertical LCPG is deflected downward due to the left-handed incident light. The following describes in detail a deflection direction of a beam at each moment.

When high-voltage signals are applied to both ends of the horizontal polarization control sheet, a polarization state of a beam passing through the horizontal polarization control sheet is not changed. When low-voltage signals are applied to both ends of the horizontal polarization control sheet, a polarization state of a beam passing through the horizontal polarization control sheet is changed. Similarly, when high-voltage signals are applied to both ends of the vertical polarization control sheet, a polarization state of a beam passing through the vertical polarization control sheet is not changed. When low-voltage signals are applied to both ends of the vertical polarization control sheet, a polarization state of a beam passing through the vertical polarization control sheet is changed.

At a moment 0, incident light of the device 1 is left-handed circularly polarized light. Because a low voltage is applied to the device 1, right-handed circularly polarized light is emitted after the incident light passes through the device 1. Incident light of the device 2 is right-handed circularly polarized light. Because a high voltage is applied to the device 2, right-handed circularly polarized light is still emitted after the incident light passes through the device 2. Incident light of the device 3 is right-handed circularly polarized light. Because a low voltage is applied to the device 3, left-handed circularly polarized light is emitted after the incident light passes through the device 3. Incident light of the device 4 is left-handed circularly polarized light. Because a high voltage is applied to the device 4, left-handed circularly polarized light is still emitted after the incident light passes through the device 4. Therefore, at the moment 0, after the incident light passes through the device 1 to the device 4, a direction of the incident light is not changed, and a polarization state is not changed. As shown in FIG. 40, a scanning point corresponding to the moment 0 is a location shown by the center t0 in FIG. 40.

At a moment t0, incident light of the device 1 is left-handed circularly polarized light. Because a high voltage is applied to the device 1, left-handed circularly polarized light is still emitted after the incident light passes through the device 1. Incident light of the device 2 is left-handed circularly polarized light. Because a low voltage is applied to the device 2, right-handed circularly polarized light deflected to the left is emitted after the incident light passes through the device 2. Incident light of the device 3 is right-handed circularly polarized light deflected to the left. Because a low voltage is applied to the device 3, left-handed circularly polarized light deflected to the left is emitted after the incident passes through the device 3. Incident light of the device 4 is left-handed circularly polarized light deflected to the left. Because a high voltage is applied to the device 4, left-handed circularly polarized light deflected to the left is still emitted after the incident light passes through the device 4. In other words, relative to the moment 0, a beam emitted by the device 4 at the moment t0 is deflected to the left, and a corresponding scanning point in FIG. 40 is a location shown by t0.

At a moment t1, incident light of the device 1 is left-handed circularly polarized light. Because a high voltage is applied to the device 1, left-handed circularly polarized light is still emitted after the incident light passes through the device 1. Incident light of the device 2 is left-handed circularly polarized light. Because a low voltage is applied to the device 2, right-handed circularly polarized light deflected to the left is emitted after the incident light passes through the device 2. Incident light of the device 3 is right-handed circularly polarized light deflected to the left. Because a high voltage is applied to the device 3, right-handed circularly polarized light deflected to the left is emitted after the incident light passes through the device 3. Incident light of the device 4 is right-handed circularly polarized light deflected to the left. Because a low voltage is applied to the device 4, left-handed circularly polarized light deflected to the left and deflected upward is emitted after the incident light passes through the device 4. In other words, relative to the moment 0, a beam emitted by the device 4 at the moment t1 is deflected to the left and deflected upward, and a corresponding scanning point in FIG. 40 is a location shown by t1.

At a moment t2, incident light of the device 1 is left-handed circularly polarized light. Because a low voltage is applied to the device 1, right-handed circularly polarized light is emitted after the incident light passes through the device 1. Incident light of the device 2 is right-handed circularly polarized light. Because a high voltage is applied to the device 2, right-handed circularly polarized light is still emitted after the incident light passes through the device 2. Incident light of the device 3 is right-handed circularly polarized light. Because a high voltage is applied to the device 3, right-handed circularly polarized light is still emitted after the incident light passes through the device 3. Incident light of the device 4 is right-handed circularly polarized light. Because a low voltage is applied to the device 4, left-handed circularly polarized light deflected upward is emitted after the incident light passes through the device 4. In other words, relative to the moment 0, a beam emitted by the device 4 at the moment t2 is deflected upward, and a corresponding scanning point in FIG. 40 is a location shown by t2.

At a moment t3, incident light of the device 1 is left-handed circularly polarized light. Because a low voltage is applied to the device 1, right-handed circularly polarized light is emitted after the incident light passes through the device 1. Incident light of the device 2 is right-handed circularly polarized light. Because a low voltage is applied to the device 2, right-handed circularly polarized light deflected to the right is emitted after the incident light passes through the device 2. Incident light of the device 3 is right-handed circularly polarized light deflected to the right. Because a low voltage is applied to the device 3, left-handed circularly polarized light deflected to the right is emitted after the incident light passes through the device 3. Incident light of the device 4 is left-handed circularly polarized light deflected to the right. Because a low voltage is applied to the device 4, left-handed circularly polarized light deflected to the right and deflected upward is emitted after the incident light passes through the device 4. In other words, relative to the moment 0, a beam emitted by the device 4 at the moment t3 is deflected to the right and deflected upward, and a corresponding scanning point in FIG. 40 is a location shown by t3.

At a moment t4, incident light of the device 1 is left-handed circularly polarized light. Because a low voltage is applied to the device 1, right-handed circularly polarized light is emitted after the incident light passes through the device 1. Incident light of the device 2 is right-handed circularly polarized light. Because a low voltage is applied to the device 2, left-handed circularly polarized light deflected to the right is emitted after the incident light passes through the device 2. Incident light of the device 3 is left-handed circularly polarized light deflected to the right. Because a low voltage is applied to the device 3, right-handed circularly polarized light deflected to the right is emitted after the incident light passes through the device 3. Incident light of the device 4 is right-handed circularly polarized light deflected to the right. Because a high voltage is applied to the device 4, right-handed circularly polarized light deflected to the right is still emitted after the incident light passes through the device 4. In other words, relative to the moment 0, a beam emitted by the device 4 at the moment t0 is deflected to the right, and a corresponding scanning point in FIG. 40 is a location shown by t4.

At a moment t5, incident light of the device 1 is left-handed circularly polarized light. Because a low voltage is applied to the device 1, right-handed circularly polarized light is emitted after the incident light passes through the device 1. Incident light of the device 2 is right-handed circularly polarized light. Because a low voltage is applied to the device 2, right-handed circularly polarized light deflected to the right is emitted after the incident light passes through the device 2. Incident light of the device 3 is right-handed circularly polarized light deflected to the right. Because a high voltage is applied to the device 3, right-handed circularly polarized light deflected to the right is still emitted after the incident light passes through the device 3. Incident light of the device 4 is right-handed circularly polarized light deflected to the right. Because a low voltage is applied to the device 4, left-handed circularly polarized light deflected to the right and deflected downward is emitted after the incident light passes through the device 4. In other words, relative to the moment 0, a beam emitted by the device 4 at the moment t5 is deflected to the right and deflected downward, and a corresponding scanning point in FIG. 40 is a location shown by t5.

At a moment t6, incident light of the device 1 is left-handed circularly polarized light. Because a low voltage is applied to the device 1, right-handed circularly polarized light is emitted after the incident light passes through the device 1. Incident light of the device 2 is right-handed circularly polarized light. Because a high voltage is applied to the device 2, right-handed circularly polarized light is still emitted after the incident light passes through the device 2. Incident light of the device 3 is right-handed circularly polarized light. Because a low voltage is applied to the device 3, left-handed circularly polarized light is emitted after the incident light passes through the device 3. Incident light of the device 4 is left-handed circularly polarized light. Because a low voltage is applied to the device 4, right-handed circularly polarized light deflected downward is emitted after the incident light passes through the device 4. In other words, relative to the moment 0, a beam emitted by the device 4 at the moment t6 is deflected downward, and a corresponding scanning point in FIG. 40 is a location shown by t6.

At a moment t7, incident light of the device 1 is left-handed circularly polarized light. Because a high voltage is applied to the device 1, left-handed circularly polarized light is still emitted after the incident light passes through the device 1. Incident light of the device 2 is left-handed circularly polarized light. Because a low voltage is applied to the device 2, right-handed circularly polarized light deflected to the left is emitted after the incident light passes through the device 2. Incident light of the device 3 is right-handed circularly polarized light deflected to the left. Because a low voltage is applied to the device 3, left-handed circularly polarized light deflected to the left is emitted after the incident light passes through the device 3. Incident light of the device 4 is left-handed circularly polarized light deflected to the left. Because a low voltage is applied to the device 4, right-handed circularly polarized light deflected to the left and deflected downward is emitted after the incident light passes through the device 4. In other words, relative to the moment 0, a beam emitted by the device 4 at the moment t7 is deflected to the left and deflected upward, and a corresponding scanning point in FIG. 40 is a location shown by t7.

It should be understood that, a possible scanning track of the TOF depth sensing module is described herein only with reference to FIG. 39 and FIG. 40, and any discrete random scanning may be implemented by changing and controlling voltages of each group of polarization control sheets and the LCPG.

For example, various scanning tracks shown in FIG. 32 may be implemented by changing and controlling voltages of each group of polarization control sheets and the LCPG.

When the target object is scanned by using a conventional laser radar, a coarse scan (Coarse scan) usually needs to be performed on the target region, and then a fine scan (Fine scan) corresponding to higher resolution is performed after a region of interest (ROI) is found. However, the TOF depth sensing module in this embodiment of this application can implement discrete scanning. Therefore, the region of interest can be directly located to perform a fine scan, so that time required for the fine scan can be greatly reduced.

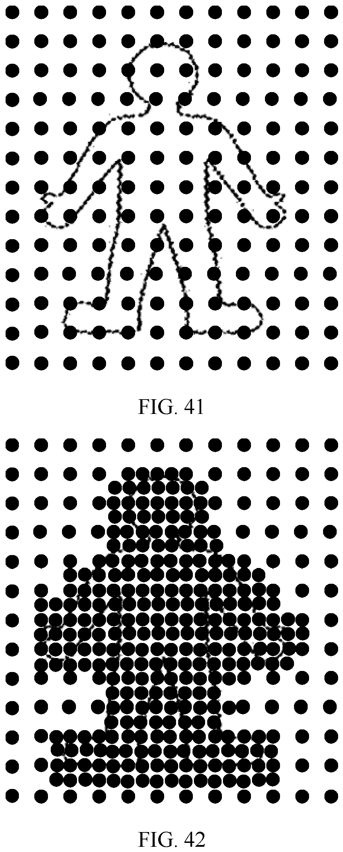

For example, as shown in FIG. 41, a total quantity of points of a to-be-scanned region (an entire rectangular region including a body contour) is M, and an ROI (an image region in the body contour image in FIG. 41) accounts for 1/N of a total area of the to-be-scanned region.

When the to-be-scanned region shown in FIG. 41 is scanned, it is assumed that point scanning speeds of both the conventional laser radar and a laser scanning radar in this embodiments of this application are K points per second, a fine scan needs to be performed when the ROI region is scanned, and resolution existing during the fine scan needs to be increased to four times of the original value (namely, 4K points per second). Therefore, a time required for completing a fine scan on the ROI by using the TOF depth sensing module in this embodiment of this application is $t_1$, and a time required for completing a fine scan on the ROI by using the conventional laser radar is $t_2$. Because the TOF depth sensing module in this embodiment of this application can implement discrete scanning, the ROI can be directly located and a fine scan can be performed on the ROI, and a required scanning time is short. However, the conventional laser radar performs linear scanning, and it is difficult to accurately locate the ROI. As a result, the conventional laser radar needs to perform a fine scan on the entire to-be-scanned region, and a scanning time is greatly increased. As shown in FIG. 42, the TOF depth sensing module in this embodiment of this application can directly locate the ROI and perform a fine scan on the ROI (it may be learned from FIG. 42 that a density of scanning points in the ROI is significantly greater than a density of scanning points outside the ROI).

In addition, $t_1$ and $t_2$ may be respectively calculated according to the following Formula (2) and Formula (3):

$$t_1 = \frac{4 \times M}{N \cdot K} \tag{2}$$

$$t_2 = \frac{4 \times M}{K} \qquad\qquad (3)$$

It may be learned from the foregoing Formula (2) and Formula (3) that the time required for performing a fine scan on the ROI by using the TOF depth sensing module in this embodiment of this application is only 1/N of the time required for performing a fine scan by using the conventional laser radar. This greatly shortens a time required for performing a fine scan on the ROI.

Because the TOF depth sensing module in this embodiment of this application can implement discrete scanning, the TOF depth sensing module in this embodiment of this application can implement a fine scan on an ROI region (a vehicle, a person, a building, and a random block) in any shape, especially some asymmetric regions and discrete ROI blocks. In addition, the TOF depth sensing module in this embodiment of this application can also implement uniform distribution or non-uniform distribution of points in a scanning region.

Case 2: The optical element 230 is an electro-optic device.

In Case 2, when the optical element 230 is an electro-optic device, the control signal may be a voltage signal, and the voltage signal may be used to change a refractive index of the electro-optic device. Therefore, when a location of the electro-optic device relative to the light source is not changed, a beam is deflected in different directions, to obtain an emergent beam whose scanning direction matches the control signal.

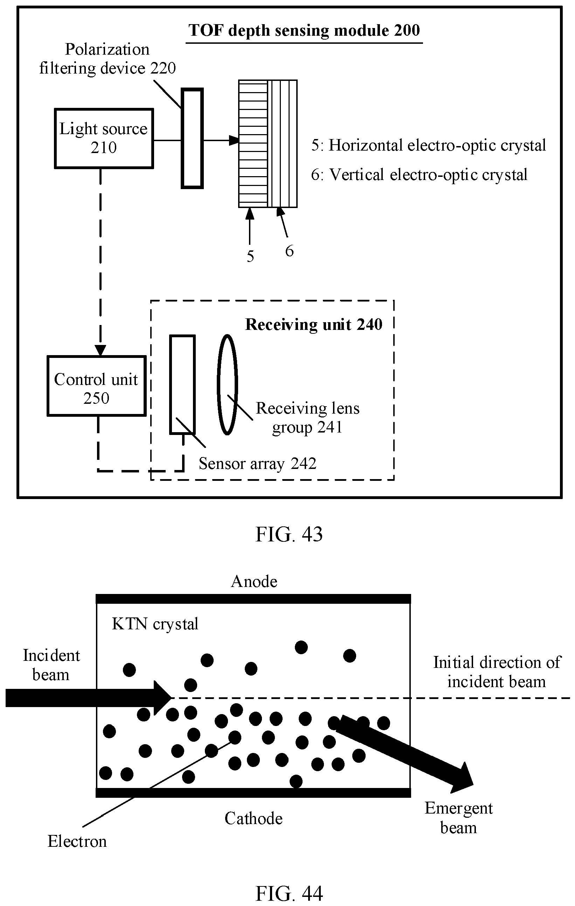

Optionally, as shown in FIG. 43, the foregoing electro-optic device may include a horizontal electro-optic crystal (a horizontally deflected electro-optic crystal) and a vertical electro-optic crystal (a vertically deflected electro-optic crystal). The horizontal electro-optic crystal can deflect a beam in a horizontal direction, and the vertical electro-optic crystal can deflect a beam in a vertical direction.

Optionally, the electro-optic crystal may be specifically any one of a potassium tantalate niobate (potassium tantalate niobate, KTN) crystal, a deuterated potassium dihydrogen phosphate (deuterated potassium dihydrogen phosphate, DKDP) crystal, and a lithium niobate (lithium niobate, LN) crystal.

The following briefly describes a working principle of the electro-optic crystal with reference to the accompanying drawings.

As shown in FIG. 44, when a voltage signal is applied to the electro-optic crystal, a refractive index difference (that is, refractive indexes of different regions in the electro-optic crystal are different) is generated in the electro-optic crystal due to a second-order photoelectric effect of the electro-optic crystal, so that an incident beam is deflected. As shown in FIG. 44, an emergent beam is deflected relative to a direction of the incident beam.

A deflection angle of the emergent beam relative to the incident beam may be calculated according to the following Formula (4):

$$\theta_{max} = -\frac{1}{2} n^3 E_{max}^2 L \frac{dg_{11y}}{dy} \qquad\qquad (4)$$

In the foregoing Formula (4), $\theta_{max}$ represents a maximum deflection angle of the emergent beam relative to the incident beam, n is a refractive index of the electro-optic crystal, $g_{11y}$ is a second-order electro-optic coefficient, $E_{max}$ represents maximum electric field strength that can be applied to the electro-optic crystal, and $\frac{dg_{11y}}{dy}$ is a second-order electro-optic coefficient gradient in a direction y.

It may be learned from the foregoing Formula (4) that a deflection angle of a beam may be controlled by adjusting applied electric field strength (that is, adjusting a voltage applied to the electro-optic crystal), to scan the target region. In addition, to implement a larger deflection angle, a plurality of electro-optical crystals may be cascaded.

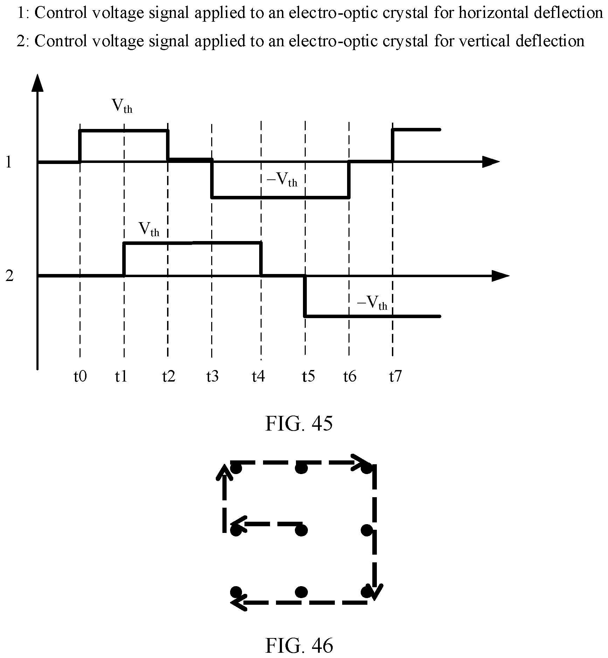

As shown in FIG. 43, the optical element includes a horizontally deflected electro-optic crystal and a vertically deflected electro-optic crystal. The two electro-optic crystals are respectively responsible for deflecting a beam in a horizontal direction and a vertical direction. After control voltage signals shown in FIG. 45 are applied, 3x3 scanning shown in FIG. 46 can be implemented. Specifically, in FIG. 45, 1 and 2 respectively represent the control voltage signals applied to the horizontally deflected electro-optic crystal and the vertically deflected electro-optic crystal.

Case 3: The optical element 230 is an acousto-optic device.

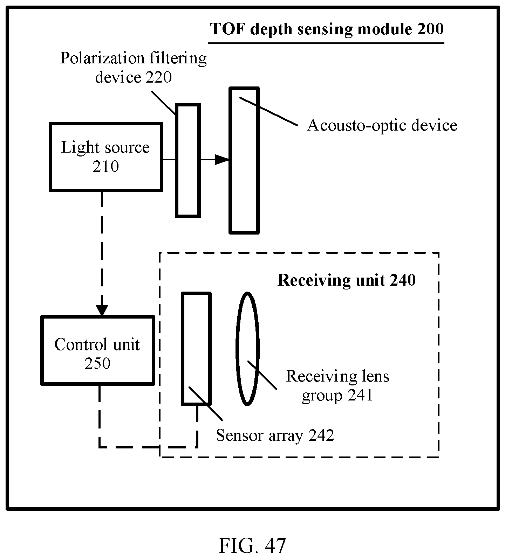

As shown in FIG. 47, the optical element 230 is an acousto-optic device. The acousto-optic device may include a transducer. When the optical element 230 is an acousto-optic device, the control signal may be specifically a radio frequency control signal, and the radio frequency control signal may be used to control the transducer to generate sound waves having different frequencies, to change a refractive index of the acousto-optic device. Therefore, when a location of the acousto-optic device relative to the light source is not changed, a beam is deflected in different directions, to obtain an emergent beam whose scanning direction matches the control signal.

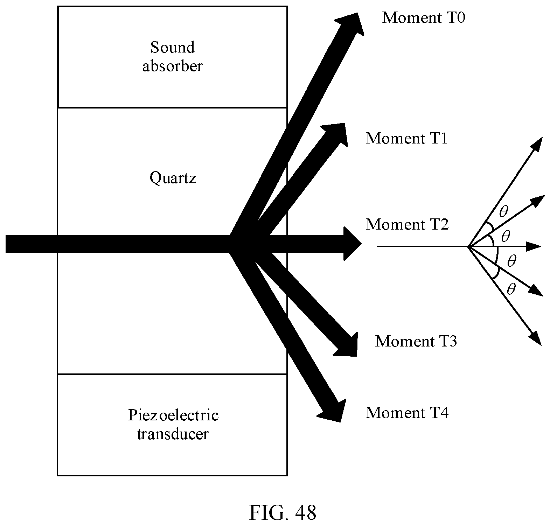

As shown in FIG. 48, the acousto-optic device includes a sound absorber, quartz, and a piezoelectric transducer. After the acousto-optic device receives an electrical signal, the piezoelectric transducer can generate a sound wave signal under an action of the electrical signal. When the sound wave signal is transmitted in the acousto-optic device, refractive index distribution of the quartz is changed, to form a grating, so that the quartz can deflect an incident beam at an angle. When control signals input at different moments are different, the acousto-optic device can generate emergent beams in different directions at different moments. As shown in FIG. 48, deflection directions of emergent beams of the quartz at different moments (T0, T1, T2, T3, and T4) may be different.

When a signal that is incident into the acousto-optic device is a periodic signal, because refractive index distribution of the quartz in the acousto-optic device periodically changes, a periodic grating is formed, and an incident beam can be periodically deflected by using the periodic grating.

In addition, intensity of emergent light of the acousto-optic device is directly related to a power of a radio frequency control signal input into the acousto-optic device, and a diffraction angle of the incident beam is also directly related to a frequency of the radio frequency control signal. An angle of the emergent beam may also be adjusted accordingly by changing the frequency of the radio frequency control signal. Specifically, a deflection angle of the emergent beam relative to the incident beam may be determined according to the following Formula (5):

$$\theta = \arcsin\frac{\lambda}{v_s}f_s \tag{5}$$

In the foregoing Formula (5), $\theta$ is the deflection angle of the emergent beam relative to the incident beam, $\lambda$ is a wavelength of the incident beam, $f_s$ is the frequency of the radio frequency control signal, and $v_s$ is a speed of a sound wave. Therefore, an optical deflector can enable a beam to perform scanning in a large angle range, and can accurately control an emergent angle of the beam.

Case 4: The optical element 230 is an optical phased array (opitcal phase array, OPA) device.

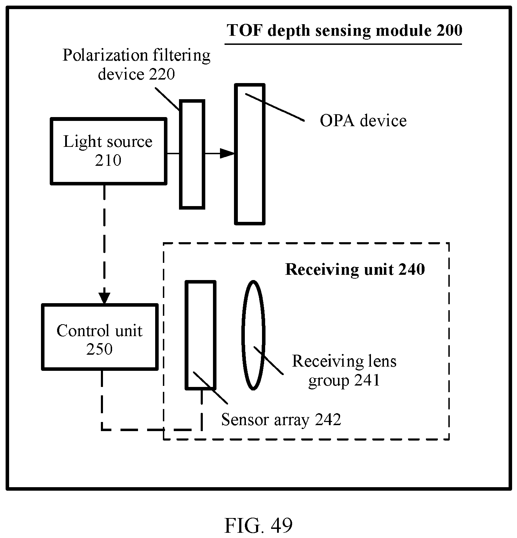

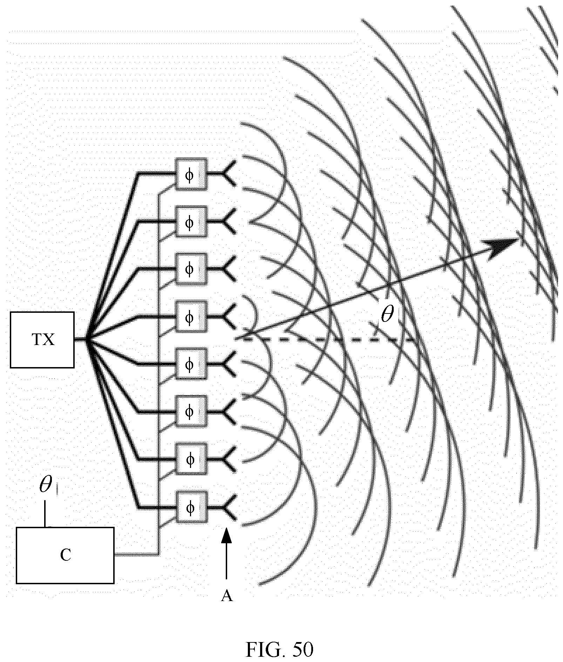

With reference to FIG. 49 and FIG. 50, the following describes in detail a case in which the optical element 230 is an OPA device.

As shown in FIG. 49, the optical element 230 is an OPA device, and an incident beam can be deflected by using the OPA device, to obtain an emergent beam whose scanning direction matches the control signal.

The OPA device generally includes a one-dimensional or two-dimensional phase shifter array. When there is no phase difference between phase shifters, light arrives at an equiphase surface at a same time, and light propagates forward without interference, so that beam deflection does not occur.

However, after the phase difference is added to the phase shifters (for example, a uniform phase difference is allocated to each optical signal, and a phase difference between the second waveguide and the first waveguide is $\Delta$, a phase difference between the third waveguide and the first waveguide is $2\Delta$, and by analogy), the equiphase surface is not perpendicular to a waveguide direction, but is deflected to an extent. Beams that meet an equiphase relationship are coherent and constructive, and beams that do not meet an equiphase condition are destructive. Therefore, a direction of a beam is always perpendicular to the equiphase surface.

As shown in FIG. 50, it is assumed that a distance between adjacent waveguides is d. In this case, a difference between optical paths that are taken after beams output by the adjacent waveguides arrive at the equiphase surface is $\Delta R=d\cdot\sin\theta$, where $\theta$ represents a deflection angle of a beam. Because the difference between optical paths is caused by a phase difference between array elements, $\Delta R=\Delta\cdot\lambda/2\pi$. Therefore, the beam can be deflected by introducing the phase difference into the array elements. This a beam deflection principle of the OPA.

Therefore, the deflection angle $\theta=\arcsin(\Delta\cdot\lambda/(2\pi^*d))$. A phase difference between adjacent phase shifters is controlled, for example, $\pi/12$ or $\pi/6$, so that the deflection angle of the beam is $\arcsin(\lambda/(24d))$ and $\arcsin(\lambda/(12d))$. In this way, deflection in any two-dimensional direction can be implemented by controlling a phase of the phase shifter array. The phase shifter may be made of a liquid crystal material, and different phase differences are generated between liquid crystals by applying different voltages.

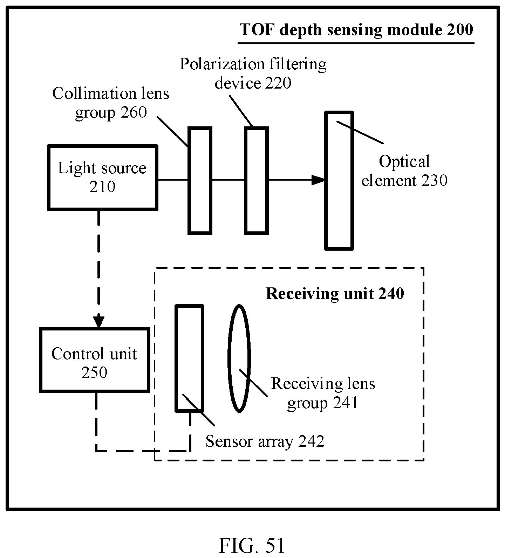

Optionally, as shown in FIG. 51, the TOF depth sensing module 200 further includes:

a collimation lens group 260, where the collimation lens group 260 is located between the light source 210 and the polarization filtering device 220, the collimation lens group 260 is configured to perform collimation processing on a beam, and the polarization filtering device 220 is configured to filter a beam obtained after the collimation lens group 260 performs processing, to obtain a beam in a single polarization state.

In addition, the collimation lens group 260 may be located between the polarization filtering device 220 and the optical element 230. In this case, the polarization filtering device 220 first performs polarization filtering on a beam generated by the light source, to obtain a beam in a single polarization state. Then, the collimation lens group 260 performs collimation processing on the beam in the single polarization state.

Optionally, the collimation lens group 260 may be located at the right of the optical element 230 (a distance between the collimation lens group 260 and the light source 210 is greater than a distance between the optical element 230 and the light source 210). In this case, after the optical element 230 adjusts a direction of a beam in a single polarization state, the collimation lens group 260 performs collimation processing on the beam that is in the single polarization state and whose direction is adjusted.

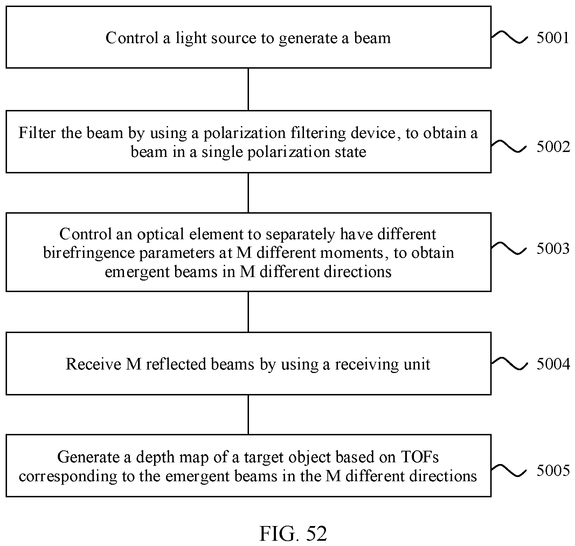

The foregoing describes in detail the TOF depth sensing module 200 in the embodiments of this application with reference to FIG. 26 to FIG. 51. The following describes an image generation method in the embodiments of this application with reference to FIG. 52.

FIG. 52 is a schematic flowchart of an image generation method according to an embodiment of this application.

The method shown in FIG. 52 may be performed by the TOF depth sensing module shown in the embodiments of this application or a terminal device including the TOF depth sensing module in the embodiments of this application. Specifically, the method shown in FIG. 52 may be performed by the TOF depth sensing module 200 shown in FIG. 27 or a terminal device including the TOF depth sensing module 200 shown in FIG. 27. The method shown in FIG. 52 includes step 4001 to step 4005. The following separately describes the steps in detail.

5001. Control a light source to generate a beam.

The light source can generate light in a plurality of polarization states.

For example, the light source may generate light in a plurality of polarization states such as linear polarization, left-handed circular polarization, and right-handed circular polarization.

5002. Filter the beam by using a polarization filtering device, to obtain a beam in a single polarization state.

The single polarization state may be any one of linear polarization, left-handed circular polarization, and right-handed circular polarization.

For example, in step 5001, the beam generated by the light source includes linearly polarized light, left-handed circularly polarized light, and right-handed circularly polarized light. In this case, in step 5002, the left-handed circularly polarized light and the right-handed circularly polarized light in the beam may be screened out, and only the linearly polarized light in a specified direction is reserved. Optionally, the polarization filtering device may further include a quarter-wave plate, so that the linearly polarized light obtained through screening is converted into left-handed circularly polarized light (or right-handed circularly polarized light).

5003. Control an optical element to separately have different birefringence parameters at M different moments, to obtain emergent beams in M different directions.

A birefringence parameter of the optical element is controllable. When the birefringence of the optical element varies, the optical element can adjust the beam in the single polarization state to different directions. M is a positive integer greater than 1. The foregoing M reflected beams are beams obtained by a target object by reflecting the emergent beams in the M different directions.

In this case, the optical element may be a liquid crystal polarization grating. For a specific case of the liquid crystal polarization grating, refer to descriptions of the foregoing Case 1.

Optionally, that the optical element separately has different birefringence parameters at the M moments may specifically include the following two cases:

Case 1: Birefringence parameters of the optical element at any two moments in the M moments are different.

Case 2: There are at least two moments in the M moments of the optical element, and birefringence parameters of the optical element at the at least two moments are different.

In Case 1, it is assumed that M=5. In this case, the optical element respectively corresponds to five different birefringence parameters at five moments.

In Case 2, it is assumed that M=5. In this case, the optical element corresponds to different birefringence parameters only at two moments in five moments.

5004. Receive the M reflected beams by using a receiving unit.

5005. Generate a depth map of the target object based on TOFs corresponding to the emergent beams in the M different directions.

The TOFs corresponding to the emergent beams in the M different directions may be specifically time difference information between moments at which the reflected beams corresponding to the emergent beams in the M different directions are received by the receiving unit and emergent moments of the emergent beams in the M different directions.

It is assumed that the emergent beams in the M different directions include an emergent beam 1. In this case, a reflected beam corresponding to the emergent beam 1 may be a beam generated after the emergent beam 1 arrives at the target object and is reflected by the target object.

In this embodiment of this application, when the birefringence of the optical element varies, a beam can be adjusted to different directions. Therefore, a propagation direction of the beam can be adjusted by controlling the birefringence parameter of the optical element, so that the propagation direction of the beam is adjusted through nonmechanical rotation, beam discrete scanning can be implemented, and a surrounding environment and a depth or a distance of the target object can be more flexibly measured.

Optionally, the foregoing step 5005 of generating a depth map of the target object specifically includes:

5005a. Determine distances between M regions of the target object and the TOF depth sensing module based on the TOFs corresponding to the emergent beams in the M different directions.

5005b. Generate depth maps of the M regions of the target object based on distances between the M regions of the target object and the TOF depth sensing module, and synthesize the depth map of the target object based on the depth maps of the M regions of the target object.

In the method shown in FIG. 52, collimation processing may be further performed on the beam.

Optionally, before step 5002, the method shown in FIG. 52 further includes:

5006. Perform collimation processing on the beam to obtain a beam obtained after collimation processing is performed.

After collimation processing is performed on the beam, the foregoing step 5002 of obtaining a beam in a single polarization state specifically includes: filtering, by using the polarization filtering device, the beam obtained after collimation processing is performed, to obtain light in the single polarization state.

Before the beam is filtered by using the polarization filtering device, to obtain the beam in the single polarization state, an approximately parallel beam can be obtained by performing collimation processing on the beam, so that a power density of the beam can be improved, and an effect of subsequently performing scanning by using the beam can be improved.

The beam obtained after collimation processing is performed may be quasi-parallel light whose divergence angle is less than 1 degree.

It should be understood that, in the method shown in FIG. 52, collimation processing may be performed on the beam in the single polarization state. Specifically, the method shown in FIG. 52 further includes:

5007. Perform collimation processing on the beam in the single polarization state, to obtain a beam obtained after collimation processing is performed.

Step 5007 may be located between step 5002 and step 5003, or step 5007 may be located between step 5003 and step 5004.

When step 5007 is located between step 5002 and step 5003, after the beam generated by the light source is filtered by using the polarization filtering device, the beam in the single polarization state is obtained. Next, collimation processing is performed on the beam in the single polarization state by using a collimation lens group, to obtain the beam obtained after collimation processing is performed. Then, a propagation direction of the beam in the single polarization state is controlled by using the optical element.

When step 5007 is located between step 5003 and step 5004, after the optical element changes a propagation direction of the beam in the single polarization state, collimation processing is performed on the beam in the single polarization state by using a collimation lens group, to obtain the beam obtained after collimation processing is performed.

It should be understood that, in the method shown in FIG. 52, step 5006 and step 5007 are optional steps, and either step 5006 or step 5007 may be performed.

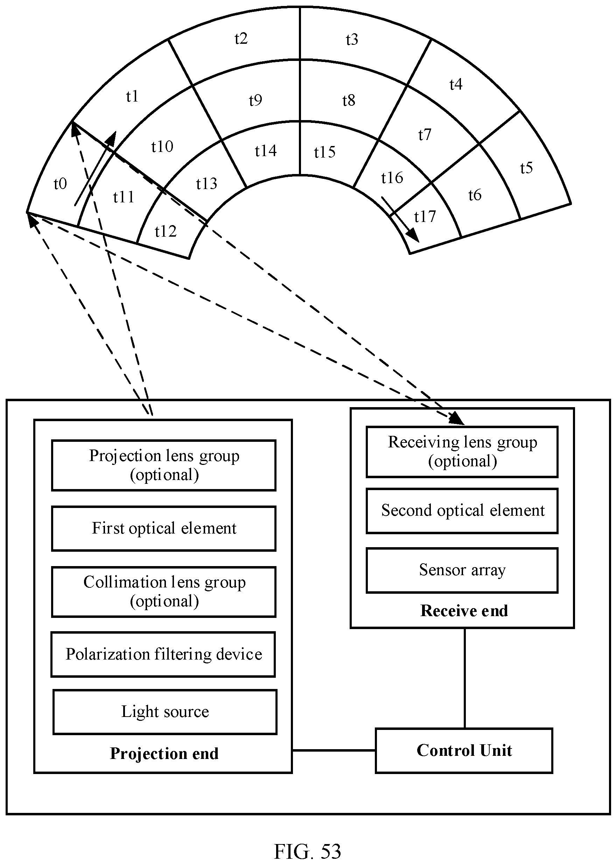

The foregoing describes in detail a TOF depth sensing module and an image generation method in the embodiments of this application with reference to FIG. 26 to FIG. 52. The following describes in detail another TOF depth sensing module and another image generation method in the embodiments of this application with reference to FIG. 53 to FIG. 69.

A conventional TOF depth sensing module generally performs scanning by using a pulse-type TOF technology. However, in the pulse-type TOF technology, a photoelectric detector is required to have sufficiently high sensitivity, to implement a single-photon detection capability. A single-photon avalanche diode (SPAD) is generally used for a frequently-used photoelectric detector. Due to a complex interface and processing circuit of the SPAD, resolution of a frequently-used SPAD sensor is low, and is insufficient to meet a requirement of high spatial resolution of depth sensing. Therefore, the embodiments of this application provide a TOF depth sensing module and an image generation method, to improve spatial resolution of depth sensing through block lighting and time division multiplexing. The following describes in detail this type of TOF depth sensing module and image generation method with reference to the accompanying drawings.

The following first briefly describes the TOF depth sensing module in the embodiments of this application with reference to FIG. 53.

FIG. 53 is a schematic diagram of performing distance measurement by using a TOF depth sensing module according to an embodiment of this application.

As shown in FIG. 53, the TOF depth sensing module may include a transmit end (or may be referred to as a projection end), a receive end, and a control unit. The transmit end is configured to emit an emergent beam. The receive end is configured to receive a reflected beam (the reflected beam is a beam obtained by a target object by reflecting the emergent beam) of the target object. The control unit may control the transmit end and the receive end to respectively emit and receive a beam.

In FIG. 53, the transmit end may generally include a light source, a polarization filtering device, a collimation lens group (optional), a first optical element, and a projection lens group (optional), and the receive end may generally include a receiving lens group, a second optical element, and a sensor. In FIG. 53, a TOF corresponding to the emergent beam may be recorded by using a timing apparatus, to calculate a distance between the TOF depth sensing module and a target region, and obtain a final depth map of the target object. The TOF corresponding to the emergent beam may be time difference information between a moment at which the reflected beam is received by the receiving unit and an emergent moment of the emergent beam.

As shown in FIG. 53, an FOV of a beam can be adjusted by using a beam shaping device and the first optical element, so that different scanning beams can be emitted at moments t0 to t17. A target FOV can be obtained by splicing FOVs of the beams emitted at the moments t0 to t17, so that resolution of the TOF depth sensing module can be improved.

The TOF depth sensing module in this embodiment of this application may be configured to obtain a 3D image. The TOF depth sensing module in this embodiment of this application may be disposed in an intelligent terminal (for example, a mobile phone, a tablet, and a wearable device), is configured to obtain a depth image or a 3D image, and may also provide gesture and body recognition for 3D games or motion sensing games.

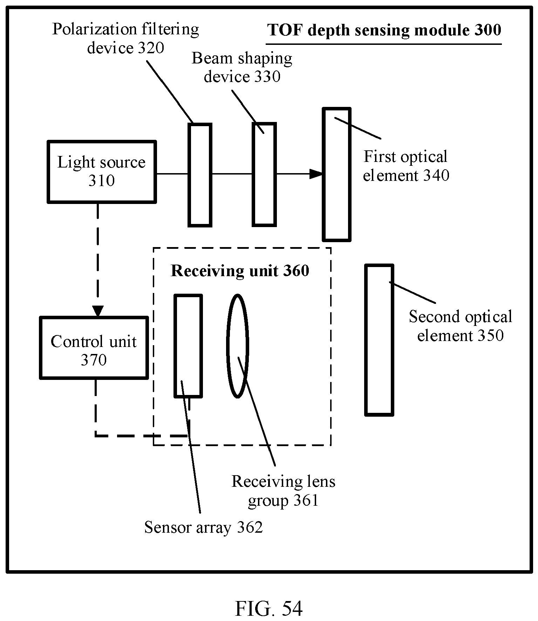

The following describes in detail the TOF depth sensing module in the embodiments of this application with reference to FIG. 54.

FIG. 54 is a schematic block diagram of a TOF depth sensing module according to an embodiment of this application.

A TOF depth sensing module 300 shown in FIG. 54 includes a light source 310, a polarization filtering device 320, a beam shaping device 330, a first optical element 340, a second optical element 350, a receiving unit 360, and a control unit 370. As shown in FIG. 54, a transmit end of the TOF depth sensing module 300 includes the light source 310, the polarization filtering device 320, the beam shaping device 330, and the first optical element 340. A receive end of the TOF depth sensing module 300 includes the second optical element 350 and the receiving unit 360. The first optical element 340 and the second optical element 350 are elements respectively located at the transmit end and the receive end of the TOF depth sensing module 300. The first optical element mainly controls a direction of a beam of the transmit end to obtain an emergent beam, and the second optical element mainly controls a direction of a reflected beam, so that the reflected beam is deflected to the receiving unit.

The following describes in detail the modules or units in the TOF depth sensing module 300.

Light source 310:

The light source 310 is configured to generate a beam. Specifically, the light source 310 can generate light in a plurality of polarization states.

Optionally, the light source 310 may be a laser light source, an light emitting diode (light emitting diode, LED) light source, or another form of light source. This is not exhaustively described in the present invention.

Optionally, the light source 310 is a laser light source. It should be understood that the beam from the laser light source may also be referred to as a laser beam. For ease of description, the laser beam is collectively referred to as a beam in this embodiment of this application.

Optionally, the beam emitted by the light source 310 is a single beam of quasi-parallel light, and a divergence angle of the beam emitted by the light source 310 is less than 1°.

Optionally, the light source 310 may be a semiconductor laser light source.

The light source may be a vertical cavity surface emitting laser (vertical cavity surface emitting laser, VCSEL).

Optionally, the light source 310 is a Fabry-Perot laser (which may be briefly referred to as an FP laser).

Compared with a single VCSEL, a single FP laser may implement a larger power, and has higher electro-optic conversion efficiency than the VCSEL, so that a scanning effect can be improved.

Optionally, a wavelength of the beam emitted by the light source 310 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of the beam emitted by the light source 310 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

A light emitting area of the light source 310 is less than or equal to $5 \times 5$ mm$^2$.

Because a size of the light source is small, the TOF depth sensing module 300 that includes the light source is easy to be integrated into a terminal device, so that space occupied in the terminal device can be reduced to an extent.

Optionally, an average output optical power of the TOF depth sensing module is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

Polarization filtering device 320:

The polarization filtering device 320 is configured to filter the beam to obtain a beam in a single polarization state.

The beam that is in the single polarization state and that is obtained by the polarization filtering device 320 through filtering is one of the beam that is in a plurality of polarization states and that is generated by the light source 310.

For example, the beam generated by the light source 310 includes linearly polarized light, left-handed circularly polarized light, and right-handed circularly polarized light. In this case, the polarization filtering device 320 may screen out the left-handed circularly polarized light and the right-handed circularly polarized light in the beam, and reserve only the linearly polarized light in a specified direction. Optionally, the polarization filtering device may further include a quarter-wave plate, so that the linearly polarized light obtained through screening is converted into left-handed circularly polarized light (or right-handed circularly polarized light).

Beam shaping device 330:

The beam shaping device 330 is configured to adjust the beam to obtain a first beam.

It should be understood that, in this embodiment of this application, the beam shaping device 330 is specifically configured to increase a field of view FOV of the beam.

An FOV of the first beam meets a first preset range.

Preferably, the first preset range may be [5°×5°, 20°×20°].

It should be understood that FOV in a horizontal direction of the FOV of the first beam may be between 5° and 20° (including 5° and 20°), and FOV in a vertical direction of the FOV of the first beam may be between 5° and 20° (including 5° and 20°).

It should also be understood that, another range less than 5°×5° or greater than 20°×20° falls within the protection scope of this application, provided that the range can meet an invention concept of this application. However, for ease of description, this is not exhaustively described herein.

Control unit 370:

The control unit 370 is configured to control the first optical element to separately control a direction of the first beam at M different moments, to obtain emergent beams in M different directions.

A total FOV covered by the emergent beams in the M different directions meets a second preset range.

Preferably, the second preset range may be [50°×50°, 80°×80°].

Similarly, another range less than 50°×50° or greater than 80°×80° falls within the protection scope of this application, provided that the range can meet an invention concept of this application. However, for ease of description, this is not exhaustively described herein.

The control unit 370 is further configured to control the second optical element to separately deflect, to the receiving unit, M reflected beams obtained by a target object by reflecting the emergent beams in the M different directions.

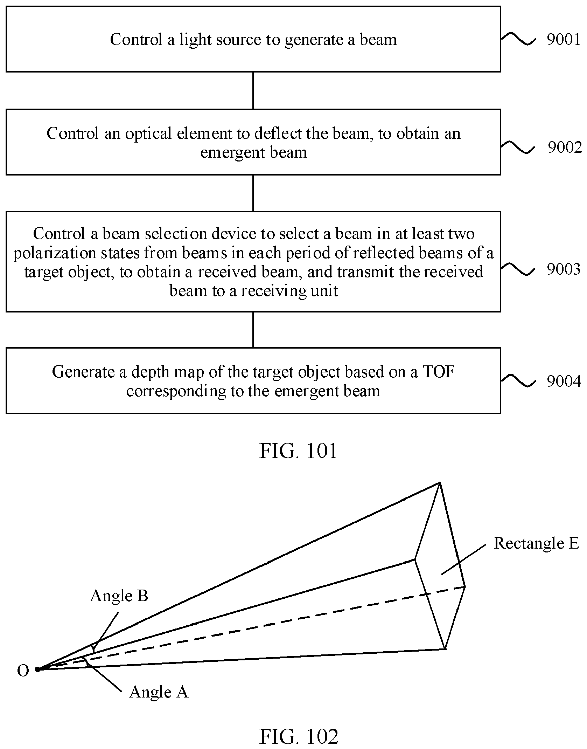

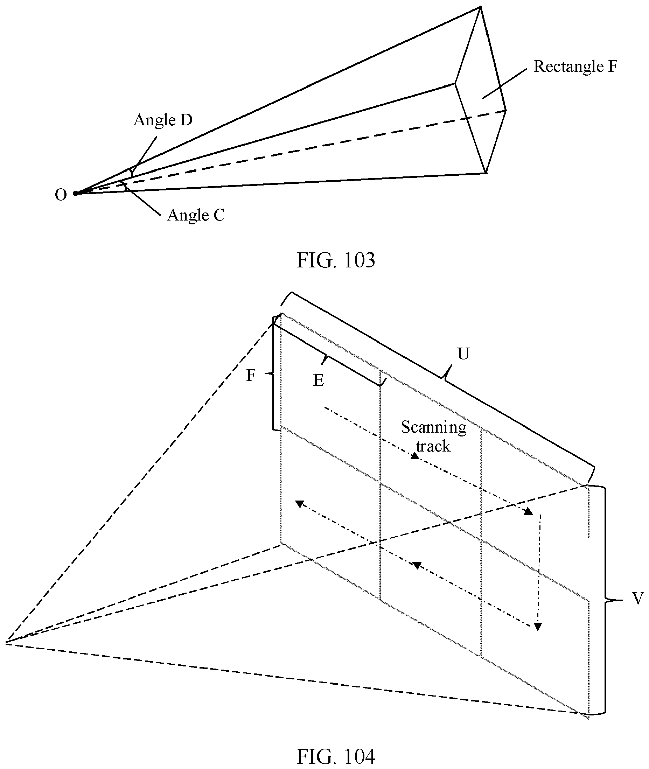

It should be understood that, with reference to FIG. 102 and FIG. 104, the following describes the FOV of the first beam obtained by the beam shaping device in the TOF depth sensing module 300 through processing and the total FOV obtained through scanning in the M different directions. Details are not described herein.

In this embodiment of this application, the beam shaping device adjusts the FOV of the beam, so that the first beam has a large FOV In addition, scanning is performed through time division multiplexing (the first optical element emits emergent beams in different directions at different moments), so that spatial resolution of a finally obtained depth map of the target object can be improved.

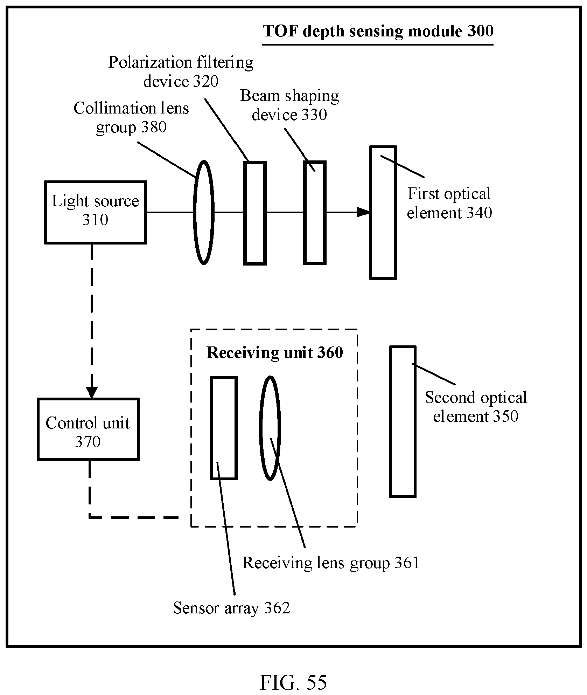

FIG. 55 is a schematic block diagram of a TOF depth sensing module according to an embodiment of this application.

As shown in FIG. 55, the TOF depth sensing module further includes a collimation lens group 380. The collimation lens group 380 is located between the light source 310 and the polarization filtering device 320, and the collimation lens group 380 is configured to perform collimation processing on a beam. The polarization filtering device 320 is configured to filter a beam obtained after the collimation lens group 380 performs collimation processing, to obtain a beam in a single polarization state.

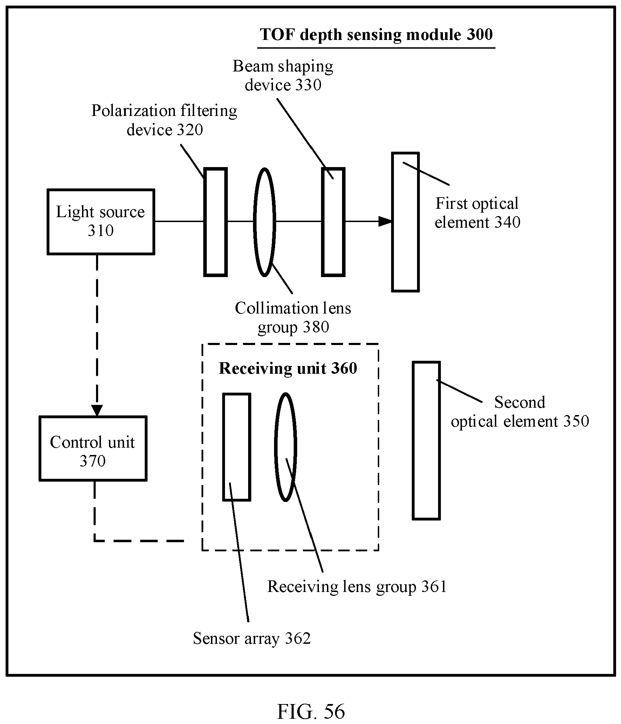

FIG. 56 is a schematic block diagram of a TOF depth sensing module according to an embodiment of this application. In FIG. 56, the collimation lens group 380 may be located between the polarization filtering device 320 and the beam shaping device 330. The collimation lens group 380 is configured to perform collimation processing on a beam in a single polarization state. The beam shaping device 330 is configured to adjust an FOV of a beam obtained after the collimation lens group 380 performs collimation processing, to obtain a first beam.

An approximately parallel beam can be obtained by performing collimation processing on a beam by using the collimation lens group, so that a power density of the beam can be improved, and an effect of subsequently performing scanning by using the beam can be improved.

Optionally, a clear aperture of the collimation lens group is less than or equal to 5 mm.

Because a size of the collimation lens group is small, the TOF depth sensing module that includes the collimation lens group is easy to be integrated into a terminal device, so that space occupied in the terminal device can be reduced to an extent.

It should be understood that the collimation lens group may be located between the optical shaping device 330 and the first optical element 340. In this case, the collimation lens group performs collimation processing on a beam obtained after the beam shaping device 330 performs shaping processing, and a beam obtained after collimation processing is performed is processed by the first optical element.

In addition, the collimation lens group 380 may be located at any possible location in the TOF depth sensing module 300, and perform collimation processing on a beam in any possible process.

Optionally, a horizontal distance between the first optical element and the second optical element is less than or equal to 1 cm.

Optionally, the first optical element and/or the second optical element are/is a rotation mirror device.

The rotation mirror device controls an emergent direction of an emergent beam through rotation.

The rotation mirror device may be specifically a microelectromechanical systems galvanometer or a multifaceted rotation mirror.

The first optical element may be any one of devices such as a liquid crystal polarization grating, an electro-optic device, an acousto-optic device, and an optical phased array device, and the second optical element may also be any one of devices such as a liquid crystal polarization grating, an electro-optic device, an acousto-optic device, and an optical phased array device. For specific content of the devices such as the liquid crystal polarization grating, the electro-optic device, the acousto-optic device, and the optical phased array device, refer to descriptions in Case1 to Case 4.

As shown in FIG. 35, the liquid crystal polarization grating includes a horizontal LCPG and a vertical LCPG, and also includes a horizontal polarization control sheet and a vertical polarization control sheet. In FIG. 35, the horizontal LCPG is located between the horizontal polarization control sheet and the vertical polarization control sheet, and the vertical polarization control sheet is located between the horizontal LCPG and the vertical LCPG.

Optionally, the components in the liquid crystal polarization grating shown in FIG. 35 may have the following combination manners:

a combination manner 1: 124;
a combination manner 2: 342; and
a combination manner 3: 3412.

In the foregoing combination manner 1, 1 may represent the horizontal polarization control sheet and the vertical polarization control sheet that are tightly attached. In the foregoing combination manner 2, 3 may represent the horizontal polarization control sheet and the vertical polarization control sheet that are tightly attached.

When the first optical element 340 or the second optical element 350 in the combination manner 1 or the combination manner 2 is placed in the TOF depth sensing module, both the horizontal polarization control sheet and the vertical polarization control sheet are located on a side close to the light source, and both the horizontal LCPG and the vertical LCPG are located on a side far away from the light source.

When the first optical element 340 or the second optical element 350 in the combination manner 3 is placed in the TOF depth sensing module, distances between the light source and all of the vertical polarization control sheet, the vertical LCPG, the horizontal polarization control sheet, and the horizontal LCPG are successively increased.

It should be understood that the foregoing three combination manners of the liquid crystal polarization grating and the combination manner in FIG. 35 are merely examples. In practice, the components in the optical element in this application may further have a different combination manner, provided that a distance between the horizontal polarization control sheet and the light source is less than a distance between the horizontal LCPG and the light source, and a distance between the horizontal polarization control sheet and the light source is less than a distance between the horizontal LCPG and the light source.

Optionally, the second optical element includes a horizontal polarization control sheet, a horizontal liquid crystal polarization grating, a vertical polarization control sheet, and a vertical liquid crystal polarization grating.

Optionally, the beam shaping device includes a diffusion lens group and a rectangular aperture.

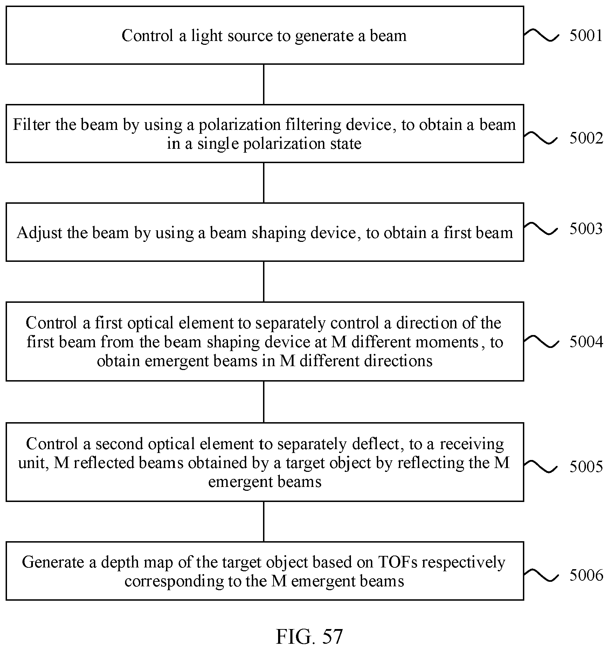

The foregoing describes the TOF depth sensing module in the embodiments of this application with reference to FIG. 53 to FIG. 56. The following describes in detail an image generation method in the embodiments of this application with reference to FIG. 57.

FIG. 57 is a schematic flowchart of an image generation method according to an embodiment of this application.

The method shown in FIG. 57 may be performed by the TOF depth sensing module or a terminal device including the TOF depth sensing module in the embodiments of this application. Specifically, the method shown in FIG. 57 may be performed by the TOF depth sensing module shown in FIG. 54 or a terminal device including the TOF depth sensing module shown in FIG. 54. The method shown in FIG. 57 includes step 5001 to step 5006. The following separately describes the steps in detail.

5001. Control a light source to generate a beam.

5002. Filter the beam by using a polarization filtering device, to obtain a beam in a single polarization state.

The single polarization state is one of the plurality of polarization states.

For example, the plurality of polarization states may include linear polarization, left-handed circular polarization, and right-handed circular polarization. The single polarization state may be any one of linear polarization, left-handed circular polarization, and right-handed circular polarization.

5003. Adjust the beam by using a beam shaping device, to obtain a first beam.

Optionally, the foregoing step 5003 specifically includes: adjusting angular spatial intensity distribution of the beam in the single polarization state by using the beam shaping device, to obtain the first beam.

It should be understood that, in this embodiment of this application, the adjusting the beam by using a beam shaping device is specifically that increasing a field of view FOV of the beam by using the beam shaping device.

This means that the foregoing step 5003 may specifically further include: increasing angular spatial intensity distribution of the beam in the single polarization state by using the beam shaping device, to obtain the first beam.

An FOV of the first beam meets a first preset range.

Preferably, the first preset range may be $[5°×5°, 20°×20°]$.

5004. Control a first optical element to separately control a direction of the first beam from the beam shaping device at M different moments, to obtain emergent beams in M different directions.

A total FOV covered by the emergent beams in the M different directions meets a second preset range.

Preferably, the second preset range may be $[50°×50°, 80°×80°]$.

5005. Control a second optical element to separately deflect, to a receiving unit, M reflected beams obtained by a target object by reflecting the emergent beams in the M different directions.

5006. Generate a depth map of the target object based on TOFs respectively corresponding to the emergent beams in the M different directions.

In this embodiment of this application, the beam shaping device adjusts the FOV of the beam, so that the first beam has a large FOV In addition, scanning is performed through time division multiplexing (the first optical element emits emergent beams in different directions at different moments), so that spatial resolution of a finally obtained depth map of the target object can be improved.

Optionally, the foregoing step 5006 specifically includes: generating depth maps of the M regions of the target object based on distances between the M regions of the target object and the TOF depth sensing module, and synthesizing the depth map of the target object based on the depth maps of the M regions of the target object.

Optionally, the foregoing step 5004 specifically includes: A control unit generates a first voltage signal, where the first voltage signal is used to control the first optical element to separately control the direction of the first beam at the M different moments, to obtain the emergent beams in the M different directions. The foregoing step 5005 includes: The control unit generates a second voltage signal, where the second voltage signal is used to control the second optical element to separately deflect, to the receiving unit, the M reflected beams obtained by the target object by reflecting the emergent beams in the M different directions.

Voltage values of the first voltage signal and the second voltage signal are the same at a same moment.

In the TOF depth sensing module 300 shown in FIG. 54, the transmit end and the receive end separately control beam emission and receiving by using different optical elements. Optionally, in the TOF depth sensing module in the embodiments of this application, the transmit end and the receive end may control beam emission and receiving by using a same optical element.

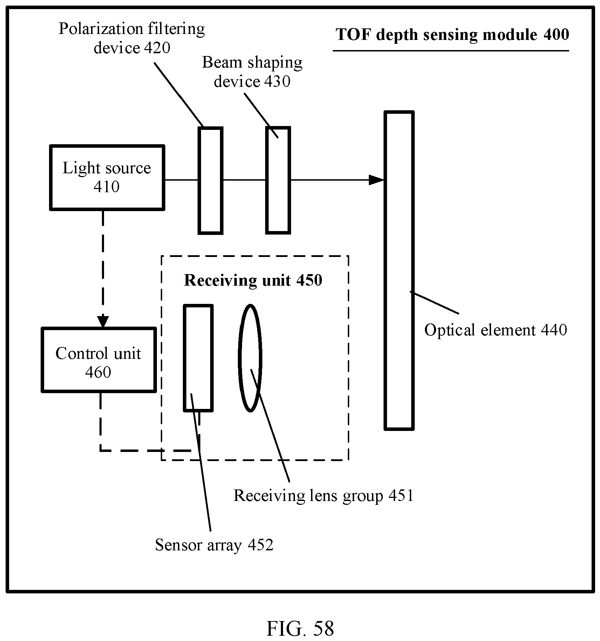

With reference to FIG. 58, the following describes in detail a case in which the transmit end and the receive end implement beam reflection and receiving by using a same optical element.

FIG. 58 is a schematic block diagram of a TOF depth sensing module according to an embodiment of this application.

A TOF depth sensing module 400 shown in FIG. 58 includes a light source 410, a polarization filtering device 420, a beam shaping device 430, an optical element 440, a receiving unit 450, and a control unit 460. As shown in FIG. 58, a transmit end of the TOF depth sensing module 400 includes the light source 410, the polarization filtering device 420, the beam shaping device 430, and the optical element 440. The receive end of the TOF depth sensing module 400 includes the optical element 440 and the receiving unit 450. The transmit end and the receive end of the TOF depth sensing module 400 share the optical element 440. The optical element 440 can control a beam at the transmit end to obtain an emergent beam, and can also control a reflected beam, so that the reflected beam is deflected to the receiving unit 450.

The following describes in detail the modules or units in the TOF depth sensing module 400.

Light source 410:

The light source 410 is configured to generate a beam.

Optionally, the beam emitted by the light source 410 is a single beam of quasi-parallel light, and a divergence angle of the beam emitted by the light source 410 is less than 1°.

Optionally, the light source 410 is a semiconductor laser light source.

The light source 410 may be a vertical cavity surface emitting laser (vertical cavity surface emitting laser, VCSEL).

Optionally, the light source 410 may be a Fabry-Perot laser (which may be briefly referred to as an FP laser).

Compared with a single VCSEL, a single FP laser may implement a larger power, and has higher electro-optic conversion efficiency than the VCSEL, so that a scanning effect can be improved.

Optionally, a wavelength of the beam emitted by the light source 410 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of the beam emitted by the light source 410 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

A light emitting area of the light source 410 is less than or equal to $5\times5$ mm$^2$.

Because a size of the light source is small, the TOF depth sensing module 400 that includes the light source is easy to be integrated into a terminal device, so that space occupied in the terminal device can be reduced to an extent.

Optionally, an average output optical power of the TOF depth sensing module 400 is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

The polarization filtering device 420 is configured to filter the beam to obtain a beam in a single polarization state.

The beam shaping device 430 is configured to increase an FOV of the beam in the single polarization state, to obtain a first beam.

The control unit 460 is configured to control the optical element 440 to separately control a direction of the first beam at M different moments, to obtain emergent beams in M different directions.

The control unit 460 is further configured to control the optical element 440 to separately deflect, to the receiving unit 450, M reflected beams obtained by a target object by reflecting the emergent beams in the M different directions.

The single polarization state is one of a plurality of polarization states.

For example, the plurality of polarization states may include linear polarization, left-handed circular polarization, and right-handed circular polarization. The single polarization state may be any one of linear polarization, left-handed circular polarization, and right-handed circular polarization.

An FOV of the first beam meets a first preset range. A total FOV covered by the emergent beams in the M different directions meets a second preset range. More specifically, the second preset range is greater than the first preset range. More generally, an FOV in the first preset range is A°, and may cover a field of view in A°*A°, and a range A is not less than 3 and is not greater than 40. An FOV in the second preset range is B°, and may cover a field of view in B°*B°, and a range B is not less than 50 and is not greater than 120. It should be understood that a proper deviation may exist in a specific production process of a device in the art.

Optionally, the first preset range may include $[5°\times5°, 20°\times20°]$, that is, A is not less than 5 and is not greater than 20. The second preset range may include $[50°\times50°, 80°\times80°]$, that is, B is not less than 50 and is not greater than 80.

In this embodiment of this application, the beam shaping device adjusts the FOV of the beam, so that the first beam has a large FOV In addition, scanning is performed through time division multiplexing (the optical element emits emergent beams in different directions at different moments), so that spatial resolution of a finally obtained depth map of the target object can be improved.

Optionally, the control unit 460 is further configured to generate a depth map of the target object based on TOFs respectively corresponding to the emergent beams in the M different direction.

The TOFs corresponding to the emergent beams in the M different directions may be specifically time difference information between moments at which the reflected beams corresponding to the emergent beams in the M different directions are received by the receiving unit and emergent moments of the emergent beams in the M different directions.

It is assumed that the emergent beams in the M different directions include an emergent beam 1. In this case, a reflected beam corresponding to the emergent beam 1 may be a beam generated after the emergent beam 1 arrives at the target object and is reflected by the target object.

Optionally, the foregoing limitation on the light source 310, the polarization filtering device 320, and the beam shaping device 330 in the TOF depth sensing module 300 is also applicable to the light source 410, the polarization filtering device 420, and the beam shaping device 430 in the TOF depth sensing module 400.

Optionally, the optical element is a rotation mirror device.

The rotation mirror device controls an emergent direction of an emergent beam through rotation.

Optionally, the rotation mirror device is a microelectromechanical systems galvanometer or a multifaceted rotation mirror.

With reference to the accompanying drawings, the following describes a case in which the optical element is a rotation mirror device.

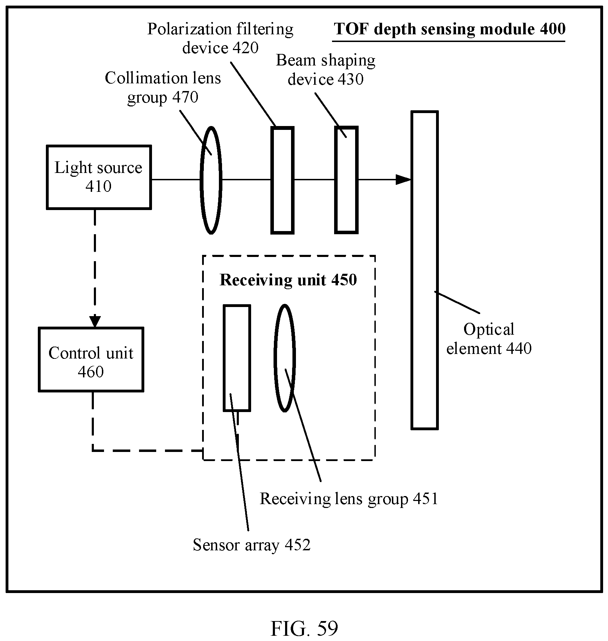

FIG. 59 is a schematic block diagram of a TOF depth sensing module according to an embodiment of this application.

As shown in FIG. 59, the TOF depth sensing module further includes a collimation lens group 470. The collimation lens group 470 is located between the light source 410 and the polarization filtering device 420, and the collimation lens group 470 is configured to perform collimation processing on a beam. The polarization filtering device 420 is configured to filter a beam obtained after the collimation lens group 470 performs collimation processing, to obtain a beam in a single polarization state.

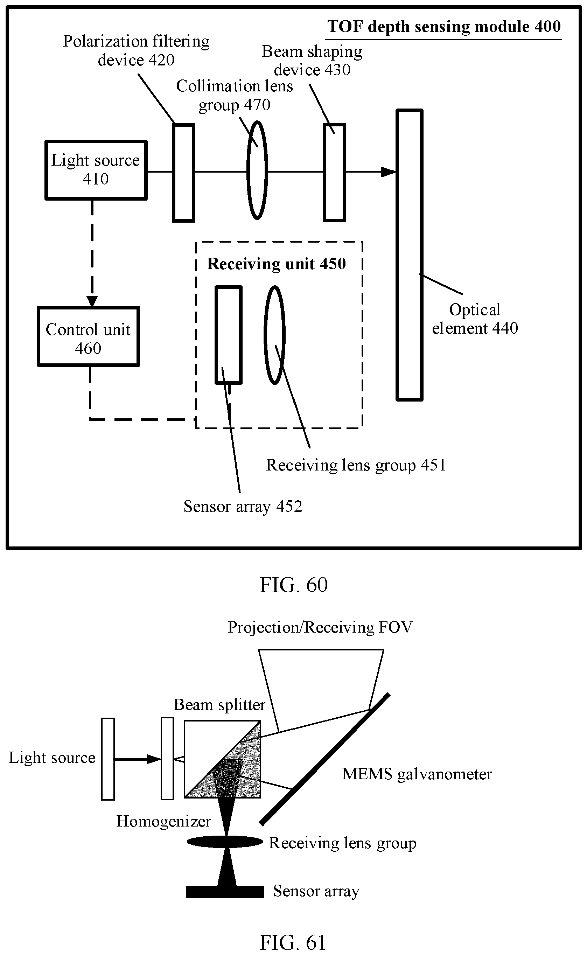

FIG. 60 is a schematic block diagram of a TOF depth sensing module according to an embodiment of this application. In FIG. 60, the collimation lens group 470 may be located between the polarization filtering device 420 and the beam shaping device 430. The collimation lens group 470 is configured to perform collimation processing on a beam in a single polarization state. The beam shaping device 430 is configured to adjust an FOV of a beam obtained after the collimation lens group 470 performs collimation processing, to obtain a first beam.

An approximately parallel beam can be obtained by performing collimation processing on a beam by using the collimation lens group, so that a power density of the beam can be improved, and an effect of subsequently performing scanning by using the beam can be improved.

Optionally, a clear aperture of the collimation lens group is less than or equal to 5 mm.

Because a size of the collimation lens group is small, the TOF depth sensing module that includes the collimation lens group is easy to be integrated into a terminal device, so that space occupied in the terminal device can be reduced to an extent.

It should be understood that the collimation lens group may be located between the optical shaping device 430 and the optical element 440. In this case, the collimation lens group performs collimation processing on a beam obtained after the beam shaping device 430 performs shaping processing, and a beam obtained after collimation processing is performed is processed by the optical element 440.

In addition, the collimation lens group 470 may be located at any possible location in the TOF depth sensing module 400, and perform collimation processing on a beam in any possible process.

As shown in FIG. 61, a TOF depth sensing module includes a light source, a homogenizer, a beam splitter, a microelectromechanical systems (microelectromechanical systems, MEMS) galvanometer, a receiving lens group, and a sensor. The MEMS in the figure includes an electrostatic galvanometer, an electromagnetic galvanometer, a multifaceted rotation mirror, and the like. Because all the rotation mirror devices work in a reflection manner, an optical path in the TOF depth sensing module is a reflective optical path, and emission and receiving optical paths are co-axial optical paths. A polarization device and a lens group may be shared by using the beam splitter. In FIG. 61, the polarization device is specifically an MEMS galvanometer.

Optionally, the optical element 440 is a liquid crystal polarization element.

Optionally, the optical element 440 includes a horizontal polarization control sheet, a horizontal liquid crystal polarization grating, a vertical polarization control sheet, and a vertical liquid crystal polarization grating.

Optionally, in the optical element 440, distances between the light source and all of the horizontal polarization control sheet, the horizontal liquid crystal polarization grating, the vertical polarization control sheet, and the vertical liquid crystal polarization grating are successively increased, or distances between the light source and all of the vertical polarization control sheet, the vertical liquid crystal polarization grating, the horizontal polarization control sheet, and the horizontal liquid crystal polarization grating are successively increased.

Optionally, the beam shaping device 430 includes a diffusion lens group and a rectangular aperture.

The optical element may be any one of devices such as a liquid crystal polarization grating, an electro-optic device, an acousto-optic device, and an optical phased array device. For specific content of the devices such as the liquid crystal polarization grating, the electro-optic device, the acousto-optic device, and the optical phased array device, refer to descriptions in Case1 to Case 4.

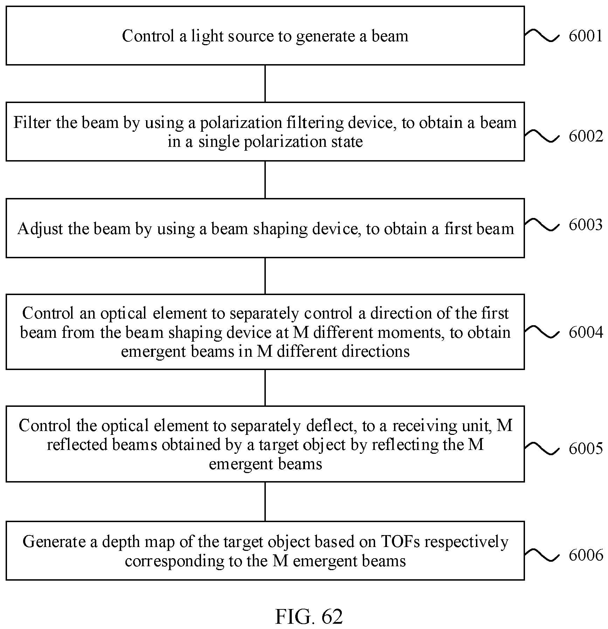

FIG. 62 is a schematic flowchart of an image generation method according to an embodiment of this application.

The method shown in FIG. 62 may be performed by the TOF depth sensing module or a terminal device including the TOF depth sensing module in the embodiments of this application. Specifically, the method shown in FIG. 62 may be performed by the TOF depth sensing module shown in FIG. 58 or a terminal device including the TOF depth sensing module shown in FIG. 58. The method shown in FIG. 62 includes step 6001 to step 6006. The following separately describes the steps in detail.

6001. Control a light source to generate a beam.

6002. Filter the beam by using a polarization filtering device, to obtain a beam in a single polarization state.

The single polarization state is one of a plurality of polarization states.

For example, the plurality of polarization states may include linear polarization, left-handed circular polarization, and right-handed circular polarization. The single polarization state may be any one of linear polarization, left-handed circular polarization, and right-handed circular polarization.

6003. Adjust the beam in the single polarization state by using a beam shaping device, to obtain a first beam.

It should be understood that, in this embodiment of this application, the adjusting the beam by using a beam shaping device is specifically that increasing a field of view FOV of the beam by using the beam shaping device.

Optionally, an FOV of the first beam meets a first preset range.

Optionally, the first preset range may be [5°×5°, 20°×20°].

6004. Control an optical element to separately control a direction of the first beam from the beam shaping device at M different moments, to obtain emergent beams in M different directions.

A total FOV covered by the emergent beams in the M different directions meets a second preset range.

Optionally, the second preset range may be [50°×50°, 80°×80°].

6005. Control the optical element to separately deflect, to a receiving unit, M reflected beams obtained by a target object by reflecting the emergent beams in the M different directions.

6006. Generate a depth map of the target object based on TOFs respectively corresponding to the emergent beams in the M different directions.

In this embodiment of this application, the beam shaping device adjusts the FOV of the beam, so that the first beam has a large FOV In addition, scanning is performed through time division multiplexing (the optical element emits emergent beams in different directions at different moments), so that spatial resolution of a finally obtained depth map of the target object can be improved.

Optionally, the foregoing step 6006 specifically includes: determining distances between M regions of the target object and the TOF depth sensing module based on the TOFs respectively corresponding to the emergent beams in the M different directions; generating depth maps of the M regions of the target object based on the distances between the M regions of the target object and the TOF depth sensing module; and synthesizing the depth map of the target object based on the depth maps of the M regions of the target object.

Optionally, the foregoing step 6003 specifically includes: adjusting angular spatial intensity distribution of the beam in the single polarization state by using the beam shaping device, to obtain the first beam.

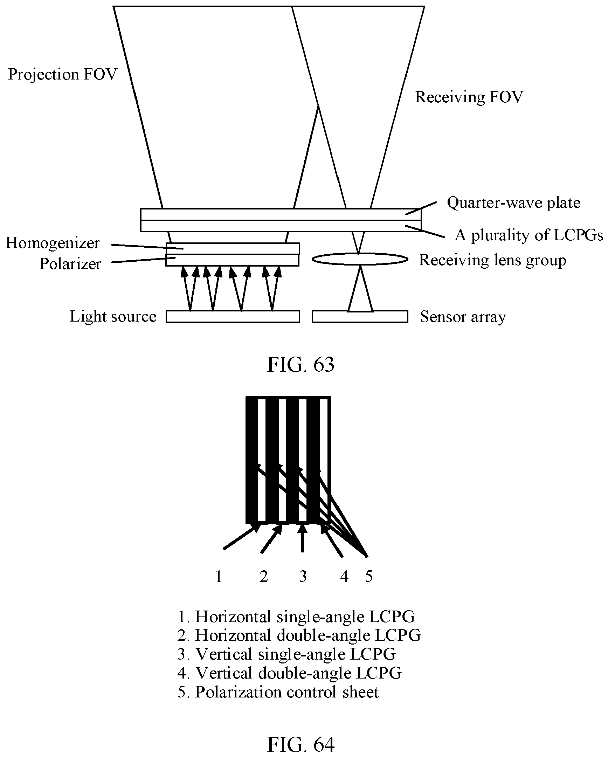

The following describes in detail a specific working process of the TOF depth sensing module 400 in the embodiments of this application with reference to FIG. 63.

FIG. 63 is a schematic diagram of a structure of a TOF depth sensing module according to an embodiment of this application.

Specific implementation and functions of each component of the TOF depth sensing module shown in FIG. 63 are as follows:

(1) A light source is a VCSEL array.
The VCSEL light source is a beam array capable of emitting a beam with good directionality.
(2) A polarizer is a polarization filtering device, and the polarizer may be located in the front (below) or back (above) of a homogenizer.
(3) The homogenizer may be a diffractive optical element (diffractive optical element, DOE) or an optical diffuser (may be referred to as a diffuser).
After a beam array is processed by the homogenizer, the beam array is arranged into a substantially uniform beam block.
(3) The optical element is a plurality of LCPGs (liquid crystal polarization gratings).

It should be understood that, in FIG. 63, only a case in which the polarizer is located below the homogenizer is reflected. In practice, the polarizer may be located above the homogenizer.

For a specific principle of controlling a direction of a beam by the liquid crystal polarization grating, refer to related content described in FIG. 37 and FIG. 38.

**EP 4 080 246 A1**

In FIG. 63, through cooperation between a plurality of liquid crystal polarization gratings and a quarter-wave plate, when emitted light is reflected by a target and returns to the polarizer, the light exactly passes through an additional optical path that is 1/2 wavelength long. In this design, due to the polarizer, the reflected light is exactly deflected in a direction opposite to the emitted light. In case of quasi-coaxial approximation, after light that is obliquely emitted is reflected, the light returns along an original path, and is deflected back in a direction parallel to the emitted light to arrive at a receiving lens group. The receive end can image, to an entire receiver (SPAD array) by using a beam deflection device, a target block on which the emitted light selects to illuminate. When a target is illuminated by a block, each block is received by the entire receiver, and a complete image may be obtained by splicing an image at each moment. In this way, time division multiplexing of the receiver is implemented, and resolution is multiplied.

(4) The receiving lens group is completed by a common lens, to image received light on the receiver.

(5) The receiver is an SPAD array.

The SPAD may detect a single photon, and a time of a single photon pulse detected by the SPAD may be accurately recorded. Each time the VCSEL emits light, the SPAD is started. The VCSEL periodically emits a beam, and the SPAD array may collect statistics about a moment at which each pixel receives reflected light in each period. Statistics about time distribution of a reflection signal are collected, so that a reflection signal pulse can be fitted, to calculate a delay time.

A key device in this embodiment is the beam deflection device that is shared by a projection end and a receive end, namely, a liquid crystal polarization device. In this embodiment, the beam deflection device includes a plurality of LCPGs, and is also referred to as an electrically controlled liquid crystal polarization device.

FIG. 64 is a schematic diagram of a structure of a liquid crystal polarization device according to an embodiment of this application.

An optional specific structure of the liquid crystal polarization device is shown in FIG. 64. In FIG. 64, 1 represents a horizontal single-angle LCPG, 2 represents a horizontal double-angle LCPG, 3 represents a vertical single-angle LCPG, 4 represents a vertical double-angle LCPG, and 5 is a polarization control sheet. There are a total of five polarization control sheets that are respectively located at the left of the four LCPGs shown in FIG. 64 and that are respectively numbered 5.1, 5.2, 5.3, and 5.4.

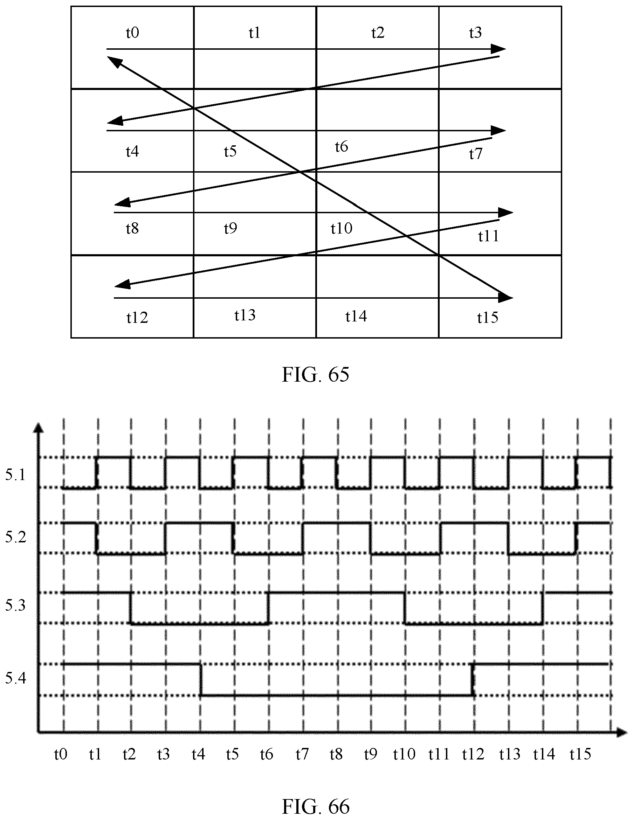

The liquid crystal polarization device shown in FIG. 64 may be controlled by using a control unit, and a control time sequence may be shown in FIG. 65 (scanning starts at a moment t0 and lasts until a moment t15). FIG. 66 is a time sequence diagram of a drive signal generated by the control unit.

FIG. 66 shows voltage drive signals of the polarization control sheets 5.1, 5.2, 5.3, and 5.4 of the device from the moments t0 to t15. The voltage drive signals include two types of signals: a low level signal and a high level signal, the low level signal is represented by 0, and the high level signal is represented by 1. In this case, the voltage drive signals of the polarization control sheets 5.1, 5.2, 5.3, and 5.4 from the moments t0 to t15 are specifically shown in Table 1.

For example, in Table 1, in the t0 time interval, a voltage drive signal of the polarization control sheet 5.1 is a low level signal, and voltage drive signals of the polarization control sheets 5.2 to 5.4 are high level signals. Therefore, voltage signals corresponding to the moment t0 are 0111.

Table 1

| Time sequence | Voltage |
| --- | --- |
| t0 | 0111 |
| t1 | 1011 |
| t2 | 0001 |
| t3 | 1101 |
| t4 | 0100 |
| t5 | 1000 |
| t6 | 0010 |
| t7 | 1110 |
| t8 | 0110 |
| t9 | 1010 |
| t10 | 0000 |
| t11 | 1100 |

(continued)

| Time sequence | Voltage |
|---|---|
| t12 | 0101 |
| t13 | 1001 |
| t14 | 0011 |
| t15 | 1111 |

Table 2

| Pass through 5.1 | Pass through 1 | Pass through 5.2 | Pass through 2 | Pass through 5.3 | Pass through 3 | Pass through 5.4 | Pass through 4 | Voltage | Time sequence | Location |
|---|---|---|---|---|---|---|---|---|---|---|
| L00 (0) | R-10 (0) | R-10 (00) | L10 (00) | L10 (000) | R1-1 (000) | R1-1 | L11 | 0000 | t10 | 11 |
| | | | | | | L1-1 | R1-3 | 0001 | t2 | 1-3 |
| | | | | R10 (001) | L11 (001) | L11 | R1-1 | 0010 | t6 | 1-1 |
| | | | | | | R11 | L13 | 0011 | t14 | 13 |
| | | L-10 (01) | R-30 (01) | R-30 (010) | L-31 (010) | L-31 | R-3-1 | 0100 | t4 | -3-1 |
| | | | | | | R-31 | L-33 | 0101 | t12 | -33 |
| | | | | L-30 (011) | R-3-1 (011) | R-3-1 | L-31 | 0110 | t8 | -31 |
| | | | | | | L-3-1 | R-33 | 0111 | t0 | -3-3 |
| R00 (1) | L-10 (1) | L-10 (10) | R-10 (10) | R-10 (100) | L-11 (100) | L-1-1 | R-1-1 | 1000 | t5 | -1-1 |
| | | | | | | R-1-1 | L-13 | 1001 | t13 | -13 |
| | | | | L-10 (101) | R-1-1 (101) | R-1-1 | L-11 | 1010 | t9 | -11 |
| | | | | | | L-1-1 | R-1-1 | 1011 | t1 | -1-3 |
| | | R-10 (11) | L30 (11) | L30 (11) | R3-1 (11) | R3-1 | L31 | 1100 | t11 | 31 |
| | | | | | | L3-1 | R3-3 | 1101 | t3 | 3-3 |
| | | | | R30 | L31 | L31 | R3-1 | 1110 | t7 | 3-1 |
| | | | | (111) | (111) | R31 | L33 | 1111 | t15 | 33 |

As shown in FIG. 64, the electrically controlled liquid crystal polarization device includes an LCPG and a polarization control sheet. Voltage drive signals for implementing 4*4 scanning are shown in FIG. 66, where 5.1, 5.2, 5.3, and 5.4 respectively represent voltage drive signals applied to the four polarization control sheets, an entire FOV is divided into 4*4 blocks, and t0 to t15 are respectively time intervals for illuminating the blocks. When the voltage drive signal shown in FIG. 66 is applied, and a beam passes through the liquid crystal polarization device, a state of the beam that passes through each device is shown in Table 2.

The following describes meanings indicated in Table 2. In all items in Table 2, a value in parentheses is a voltage signal, L represents left-handed rotation, R represents right-handed rotation, a value such as 1 and 3 represents a deflection angle of a beam, and a deflection angle represented by 3 is greater than a deflection angle represented by 1.

For example, for R1-1, R represents right-handed rotation, the first 1 means left (which means right in case of-1), and the second -1 means an upper side (which means a lower side in case of 1).

For another example, for L3-3, L represents left-handed rotation, the first 3 means rightmost (which means leftmost in case of -3), and the second -3 means topmost (which represents bottommost in case of 3).

When the voltage drive signal shown in FIG. 66 is applied to the liquid crystal polarization device, scanning regions of the TOF depth sensing module at different moments are shown in FIG. 67.

The following describes the obtained depth map in this embodiment of this application with reference to the accompanying drawings. As shown in FIG. 68, it is assumed that depth maps corresponding to a target object at moments t0 to t3 can be obtained through time division scanning. Resolution of the depth maps corresponding to the moments t0 to t3 is 160×120. A final depth map that is of the target object and that is shown in FIG. 69 may be obtained by splicing the depth maps corresponding to the moments t0 to t3. Resolution of the final depth map of the target object is 320×240. It may be learned from FIG. 68 and FIG. 69 that resolution of a finally obtained depth map can be improved by splicing depth maps obtained at different moments.

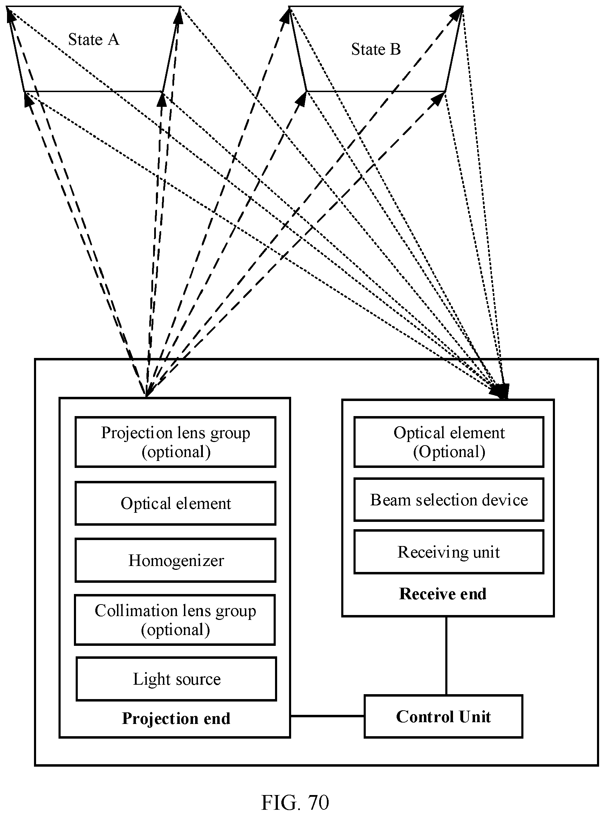

The foregoing describes in detail a TOF depth sensing module and an image generation method in the embodiments of this application with reference to FIG. 53 to FIG. 69. The following describes in detail another TOF depth sensing module and another image generation method in the embodiments of this application with reference to FIG. 70 to FIG. 78.

In the TOF depth sensing module, a liquid crystal device may be used to adjust a direction of a beam. In addition, in the TOF depth sensing module, a polarizer is generally added to a transmit end to emit polarized light. However, in a process of emitting the polarized light, due to a polarization selection function of the polarizer, half of energy is lost when the beam is emitted. The part of lost energy is absorbed by the polarizer or scattered and converted into heat. Consequently, a temperature of the TOF depth sensing module rises, and stability of the TOF depth sensing module is affected. Therefore, how to reduce a heat loss of the TOF depth sensing module is a problem that needs to be resolved.

Specifically, in the TOF depth sensing module in the embodiments of this application, the heat loss of the TOF depth sensing module may be reduced by transferring the polarizer from the transmit end to the receive end. The following describes in detail the TOF depth sensing module in the embodiments of this application with reference to the accompanying drawings.

The following first briefly describes the TOF depth sensing module in the embodiments of this application with reference to FIG. 70.

FIG. 70 is a schematic working diagram of a TOF depth sensing module according to an embodiment of this application. As shown in FIG. 70, the TOF depth sensing module may include a transmit end (or may be referred to as a projection end), a receive end, and a control unit. The transmit end is configured to emit an emergent beam. The receive end is configured to receive a reflected beam (the reflected beam is a beam obtained by a target object by reflecting the emergent beam) of the target object. The control unit may control the transmit end and the receive end to respectively emit and receive a beam.

In FIG. 70, the transmit end may generally include a light source, a collimation lens group (optional), a homogenizer, an optical element, and a projection lens group (optional). The receive end generally includes a beam selection device and a receiving unit, and the receiving unit may specifically include a receiving lens group and a sensor.

The TOF depth sensing module shown in FIG. 70 projects projection light in two or more different states (a state A and a state B) at a same moment. After the projection light in the two different states is reflected and arrive at the receive end, the beam selection device selects, through time division based on an instruction, reflected light in a state to enter the sensor, and performs depth imaging on light in a specified state. Then, a beam deflection device may perform scanning in different directions to implement coverage of a target FOV

The TOF depth sensing module shown in FIG. 70 may be configured to obtain a 3D image. The TOF depth sensing module in this embodiment of this application may be disposed in an intelligent terminal (for example, a mobile phone, a tablet, and a wearable device), is configured to obtain a depth image or a 3D image, and may also provide gesture and body recognition for 3D games or motion sensing games.

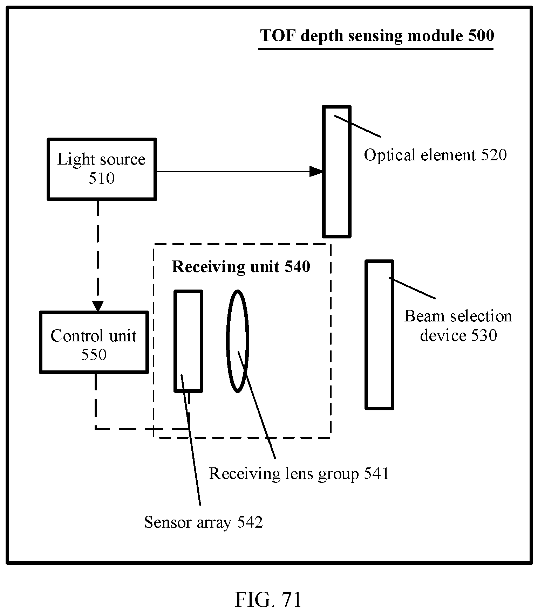

The following describes in detail the TOF depth sensing module in the embodiments of this application with reference to FIG. 71.

A TOF depth sensing module 500 shown in FIG. 71 includes a light source 510, an optical element 520, a beam selection device 530, a receiving unit 540, and a control unit 550.

The following describes in detail the modules or units in the TOF depth sensing module 500.

Light source 510:

The light source 510 is configured to generate a beam.

Optionally, the light source may be a semiconductor laser light source.

The light source may be a vertical cavity surface emitting laser (vertical cavity surface emitting laser, VCSEL).

Optionally, the light source may be a Fabry-Perot laser (which may be briefly referred to as an FP laser).

Compared with a single VCSEL, a single FP laser may implement a larger power, and has higher electro-optic conversion efficiency than the VCSEL, so that a scanning effect can be improved.

Optionally, a wavelength of the beam emitted by the light source 510 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of the beam emitted by the light source 510 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

Optionally, a light emitting area of the light source 510 is less than or equal to $5 \times 5$ mm$^2$.

Because a size of the light source is small, the TOF depth sensing module that includes the light source is easy to be integrated into a terminal device, so that space occupied in the terminal device can be reduced to an extent.

Optionally, an average output optical power of the TOF depth sensing module is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

Optical element 520:

The optical element 520 is disposed in an emergent direction of a beam, and the optical element 520 is configured to control a direction of the beam to obtain a first emergent beam and a second emergent beam. An emergent direction of the first emergent beam is different from an emergent direction of the second emergent beam, and a polarization direction of the first emergent beam is orthogonal to a polarization direction of the second emergent beam.

Optionally, as shown in FIG. 35, the optical element 520 may include a horizontal polarization control sheet, a horizontal liquid crystal polarization grating, a vertical polarization control sheet, and a vertical liquid crystal polarization grating, and distances between the light source and all of the horizontal polarization control sheet, the horizontal liquid crystal polarization grating, the vertical polarization control sheet, and the vertical liquid crystal polarization grating are successively increased.

Alternatively, in the optical element 520, distances between the light source and all of the vertical polarization control sheet, the vertical liquid crystal polarization grating, the horizontal polarization control sheet, and the horizontal liquid crystal polarization grating are successively increased.

Receiving unit 540:

The receiving unit 540 may include a receiving lens group 541 and a sensor 542.

Control unit 550 and beam selection device 530:

The control unit 550 is configured to control working of the beam selection device 530 by using a control signal. Specifically, the control unit 550 may generate a control signal. The control signal is used to control the beam selection device 530 to separately propagate a third reflected beam and a fourth reflected beam to the sensor at different time intervals. The third reflected beam is a beam obtained by the target object by reflecting the first emergent beam, and the fourth reflected beam is a beam by the target object obtained by reflecting the second emergent beam.

The beam selection device 530 can separately propagate beams in different polarization states to the receiving unit at different moments under control of the control unit 550. The beam selection device 530 herein propagates the received reflected beam to the receiving unit 540 in a time division mode. Compared with a beam splitter 630 in a TOF depth sensing module 600 below, receive resolution of the receiving unit 540 can be more fully utilized, and resolution of a finally obtained depth map is high.

Optionally, the control signal generated by the control unit 550 is used to control the beam selection device 530 to separately propagate the third reflected beam and the fourth reflected beam to the sensor at different time intervals.

In other words, under the control of the control signal generated by the control unit 550, the beam selection device may separately propagate the third reflected beam and the fourth reflected beam to the receiving unit at different moments.

Optionally, in an embodiment, the beam selection device 530 includes a quarter-wave plate, a half-wave plate, and a polarizer.

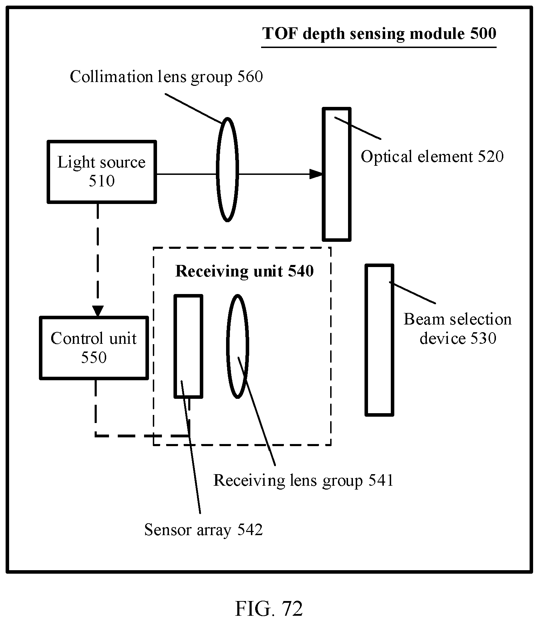

As shown in FIG. 72, the TOF depth sensing module 500 may further include:

a collimation lens group 560, where the collimation lens group 560 is disposed in an emergent direction of a beam, the collimation lens group is disposed between the light source and the optical element, the collimation lens group 560 is configured to perform collimation processing on the beam to obtain a beam obtained after collimation processing is performed, and the optical element 520 is configured to control a direction of the beam obtained after collimation processing is performed, to obtain a first emergent beam and a second emergent beam.

An approximately parallel beam can be obtained by performing collimation processing on a beam by using the collimation lens group, so that a power density of the beam can be improved, and an effect of subsequently performing scanning by using the beam can be improved.

Optionally, a clear aperture of the collimation lens group is less than or equal to 5 mm.

Because a size of the collimation lens group is small, the TOF depth sensing module that includes the collimation lens group is easy to be integrated into a terminal device, so that space occupied in the terminal device can be reduced to an extent.

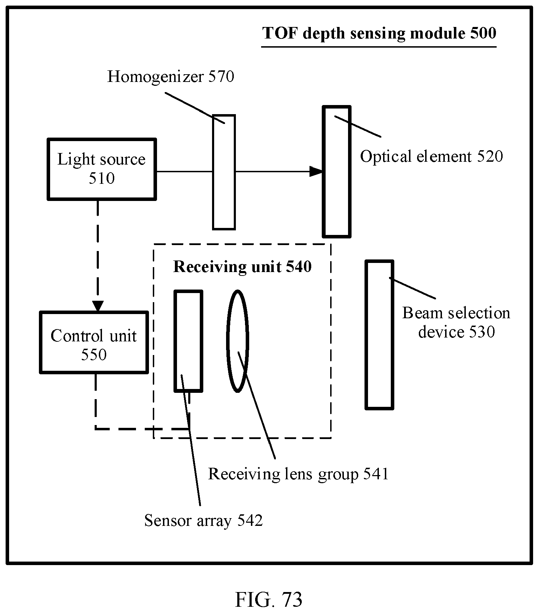

As shown in FIG. 73, the TOF depth sensing module 500 may further include:

a homogenizer 570, where the homogenizer 570 is disposed in an emergent direction of a beam, a collimation lens group is disposed between the light source 510 and the optical element 520, the homogenizer 570 is configured to adjust energy distribution of the beam to obtain a homogenized beam, and the optical element is configured to control a direction of the homogenized beam, to obtain a first emergent beam and a second emergent beam.

Optionally, the homogenizer is a microlens diffuser or a diffractive optical element diffuser (DOE Diffuser).

It should be understood that the TOF depth sensing module 500 may include both the collimation lens group 560 and the homogenizer 570. Both the collimation lens group 560 and the homogenizer 570 are located between the light source 510 and the optical element 520. For the collimation lens group 560 and the homogenizer 570, either the collimation lens group 560 is closer to the light source or the homogenizer 570 is closer to the light source.

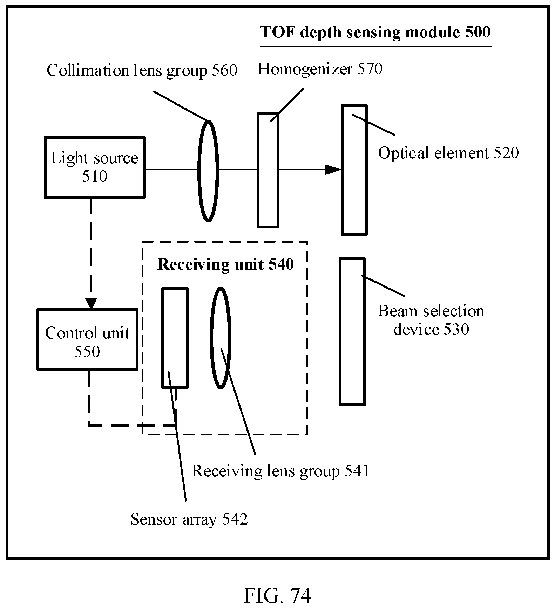

As shown in FIG. 74, a distance between the collimation lens group 560 and the light source 510 is less than a distance between the homogenizer 570 and the light source 510.

In the TOF depth sensing module 500 shown in FIG. 74, a beam emitted by the light source 510 is first subject to collimation processing of the collimation lens group 560, is subject to homogenization processing of the homogenizer 570, and then is propagated to the optical element 520 for processing.

In this embodiment of this application, through homogenization processing, an optical power of a beam can be distributed in angle space more uniformly or according to a specified rule, to prevent a local optical power from being excessively small, and avoid blind spots in a finally obtained depth map of a target object.

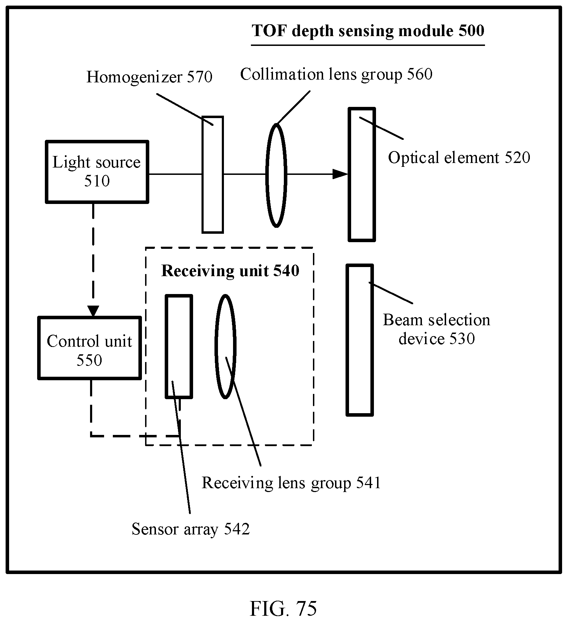

As shown in FIG. 75, a distance between the collimation lens group 560 and the light source 510 is greater than a distance between the homogenizer 570 and the light source 510.

In the TOF depth sensing module 500 shown in FIG. 74, a beam emitted by the light source 510 is first subject to homogenization processing of the homogenizer 570, is subject to collimation processing of the collimation lens group 560, and then is propagated to the optical element 520 for processing.

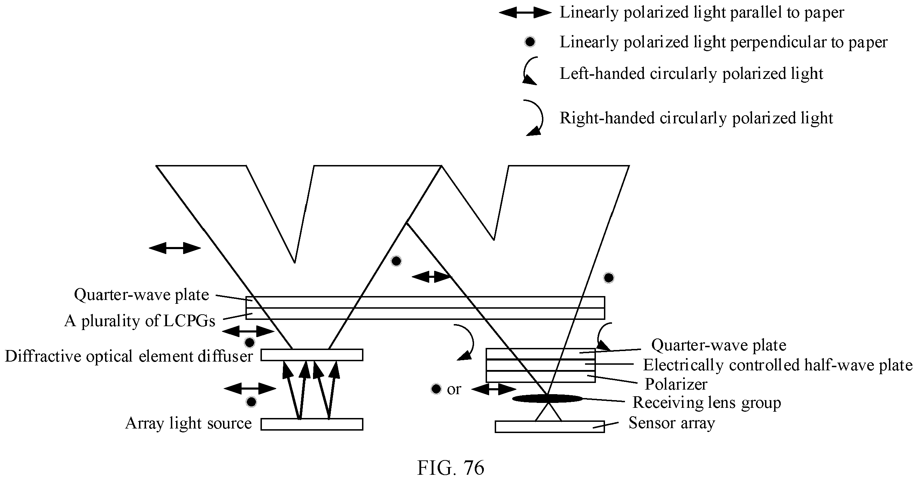

The following describes in detail a specific structure of the TOF depth sensing module 500 with reference to FIG. 76.

FIG. 76 is a schematic diagram of a specific structure of a TOF depth sensing module 500 according to an embodiment of this application.

As shown in FIG. 76, the TOF depth sensing module 500 includes a projection end, a control unit, and a receive end. The projection end includes a light source, a homogenizer, and a beam deflection device. The receive end includes a beam deflection device, a beam (dynamic) selection device, a receiving lens group, and a two-dimensional sensor. The control unit is configured to control the projection end and the receive end to complete beam scanning. In addition, the beam deflection device in FIG. 76 corresponds to the optical element in FIG. 71, and the beam (dynamic) selection device in FIG. 76 corresponds to the beam selection device in FIG. 71.

The following describes in detail a device specifically used for each module or unit.

The light source may be a vertical cavity surface emitting laser (VCSEL) array light source.

The homogenizer may be a diffractive optical element diffuser.

The beam deflection device may be a plurality of LCPGs and a quarter-wave plate.

An electrically controlled LCPG includes an electrically controlled horizontal LCPG device and an electrically controlled vertical LCPG device.

Two-dimensional block scanning in a horizontal direction and a vertical direction may be implemented by using the plurality of electrically controlled LCPGs that are cascaded. The quarter-wave plate is configured to convert a circularly polarized light from the LCPG into linearly polarized light, to implement a quasi-coaxial effect between the transmit end and the receive end.

A wavelength of the VCSEL array light source may be greater than 900 nm. Specifically, the wavelength of the VCSEL array light source may be 940 nm or 1550 nm.

Intensity of a solar spectrum on the band of 940 nm is weak. This helps reduce noise caused by sunlight in an outdoor scenario. In addition, a laser beam emitted by the VCSEL array light source may be continuous light or pulse light. The VCSEL array light source may also be divided into several blocks to implement control through time division, so that different regions are lit through time division.

The diffractive optical element diffuser is used to shape a beam emitted by the VCSEL array light source into a uniform square or rectangular light source with a specified FOV (for example, an FOV of 5°×5°).

The plurality of LCPGs and the quarter-wave plate are used to implement beam scanning.

The receive end and the transmit end share the plurality of LCPGs and the quarter-wave plate. The beam selection device of the receive end includes a quarter-wave plate, an electrically controlled half-wave plate, and a polarizer. The receiving lens group of the receive end may be a single lens or a combination of a plurality of lenses. The sensor of the receive end is a single-photon avalanche diode (SPAD) array. Because the SPAD has single-photon detection sensitivity, a detection distance of a Lidar system can be increased.

For the TOF depth sensing module 500, a polarization selection device of the transmit end is transferred to the receive end. As shown in FIG. 76, a laser beam emitted by a common VCSEL array light source is not in a fixed polarization state, and may be decomposed into a linearly polarized laser beam parallel to paper and a linearly polarized laser beam perpendicular to the paper. After passing through the LCPG, the linearly polarized laser beam is split into two laser beams that are in different polarization states (left-handed circular polarization and right-handed circular polarization) and that separately have different emergent angles. After passing through the quarter-wave plate, corresponding polarization states of the two laser beams are converted into linearly polarized light parallel to the paper and linearly polarized light perpendicular to the paper. Reflected beams generated after the two laser beams in different polarization states are irradiated to an object in a target region are received by the quarter-wave plate and the LCPG that are shared with the transmit end, and then become laser beams that have a same divergence angle but different polarization states, namely, left-handed circularly polarized light and right-handed circularly polarized light. The beam selection device of the receive end includes a quarter-wave plate, an electrically controlled half-wave plate, and a polarizer. After received light passes through the quarter-wave plate, a polarization state of the received light is converted into linearly polarized light parallel to the paper and linearly polarized light perpendicular to the paper. In this way, the electrically controlled half-wave plate is controlled through time division, so that a polarization state of the linearly polarized light is rotated by 90 degrees or a polarization state passing through the half-wave plate is not changed, and the linearly polarized light parallel to the paper and the linearly polarized light perpendicular to the paper are transmitted through time division. In addition, light in another polarization state is absorbed or scattered.

Compared with an existing TOF depth sensing module in which a polarization selection device is located at a transmit end, in this application, because the polarization selection device is located at the receive end, energy absorbed or scattered by the polarizer is significantly reduced. It is assumed that a detection distance is R meters, a reflectivity of a target object is p, and an entrance pupil diameter of a receiving system is D. In this case, when receiving FOV is the same, incident energy $P_t$ of the polarization selection device in the TOF depth sensing module 500 in this embodiment of this application is as follows:

$$P_t = \frac{\pi D^2 \rho}{2\pi R^2} P$$

P is energy emitted by the transmit end, and energy can be reduced by about $10^4$ times at a distance of 1 m.

In addition, it is assumed that non-polarized light sources with a same power are used for the TOF depth sensing module 500 in this embodiment of this application and the conventional TOF depth sensing module. Light of the TOF depth sensing module 500 in this embodiment of this application in outdoors is non-polarized, and half of light entering a receiving detector is absorbed or scattered. Light of the TOF depth sensing module in the conventional solution in outdoors all enters the detector. Therefore, a signal-to-noise ratio in this embodiment of this application is doubled in a same case.

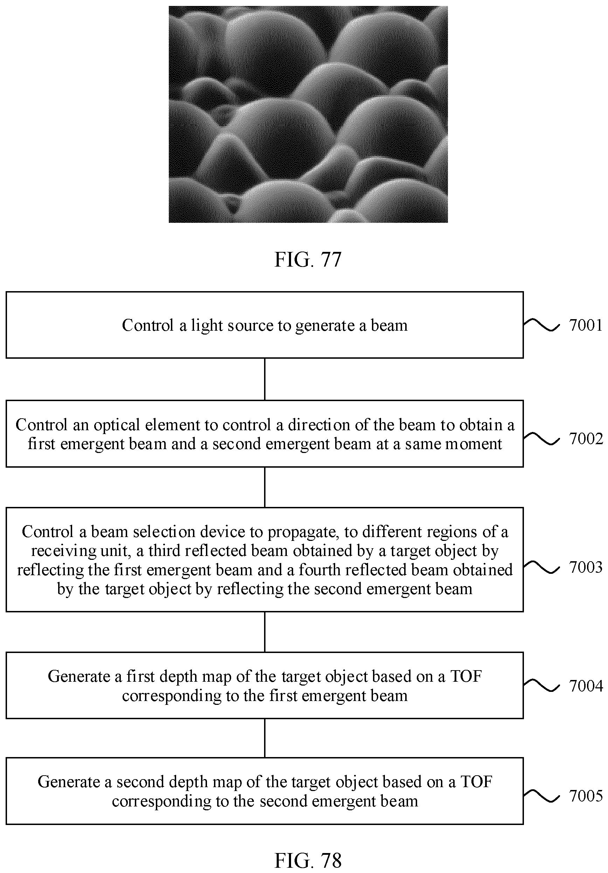

Based on the TOF depth sensing module 500 shown in FIG. 76, the diffractive optical element diffuser (DOE Diffuser) following the VCSEL array light source may be further changed to a microlens diffuser (Diffuser). Because the microlens diffuser implements homogenization based on geometrical optics, transmission efficiency of the microlens diffuser may be at least 80%, and transmission efficiency of a conventional diffractive optical element diffuser (DOE Diffuser) is only about 70%. A morphology of the microlens diffuser is shown in FIG. 77. The microlens diffuser includes a series of randomly distributed microlenses. A location and a morphology of each microlens are designed through simulation and optimization, so that a shaped beam is as uniform as possible, and transmission efficiency is high.

FIG. 78 is a schematic flowchart of an image generation method according to an embodiment of this application.

The method shown in FIG. 78 may be performed by the TOF depth sensing module or a terminal device including the TOF depth sensing module in the embodiments of this application. Specifically, the method shown in FIG. 78 may be performed by the TOF depth sensing module shown in FIG. 71 or a terminal device including the TOF depth sensing module shown in FIG. 71. The method shown in FIG. 78 includes step 7001 to step 7006. The following separately describes the steps in detail.

7001. Control a light source to generate a beam.

7002. Control an optical element to control a direction of the beam to obtain a first emergent beam and a second emergent beam.

7003. Control a beam selection device to propagate, to different regions of a receiving unit, a third reflected beam obtained by a target object by reflecting the first emergent beam and a fourth reflected beam obtained by the target object by reflecting the second emergent beam.

7004. Generate a first depth map of the target object based on a TOF corresponding to the first emergent beam.

7005. Generate a second depth map of the target object based on a TOF corresponding to the second emergent beam.

An emergent direction of the first emergent beam and an emergent direction of the second emergent beam are different, and a polarization direction of the first emergent beam is orthogonal to a polarization direction of the second emergent beam.

In this embodiment of this application, because a transmit end does not have a polarization filtering device, a beam emitted by a light source may arrive at the optical element almost without a loss (the polarization filtering device generally absorbs much light energy, and generates a heat loss), so that a heat loss of a terminal device can be reduced.

Optionally, the method shown in FIG. 78 further includes: splicing the first depth map and the second depth map to obtain a depth map of the target object.

It should be understood that, in the method shown in FIG. 78, a third depth map, a fourth depth map, and the like may be further generated in a similar manner. Next, all depth maps may be spliced or combined to obtain the final depth map of the target object.

Optionally, the terminal device further includes a collimation lens group. The collimation lens group is disposed between the light source and the optical element. The method shown in FIG. 78 further includes:

7006. Perform collimation processing on the beam by using the collimation lens group, to obtain a beam obtained after collimation processing is performed.

The foregoing step 7002 specifically includes: controlling the optical element to control a direction of the beam obtained after collimation processing is performed, to obtain the first emergent beam and the second emergent beam.

In addition, an approximately parallel beam can be obtained by performing collimation processing on a beam by using the collimation lens group, so that a power density of the beam can be improved, and an effect of subsequently performing scanning by using the beam can be improved.

Optionally, the terminal device further includes a homogenizer. The homogenizer is disposed between the light source and the optical element. The method shown in FIG. 78 further includes:

7007. Adjust energy distribution of the beam by using the homogenizer, to obtain a beam obtained after homogenization processing is performed.

The foregoing step 7002 specifically includes: controlling the optical element to control a direction of the beam obtained after homogenization processing is performed, to obtain the first emergent beam and the second emergent beam.

Through homogenization processing, an optical power of a beam can be distributed in angle space more uniformly or according to a specified rule, to prevent a local optical power from being excessively small, and avoid blind spots in a finally obtained depth map of a target object.

Based on the foregoing step 7001 to step 7005, the method shown in FIG. 78 may further include step 7006 or step 7007.

Alternatively, based on the foregoing step 7001 to step 7005, the method shown in FIG. 78 may further include step 7006 and step 7007. In this case, after step 7001 is performed, step 7006 may be performed before step 7007, and then step 7002 is performed. Alternatively, step 7007 may be performed before step 7006, and then step 7002 is performed. In other words, after the light source in step 7001 generates a beam, collimation processing and homogenization processing (energy distribution of the beam is adjusted by using the homogenizer) may be first performed on the beam successively, and then the optical element is controlled to control a direction of the beam. Alternatively, after the light source in step 7001 generates a beam, homogenization processing (energy distribution of the beam is adjusted by using the homogenizer) and collimation processing may be first performed on the beam successively, and then the optical element is controlled to control a direction of the beam.

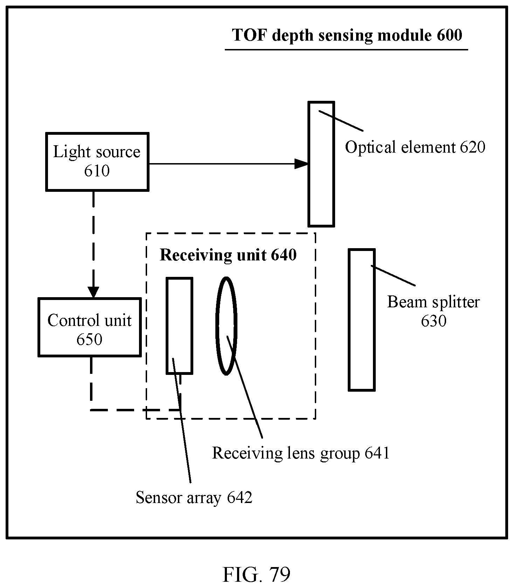

The foregoing describes in detail a TOF depth sensing module and an image generation method in the embodiments of this application with reference to FIG. 70 to FIG. 78. The following describes in detail another TOF depth sensing module and another image generation method in the embodiments of this application with reference to FIG. 79 to FIG. 88.

Due to excellent polarization and phase adjustment capabilities of a liquid crystal device, the liquid crystal device is widely used in the TOF depth sensing module to implement beam deflection. However, due to a birefringence characteristic of a liquid crystal material, in an existing TOF depth sensing module in which the liquid crystal device is used, a polarizer is generally added to a transmit end to emit polarized light. In a process of emitting the polarized light, due to a polarization selection function of the polarizer, half of energy is lost when the beam is emitted. The part of lost energy is absorbed by the polarizer or scattered and converted into heat. Consequently, a temperature of the TOF depth sensing module rises, and stability of the TOF depth sensing module is affected. Therefore, how to reduce a heat loss of the TOF depth sensing module and improve a signal-to-noise ratio of the TOF depth sensing module is a problem that needs to be resolved.

This application provides a new TOF depth sensing module, to reduce a heat loss of a system by transferring a polarizer from a transmit end to a receive end, and improve a signal-to-noise ratio of the system relative to background straylight.

The following first briefly describes the TOF depth sensing module in the embodiments of this application with reference to FIG. 79.

A TOF depth sensing module 600 shown in FIG. 79 includes a light source 610, an optical element 620, a beam splitter 630, a receiving unit 640, and a control unit 650.

The following describes in detail the modules or units in the TOF depth sensing module 600.

Light source 610:

The light source 610 is configured to generate a beam.

Optionally, the light source 610 is a vertical cavity surface emitting laser (vertical cavity surface emitting laser, VCSEL).

Optionally, the light source 610 is a Fabry-Perot laser (which may be briefly referred to as an FP laser).

Compared with a single VCSEL, a single FP laser may implement a larger power, and has higher electrooptic conversion efficiency than the VCSEL, so that a scanning effect of the TOF depth sensing module can be improved.

Optionally, a wavelength of the beam emitted by the light source 610 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of the beam emitted by the light source 610 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

Optionally, a light emitting area of the light source 610 is less than or equal to $5 \times 5$ mm$^2$.

Because a size of the light source is small, the TOF depth sensing module that includes the light source is easy to be integrated into a terminal device, so that space occupied in the terminal device can be reduced to an extent.

Optical element 620:

The optical element 620 is disposed in an emergent direction of the beam, and the optical element 620 is configured to control a direction of the beam to obtain a first emergent beam and a second emergent beam. An emergent direction of the first emergent beam is different from an emergent direction of the second emergent beam, and a polarization direction of the first emergent beam is orthogonal to a polarization direction of the second emergent beam.

Optionally, as shown in FIG. 35, the optical element 620 may include a horizontal polarization control sheet, a horizontal liquid crystal polarization grating, a vertical polarization control sheet, and a vertical liquid crystal polarization grating. Distances between the light source and all of the horizontal polarization control sheet, the horizontal liquid crystal polarization grating, the vertical polarization control sheet, and the vertical liquid crystal polarization grating are successively increased.

Alternatively, in the optical element 620, distances between the light source and all of the vertical polarization control sheet, the vertical liquid crystal polarization grating, the horizontal polarization control sheet, and the horizontal liquid crystal polarization grating are successively increased.

Receiving unit 640:

The receiving unit 640 may include a receiving lens group 641 and a sensor 642.

Beam splitter 630:

The beam splitter 630 is configured to transmit, to different regions of the sensor, a third reflected beam obtained by a target object by reflecting a first emergent beam and a fourth reflected beam obtained by the target object by reflecting a second emergent beam.

The beam splitter is a passive selection device, is generally not controlled by the control unit, and can respectively propagate, to different regions of the receiving unit, beams in different polarization states in beams in hybrid polarization states.

Optionally, the beam splitter is implemented based on any one of a liquid crystal polarization grating LCPG, a polarization beam splitter PBS, and a polarization filter.

In this application, a polarizer is transferred from a transmit end to a receive end, so that a heat loss of a system can be reduced. In addition, the beam splitter is disposed at the receive end, so that a signal-to-noise ratio of the TOF depth sensing module can be improved.

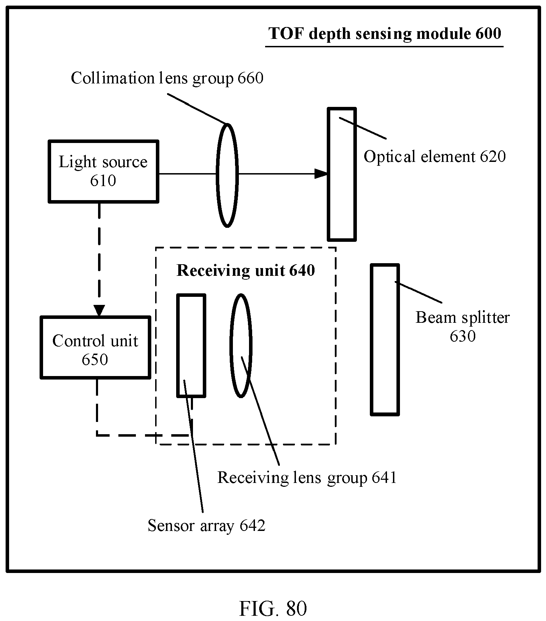

As shown in FIG. 80, the TOF depth sensing module 600 may further include a collimation lens group 660, where the collimation lens group 660 is disposed in an emergent direction of a beam, the collimation lens group 660 is disposed between the light source 610 and the optical element 620, the collimation lens group 660 is configured to perform collimation processing on the beam to obtain a beam obtained after collimation processing is performed, and when the collimation lens group 660 is disposed between the light source 610 and the optical element 620, the optical element 620 is configured to control a direction of the beam obtained after collimation processing is performed, to obtain a first emergent beam and a second emergent beam.

An approximately parallel beam can be obtained by performing collimation processing on a beam by using the collimation lens group, so that a power density of the beam can be improved, and an effect of subsequently performing scanning by using the beam can be improved.

Optionally, a clear aperture of the collimation lens group is less than or equal to 5 mm.

Because a size of the collimation lens group is small, the TOF depth sensing module that includes the collimation lens group is easy to be integrated into a terminal device, so that space occupied in the terminal device can be reduced to an extent.

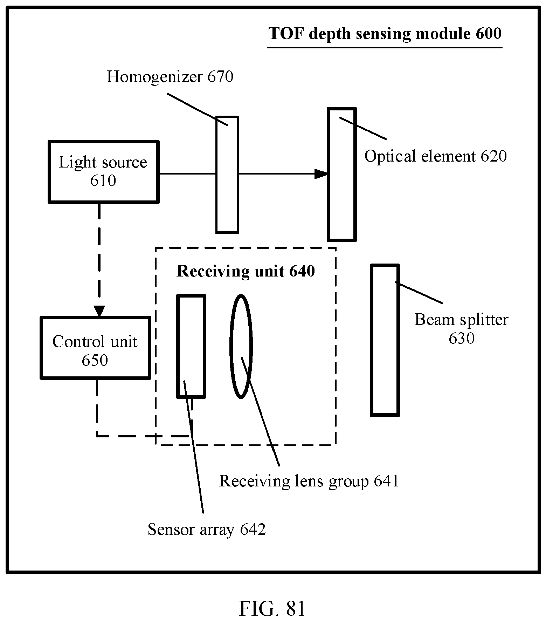

As shown in FIG. 81, the TOF depth sensing module 600 may further include:

a homogenizer 670, where the homogenizer 670 is disposed in an emergent direction of a beam, the homogenizer 670 is disposed between the light source and the optical element, the homogenizer 670 is configured to adjust energy distribution of a beam to obtain a homogenized beam, and when the homogenizer 670 is disposed between the light source 610 and the optical element 620, the optical element 620 is configured to control a direction of the homogenized beam, to obtain a first emergent beam and a second emergent beam.

Optionally, the homogenizer may be a microlens diffuser or a diffractive optical element diffuser.

It should be understood that the TOF depth sensing module 600 may include both the collimation lens group 660 and the homogenizer 670. Both the collimation lens group 660 and the homogenizer 670 may be located between the light source 610 and the optical element 620. For the collimation lens group 660 and the homogenizer 670, either the collimation lens group 660 may be closer to the light source or the homogenizer 670 may be closer to the light source.

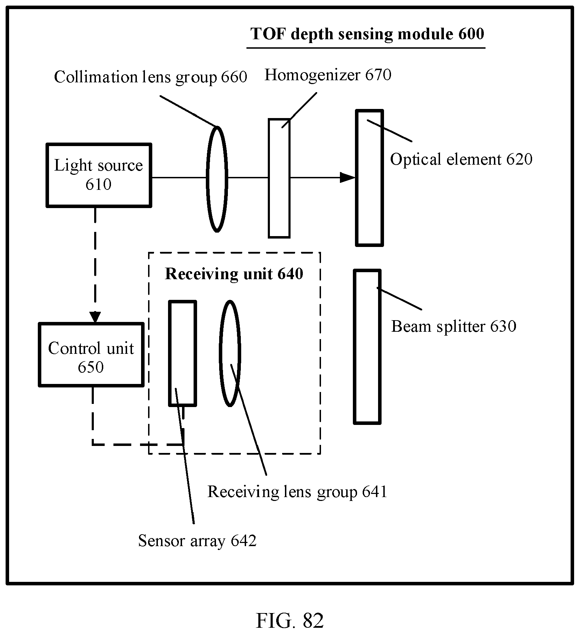

As shown in FIG. 82, a distance between the collimation lens group 660 and the light source 610 is less than a distance between the homogenizer 670 and the light source 610.

In the TOF depth sensing module 600 shown in FIG. 82, a beam emitted by the light source 610 is first subject to collimation processing of the collimation lens group 660, is subject to homogenization processing of the homogenizer 670, and then is propagated to the optical element 620 for processing.

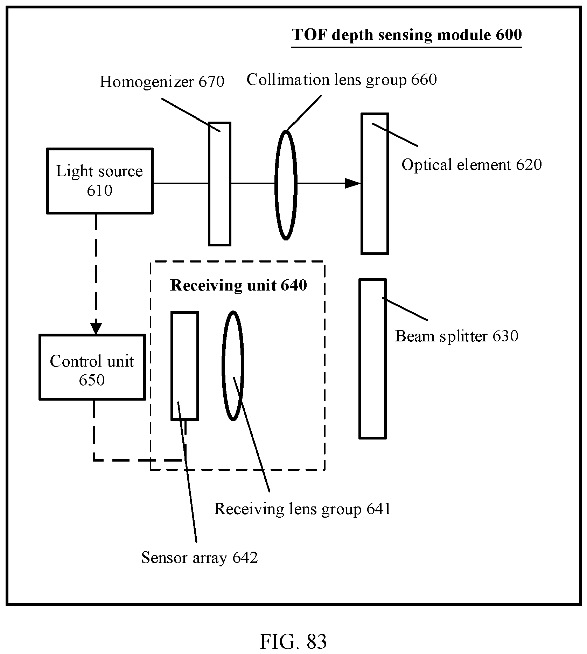

As shown in FIG. 83, a distance between the collimation lens group 660 and the light source 610 is greater than a distance between the homogenizer 670 and the light source 610.

In the TOF depth sensing module 600 shown in FIG. 83, a beam emitted by the light source 610 is first subject to homogenization processing of the homogenizer 670, is subject to collimation processing of the collimation lens group 660, and then is propagated to the optical element 620 for processing.

The following describes in detail a specific structure of the TOF depth sensing module 600 with reference to the accompanying drawings.

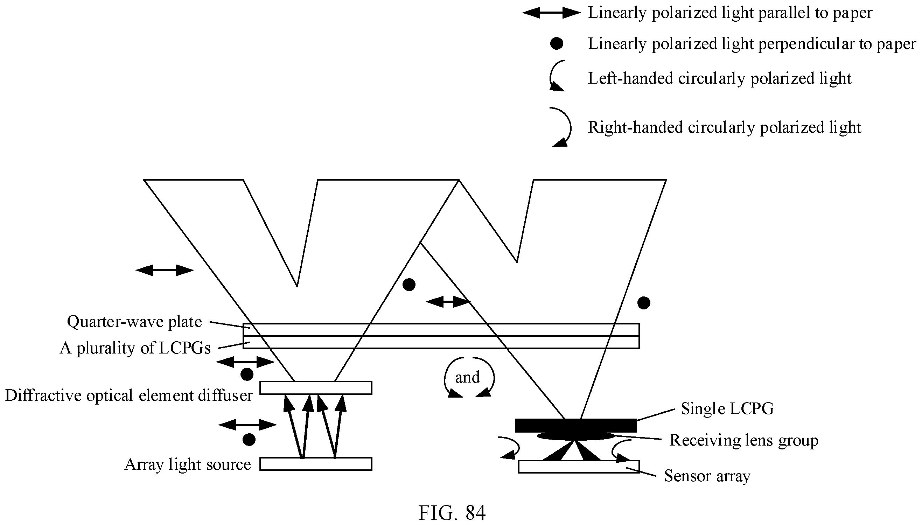

FIG. 84 is a schematic diagram of a structure of a TOF depth sensing module 600 according to an embodiment of this application.

As shown in FIG. 84, the TOF depth sensing module 600 includes a projection end and a receive end. A light source of the projection end is a VCSEL light source. A homogenizer is a diffractive optical element diffuser (DOE Diffuser). A beam element is a plurality of LCPGs and a quarter-wave plate. Each LCPG includes an electrically controlled horizontal LCPG device and an electrically controlled vertical LCPG device. Two-dimensional block scanning in a horizontal direction and a vertical direction may be implemented by using the plurality of LCPGs that are cascaded.

A wavelength of the VCSEL array light source may be greater than 900 nm. Specifically, the wavelength of the VCSEL array light source may be 940 nm or 1650 nm.

When the wavelength of the VCSEL array light source may be 940 nm or 1650 nm, intensity of a solar spectrum is low. This helps reduce noise caused by sun light in an outdoor scenario.

A laser beam emitted by the VCSEL array light source may be continuous light or pulse light. The VCSEL array light source may also be divided into several blocks to implement control through time division, so that different regions are lit through time division.

The diffractive optical element diffuser is used to shape a beam emitted by the VCSEL array light source into a uniform square or rectangular light source with a specified FOV (for example, an FOV of 5°×5°).

The plurality of LCPGs and the quarter-wave plate are used to implement beam scanning.

The receive end and the transmit end share the plurality of LCPGs and the quarter-wave plate. The receiving lens group of the receive end may be a single lens or a combination of a plurality of lenses. The sensor of the receive end is a single-photon avalanche diode (SPAD) array. Because the SPAD has single-photon detection sensitivity, a detection distance of the TOF depth sensing module 600 can be increased. The receive end includes a beam splitter. The beam splitter is implemented by using a single LCPG. At a same moment, the projection end projects light in two polarization states to different FOV ranges, and then the light passes through the plurality of LCPGs at the receive end to be converged into a same beam of light. Then, the beam of light is split by the beam splitter into two beams of light in different directions based on the different polarization states, and is projected to different locations of the SPAD array.

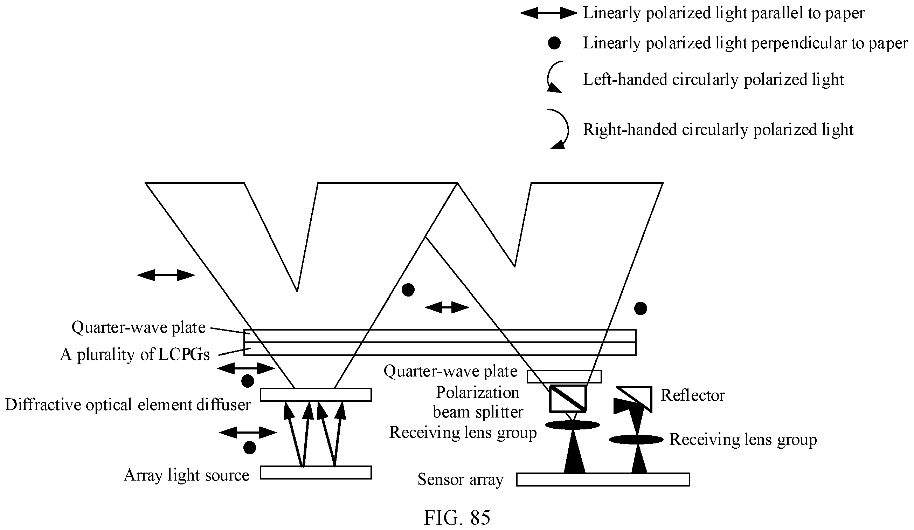

FIG. 85 is a schematic diagram of a structure of a TOF depth sensing module 600 according to an embodiment of this application.

A difference between the TOF depth sensing module 600 shown in FIG. 85 and the TOF depth sensing module 600 shown in FIG. 84 lies in that, in FIG. 84, the beam splitter is implemented by using the single LCPG, while in FIG. 85, the beam splitter is implemented by using a polarization beam splitter, and the polarization beam splitter is generally formed by gluing edges and angles of coatings. Because the polarization beam splitter is an existing product, the polarization beam splitter brings a specific cost advantage when being used as the beam splitter.

As shown in FIG. 85, beams that are in two orthogonal polarization states and that are obtained through reflection are split by the polarization beam splitter. One beam is directly transmitted to an SPAD array sensor, and the other beam is reflected by another reflector to the SPAD array sensor after being reflected.

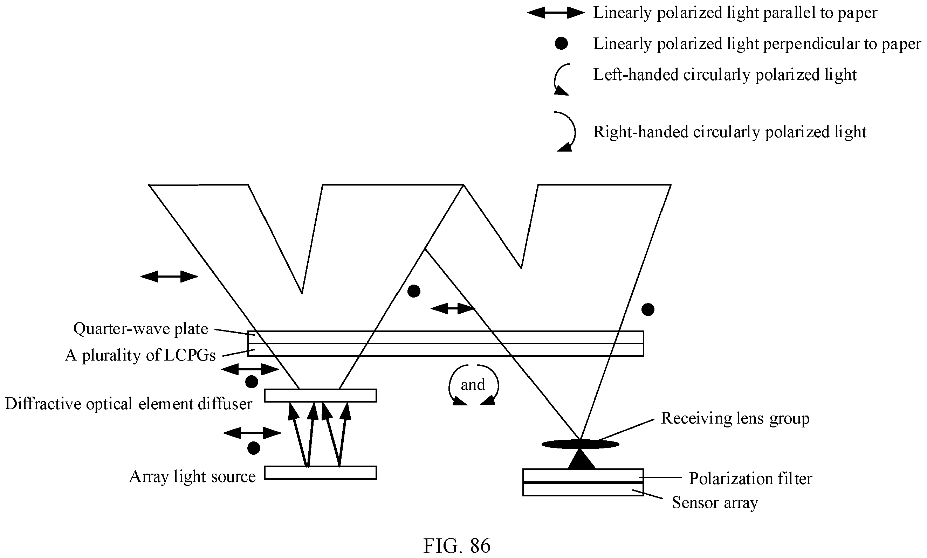

FIG. 86 is a schematic diagram of a structure of a TOF depth sensing module according to an embodiment of this application.

A difference from the TOF depth sensing module 600 shown in FIG. 84 lies in that, in FIG. 86, the beam splitter is implemented by using a polarization filter. For example, in FIG. 86, the beam splitter may be implemented by using a quarter-wave plate.

The polarization filter performs processing similar to pixel drawing. Transmittable polarization states on adjacent pixels are different, and each correspond to an SPAD pixel. In this way, an SPAD sensor can simultaneously receive information in two polarization states.

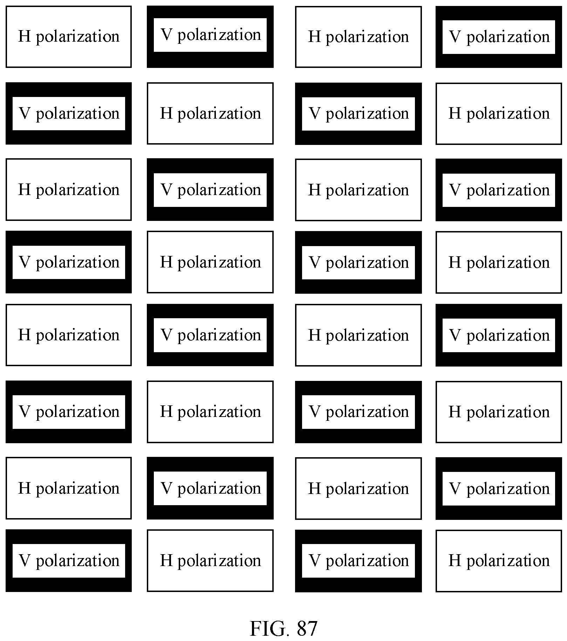

FIG. 87 is a schematic diagram of a received polarized beam of a polarization filter.

As shown in FIG. 87, different regions of the polarization filter may allow H polarization or V polarization, where the H polarization represents polarization in a horizontal direction, and the V polarization represents polarization in a vertical direction. In FIG. 87, different regions of the polarization filter allow only a beam in a corresponding polarization state to arrive at a corresponding location of a sensor. For example, the H polarization allows only a horizontally polarized beam to arrive at a corresponding location of the sensor, and the V polarization allows only a vertically polarized beam to arrive at a corresponding location of the sensor.

When the beam splitter is implemented by using the polarization filter, because the polarization filter is thin and small in size, it is convenient to integrate the polarization filter into a terminal device with a small size.

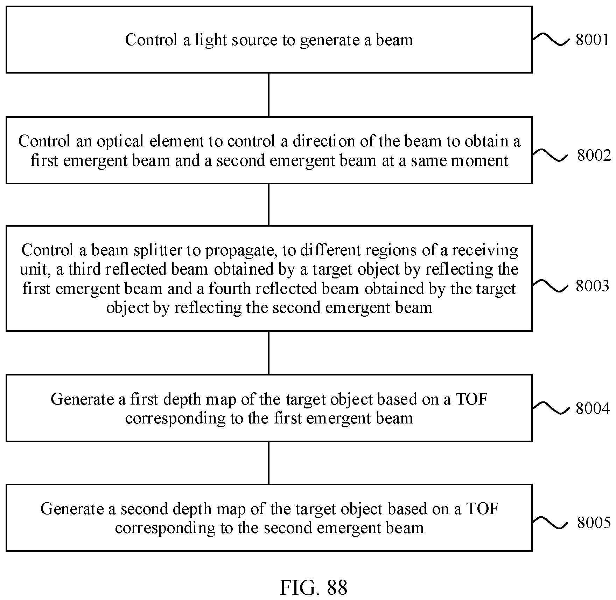

FIG. 88 is a schematic flowchart of an image generation method according to an embodiment of this application.

The method shown in FIG. 88 may be performed by the TOF depth sensing module or a terminal device including the TOF depth sensing module in the embodiments of this application. Specifically, the method shown in FIG. 88 may be performed by the TOF depth sensing module shown in FIG. 79 or a terminal device including the TOF depth sensing module shown in FIG. 79. The method shown in FIG. 88 includes step 8001 to step 8006. The following separately describes the steps in detail.

8001. Control a light source to generate a beam.

8002. Control an optical element to control a direction of the beam to obtain a first emergent beam and a second emergent beam.

An emergent direction of the first emergent beam is different from an emergent direction of the second emergent beam, and a polarization direction of the first emergent beam is orthogonal to a polarization direction of the second emergent beam.

8003. Control a beam splitter to propagate, to different regions of a receiving unit, a third reflected beam obtained by a target object by reflecting the first emergent beam and a fourth reflected beam obtained by the target object by reflecting the second emergent beam.

8004. Generate a first depth map of the target object based on a TOF corresponding to the first emergent beam.

8005. Generate a second depth map of the target object based on a TOF corresponding to the second emergent beam.

A process of the method shown in FIG. 88 is the same as a basic process of the method shown in FIG. 78, and a main difference lies in that in step 7003 of the method shown in FIG. 78, the third reflected beam and the fourth reflected beam are propagated to the different regions of the receiving unit by using the beam selection device. However, in step 8003 of the method shown in FIG. 88, the third reflected beam and the fourth reflected beam are propagated to the different regions of the receiving unit by using the beam splitter.

In this embodiment of this application, because a transmit end does not have a polarization filtering device, the beam emitted by the light source may arrive at the optical element almost without a loss (the polarization filtering device generally absorbs much light energy, and generates a heat loss), so that a heat loss of a terminal device can be reduced.

Optionally, the method shown in FIG. 88 further includes: splicing the first depth map and the second depth map to obtain a depth map of the target object.

It should be understood that, in the method shown in FIG. 88, a third depth map, a fourth depth map, and the like may be further generated in a similar manner. Next, all depth maps may be spliced or combined to obtain the final depth map of the target object.

Optionally, the terminal device further includes a collimation lens group. The collimation lens group is disposed between the light source and the optical element. The method shown in FIG. 88 further includes:

8006. Perform collimation processing on the beam by using the collimation lens group, to obtain a beam obtained after collimation processing is performed.

The foregoing step 8002 specifically includes: controlling the optical element to control a direction of the beam obtained after collimation processing is performed, to obtain the first emergent beam and the second emergent beam.

In addition, an approximately parallel beam can be obtained by performing collimation processing on a beam by using the collimation lens group, so that a power density of the beam can be improved, and an effect of subsequently performing scanning by using the beam can be improved.

Optionally, the terminal device further includes a homogenizer. The homogenizer is disposed between the light source and the optical element. The method shown in FIG. 88 further includes:

8007. Adjust energy distribution of the beam by using the homogenizer, to obtain a beam obtained after homogenization processing is performed.

The foregoing step 8002 of controlling an optical element to control a direction of the beam to obtain a first emergent beam and a second emergent beam specifically includes: controlling the optical element to control a direction of the beam obtained after homogenization processing is performed, to obtain the first emergent beam and the second emergent beam.

Through homogenization processing, an optical power of a beam can be distributed in angle space more uniformly or according to a specified rule, to prevent a local optical power from being excessively small, and avoid a blind spot in the finally obtained depth map of the target object.

Based on the foregoing step 8001 to step 8005, the method shown in FIG. 88 may further include step 8006 or step 8007.

Alternatively, based on the foregoing step 8001 to step 8005, the method shown in FIG. 88 may further include step 8006 and step 8007. In this case, after step 8001 is performed, step 8006 may be performed before step 8007, and then step 8002 is performed. Alternatively, step 8007 may be performed before step 8006, and then step 8002 is performed. In other words, after the light source in step 8001 generates a beam, collimation processing and homogenization processing (energy distribution of the beam is adjusted by using the homogenizer) may be first performed on the beam successively, and then the optical element is controlled to control a direction of the beam. Alternatively, after the light source in step 8001 generates a beam, homogenization processing (energy distribution of the beam is adjusted by using the homogenizer) and collimation processing may be first performed on the beam successively, and then the optical element is controlled to control a direction of the beam.

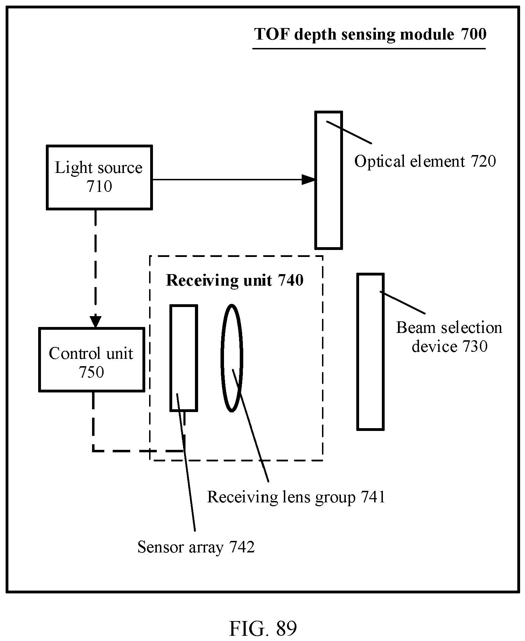

The foregoing describes in detail a TOF depth sensing module and an image generation method in the embodiments of this application with reference to FIG. 79 to FIG. 88. The following describes in detail another TOF depth sensing module and another image generation method in the embodiments of this application with reference to FIG. 89 to FIG. 101.

Due to excellent polarization and phase adjustment capabilities of a liquid crystal device, the liquid crystal device is usually used in a TOF depth sensing module to control a beam. However, due to a limitation of a liquid crystal material, a response time of the liquid crystal device is limited to some extent, and is usually in a millisecond order. Therefore, a scanning frequency of the TOF depth sensing module using the liquid crystal device is low (usually less than 1 kHz).

This application provides a new TOF depth sensing module. Time sequences of drive signals of electronically controlled liquid crystals of a transmit end and a receive end are controlled to be staggered by specific time (for example, half a period), to increase a scanning frequency of a system.

The following first briefly describes the TOF depth sensing module in the embodiments of this application with reference to FIG. 89.

A TOF depth sensing module 700 shown in FIG. 89 includes a light source 710, an optical element 720, a beam selection device 730, a receiving unit 740, and a control unit 750.

A function of each module or unit in the TOF depth sensing module is specifically as follows:

Light source 710:

The light source 710 is configured to generate a beam.

Optionally, the light source 710 is a vertical cavity surface emitting laser (vertical cavity surface emitting laser, VCSEL).

Optionally, the light source 710 is a Fabry-Perot laser (which may be briefly referred to as an FP laser).

Compared with a single VCSEL, a single FP laser may implement a larger power, and has higher electrooptic conversion efficiency than the VCSEL, so that a scanning effect of the TOF depth sensing module can be improved.

Optionally, a wavelength of the beam emitted by the light source 710 is greater than 900 nm.

Intensity of light greater than 900 nm in sun light is low. Therefore, when the wavelength of the beam is greater than 900 nm, it helps reduce interference caused by the sun light, so that the scanning effect of the TOF depth sensing module can be improved.

Optionally, a wavelength of the beam emitted by the light source 710 is 940 nm or 1550 nm.

Intensity of light near 940 nm or 1550 nm in sun light is low. Therefore, when the wavelength of the beam is 940 nm or 1550 nm, interference caused by the sun light can be greatly reduced, so that the scanning effect of the TOF depth sensing module can be improved.

Optionally, a light emitting area of the light source 710 is less than or equal to $5 \times 5$ mm$^2$.

Because a size of the light source is small, the TOF depth sensing module that includes the light source is easy to be integrated into a terminal device, so that space occupied in the terminal device can be reduced to an extent.

Optionally, an average output optical power of the TOF depth sensing module 700 is less than 800 mw.

When the average output optical power of the TOF depth sensing module is less than or equal to 800 mw, power consumption of the TOF depth sensing module is small, to help dispose the TOF depth sensing module in a device that is sensitive to power consumption, for example, a terminal device.

Optical element 720:

The optical element 720 is disposed in a direction in which the light source emits a beam. The optical element 720 is configured to deflect the beam under control of the control unit 750, to obtain an emergent beam.

Beam selection device 730:

The beam selection device 730 is configured to select a beam in at least two polarization states from beams in each period of reflected beams of a target object under control of the control unit 750, to obtain a received beam, and transmit the received beam to a receiving unit 740.

The emergent beam is a beam that changes periodically. A value of a change period of the emergent beam is a first time interval. In the emergent beam, beams in adjacent periods have different tilt angles, beams in a same period have at least two polarization states, and the beams in the same period have a same tilt angle and different azimuths.

In this embodiment of this application, the direction and the polarization state of the beam emitted by the light source are adjusted by using the optical element and the beam selection device, so that emergent beams in adjacent periods have different tilt angles, and beams in a same period have at least two polarization states, to increase a scanning frequency of the TOF depth sensing module.

In this application, time sequences of control signals of a transmit end and a receive end are controlled by the control unit to be staggered by specific time, to increase a scanning frequency of the TOF depth sensing module.

Optionally, as shown in FIG. 35, the optical element 720 includes a horizontal polarization control sheet, a horizontal liquid crystal polarization grating, a vertical polarization control sheet, and a vertical liquid crystal polarization grating. Distances between the light source and all of the horizontal polarization control sheet, the horizontal liquid crystal polarization grating, the vertical polarization control sheet, and the vertical liquid crystal polarization grating are successively increased.

Alternatively, in the optical element 720, distances between the light source and all of the vertical polarization control sheet, the vertical liquid crystal polarization grating, the horizontal polarization control sheet, and the horizontal liquid crystal polarization grating are successively increased.

Optionally, the beam selection device includes a quarter-wave plate, an electrically controlled half-wave plate, and a polarizer.

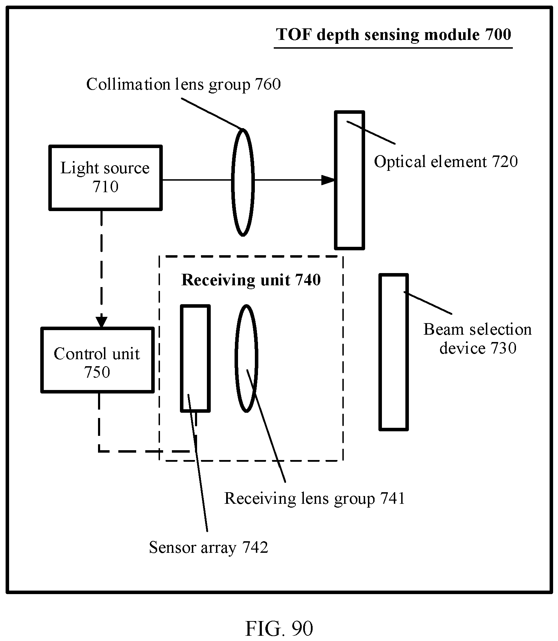

As shown in FIG. 90, the TOF depth sensing module may further include a collimation lens group 760. The collimation lens group 760 is disposed between the light source 710 and the optical element 720. The collimation lens group 760 is configured to perform collimation processing on a beam. The optical element 720 is configured to deflect, under control of the control unit 750, the beam obtained after the collimation lens group performs collimation processing, to obtain an emergent beam.

When the TOF depth sensing module includes the collimation lens group, an approximately parallel beam can be obtained by first performing collimation processing on a beam, emitted by the light source, by using the collimation lens group, so that a power density of the beam can be improved, and an effect of subsequently performing scanning by using the beam can be improved.

Optionally, a clear aperture of the collimation lens group is less than or equal to 5 mm.

Because a size of the collimation lens group is small, the TOF depth sensing module that includes the collimation lens group is easy to be integrated into a terminal device, so that space occupied in the terminal device can be reduced to an extent.

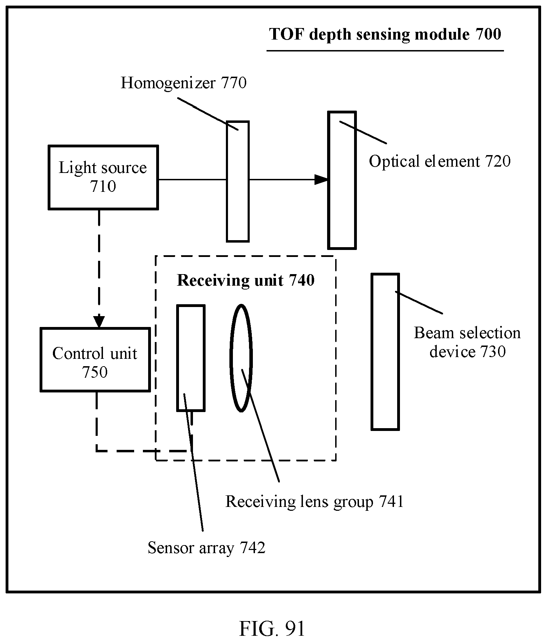

As shown in FIG. 91, the TOF depth sensing module 700 further includes a homogenizer 770. The homogenizer 770 is disposed between the light source 710 and the optical element 720. The homogenizer 770 is configured to adjust angular spatial intensity distribution of a beam. The optical element 720 is configured to control, under control of the control unit 750, a direction of a beam obtained after the homogenizer 720 performs homogenization processing, to obtain an emergent beam.

Optionally, the homogenizer 770 is a microlens diffuser or a diffractive optical element diffuser.

Through homogenization processing, an optical power of a beam can be distributed in angle space more uniformly or according to a specified rule, to prevent a local optical power from being excessively small, and avoid a blind spot in a finally obtained depth map of the target object.

It should be understood that the TOF depth sensing module 700 may include both the collimation lens group 760 and the homogenizer 770. Both the collimation lens group 760 and the homogenizer 770 may be located between the light source 710 and the optical element 720. For the collimation lens group 760 and the homogenizer 770, either the collimation lens group 760 may be closer to the light source or the homogenizer 770 may be closer to the light source.

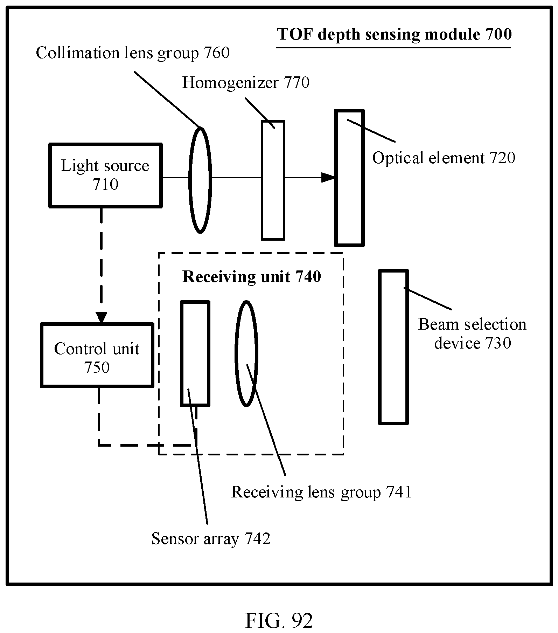

FIG. 92 is a schematic diagram of a specific structure of a TOF depth sensing module according to an embodiment of this application.

As shown in FIG. 92, a distance between the collimation lens group 760 and the light source 710 is less than a distance between the homogenizer 770 and the light source 710.

In the TOF depth sensing module 700 shown in FIG. 92, a beam emitted by the light source 710 is first subject to collimation processing of the collimation lens group 760, is subject to homogenization processing of the homogenizer 770, and then is propagated to the optical element 720 for processing.

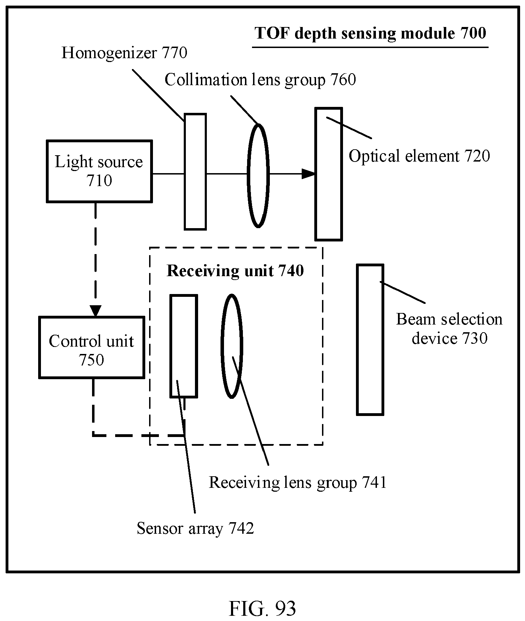

FIG. 93 is a schematic diagram of a specific structure of a TOF depth sensing module according to an embodiment of this application.

As shown in FIG. 93, a distance between the collimation lens group 760 and the light source 710 is greater than a distance between the homogenizer 770 and the light source 710.

In the TOF depth sensing module 700 shown in FIG. 93, a beam emitted by the light source 710 is first subject to homogenization processing of the homogenizer 770, is subject to collimation processing of the collimation lens group 760, and then is propagated to the optical element 720 for processing.

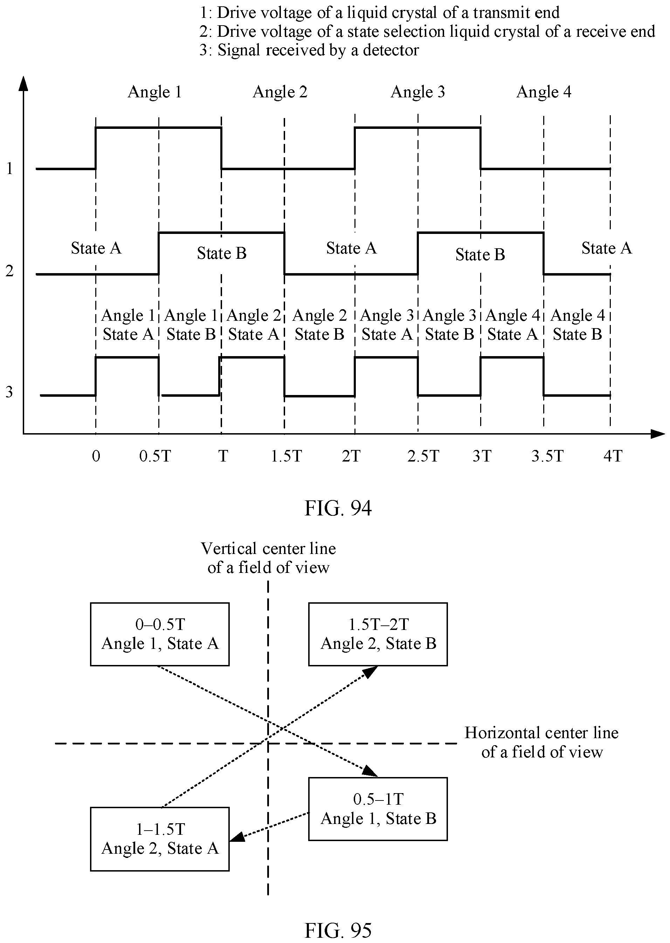

The following describes a working process of the TOF depth sensing module 700 with reference to FIG. 94 and FIG. 95.

As shown in FIG. 94, assuming that highest frequencies of electrically controlled devices of a transmit end and a receive end of the TOF depth sensing module 700 are both 1/T, control time sequences of the transmit end and the receive end are staggered by the control unit by half a period (0.5T). In this case, a sensor of the receive end can receive beams at different spatial locations at an interval of 0.5T.

As shown in FIG. 95, in 0T to 0.5T, the sensor of the receive end receives a beam at an angle 1 and in a state A; in 0.5T to T, the sensor of the receive end receives a beam at an angle 1 and in a state B; in T to 1.5T, the sensor of the receive end receives a beam at an angle 2 and in a state A; and in 1.5T to 2T, the sensor of the receive end receives a beam at an angle 2 and in a state B. In this way, a scanning frequency of a system is doubled from 1/T to 2/T.

The following describes in detail a specific structure of the TOF depth sensing module 700 with reference to the accompanying drawings.

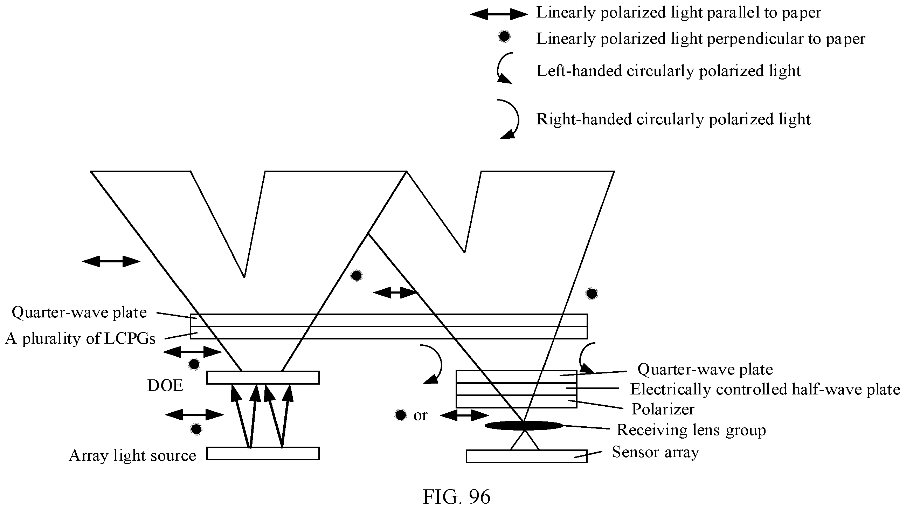

FIG. 96 is a schematic diagram of a structure of a TOF depth sensing module 700 according to an embodiment of this application.

As shown in FIG. 96, the TOF depth sensing module 700 includes a projection end, a receive end, and a control unit. The projection end includes a light source, a homogenizer, and an optical element. The receive end includes an optical element, a beam selection device, a receiving lens group, and a two-dimensional sensor. The control unit is configured to control the projection end and the receive end to complete beam scanning.

A light source of the projection end is a VCSEL light source. The homogenizer is a diffractive optical element diffuser (DOE Diffuser). A beam element is a plurality of LCPGs and a quarter-wave plate. Each LCPG includes an electrically controlled horizontal LCPG device and an electrically controlled vertical LCPG device. Two-dimensional block scanning in a horizontal direction and a vertical direction may be implemented by using the plurality of LCPGs that are cascaded.

A wavelength of the VCSEL array light source may be greater than 900 nm. Specifically, the wavelength of the VCSEL array light source may be 940 nm or 1650 nm.

When the wavelength of the VCSEL array light source may be 940 nm or 1650 nm, intensity of a solar spectrum is low. This helps reduce noise caused by sun light in an outdoor scenario.

A laser beam emitted by the VCSEL array light source may be continuous light or pulse light. The VCSEL array light source may also be divided into several blocks to implement control through time division, so that different regions are lit through time division.

The diffractive optical element diffuser is used to shape a beam emitted by the VCSEL array light source into a uniform square or rectangular light source with a specified FOV (for example, an FOV of 5°×5°).

The plurality of LCPGs and the quarter-wave plate are used to implement beam scanning.

In this application, light at different angles and in different states may be dynamically selected to enter a sensor through time-division control of a transmit end and the receive end. As shown in FIG. 96, a laser beam emitted by a common VCSEL array light source does not have a fixed polarization state, and may be decomposed into a linearly polarized laser beam parallel to paper and a linearly polarized laser beam perpendicular to paper. After passing through the LCPG, the linearly polarized laser beam is split into two laser beams that are in different polarization states (left-handed circular polarization and right-handed circular polarization) and that separately have different emergent angles. After passing through the quarter-wave plate, polarization states corresponding to the two laser beams are converted into linearly polarized light parallel to paper and linearly polarized light perpendicular to paper. Reflected beams generated after the two laser beams in different polarization states are irradiated to an object in a target region are received by the quarter-wave plate and the LCPG that are shared with the transmit end, and then become laser beams that have a same divergence angle but different polarization states, namely, left-handed circularly polarized light and right-handed circularly polarized light. The beam selection device of the receive end includes a quarter-wave plate, an electrically controlled half-wave plate, and a polarizer. After received light passes through the quarter-wave plate, a polarization state of the received light is converted into linearly polarized light parallel to paper and linearly polarized light perpendicular to paper. In this way, the electrically controlled half-wave plate is controlled through time division, so that the half-wave plate rotates a polarization state of the linearly polarized light by 90 degrees or does not change a polarization state passing through the half-wave plate. Therefore, the linearly polarized light parallel to paper and the linearly polarized light perpendicular to paper are transmitted through time division. In addition, light in another polarization state is absorbed or scattered.

In FIG. 96, time division control signals of the transmit end and the receive end may be shown in FIG. 94. By staggering a control time sequence of an electrically controlled LCPG of the transmit end and a control time sequence of an electrically controlled half-wave plate of the receive end by half a period (0.5T), a scanning frequency of a system can be doubled.

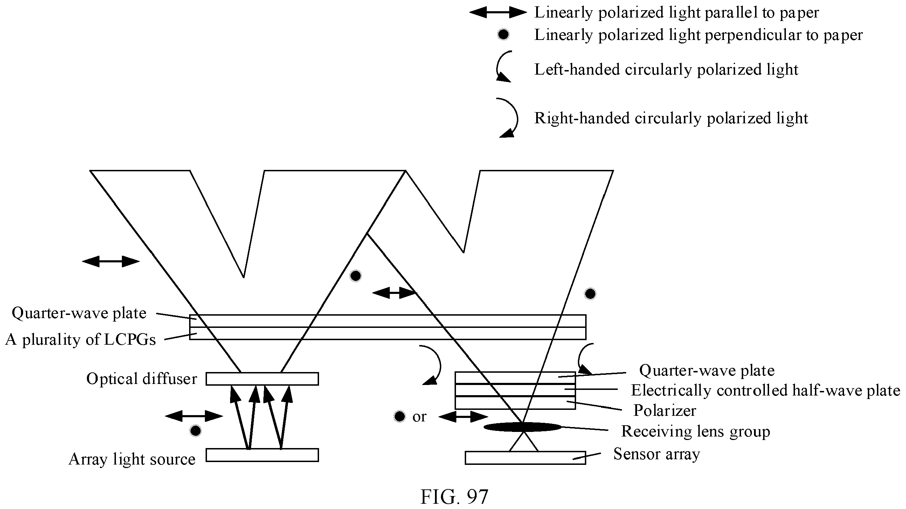

FIG. 97 is a schematic diagram of a structure of a TOF depth sensing module 700 according to an embodiment of this application.

As shown in FIG. 97, based on the TOF depth sensing module shown in FIG. 96, the diffractive optical element diffuser (DOE Diffuser) in the back of the VCSEL array light source is changed to a microlens diffuser (Diffuser). Because the microlens diffuser implements homogenization based on geometrical optics, transmission efficiency of the microlens diffuser may be at least 80%, and transmission efficiency of a conventional diffractive optical element diffuser (DOE Diffuser) is only about 70%. A morphology of the microlens diffuser is shown in FIG. 77. The microlens diffuser includes a series of randomly distributed microlenses. A location and a morphology of each microlens are designed through simulation and optimization, so that a shaped beam is as uniform as possible, and transmission efficiency is high.

A driving principle of the TOF depth sensing module shown in FIG. 97 is the same as that of the TOF depth sensing module shown in FIG. 96, except that the diffractive optical element diffuser (DOE Diffuser) in the TOF depth sensing module shown in FIG. 96 is replaced with an optical diffuser to improve transmission efficiency of the transmit end. Other details are not described again.

For the TOF depth sensing module shown in FIG. 97, time division control signals of the transmit end and the receive end may be shown in FIG. 94. By staggering a control time sequence of an electrically controlled LCPG of the transmit end and a control time sequence of an electrically controlled half-wave plate of the receive end by half a period (0.5T), a scanning frequency of a system can be doubled.

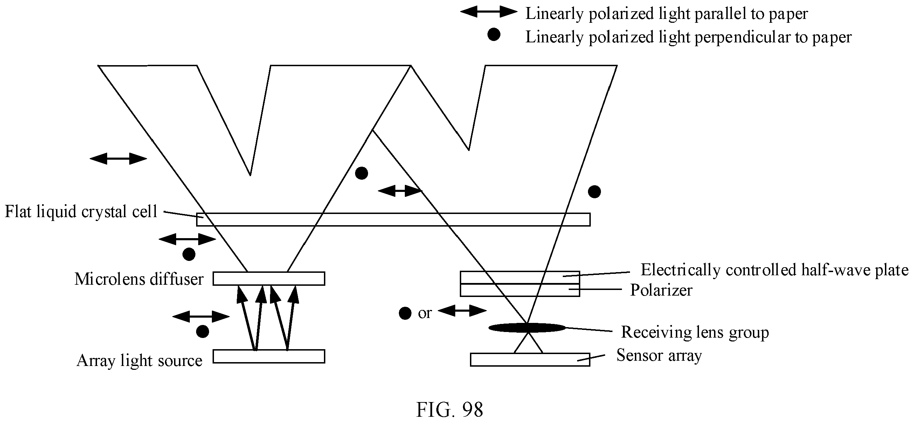

FIG. 98 is a schematic diagram of a structure of a TOF depth sensing module 700 according to an embodiment of this application.

Based on the TOF depth sensing module shown in FIG. 96 or FIG. 97, the optical element may be changed from the plurality of LCPGs and the quarter-wave plate to a plurality of layers of flat liquid crystal cells, as shown in FIG. 98. The plurality of layers of flat liquid crystal cells are used to implement beam deflection at a plurality of angles and in horizontal and vertical directions. A beam selection device of a receive end includes an electrically controlled half-wave plate and a polarizer.

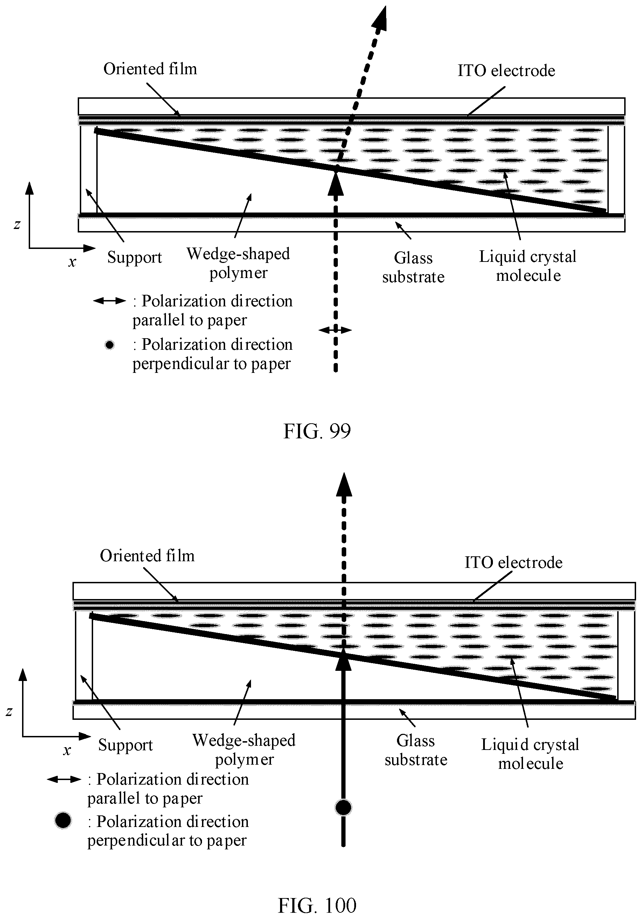

A beam deflection principle of the flat liquid crystal cell is shown in FIG. 99 and FIG. 100. Beam deflection is implemented by using an interface of a wedge-shaped polymer (Polymer). A refractive index of a wedge-shaped polymer material needs to be equal to a refractive index $n_0$ of ordinary light of a liquid crystal. In this way, as shown in FIG. 99, when an optical axis of a liquid crystal molecule is parallel to an x direction, incident light parallel to paper deflects at a specific angle. A value of the deflection angle may be controlled by controlling a voltage applied to the liquid crystal molecule, and incident light perpendicular to paper propagates along a straight line. In this way, by superimposing the plurality of layers of flat liquid crystal cells with different orientations (an optical axis is parallel to the x direction or a y direction), deflected incident light can be simultaneously projected to different angles.

Similarly, by controlling a drive voltage of the flat liquid crystal cells at a transmit end and a drive voltage of the electrically controlled half-wave plate at the receive end, control time sequences of the two drive voltages are staggered by half a period (0.5T), to increase a scanning frequency of the liquid crystal.

FIG. 101 is a schematic flowchart of an image generation method according to an embodiment of this application.

The method shown in FIG. 101 may be performed by the TOF depth sensing module or a terminal device including the TOF depth sensing module in the embodiments of this application. Specifically, the method shown in FIG. 101 may be performed by the TOF depth sensing module shown in FIG. 89 or a terminal device including the TOF depth sensing module shown in FIG. 89. The method shown in FIG. 101 includes step 9001 to step 9004. The following separately describes the steps in detail.

9001. Control a light source to generate a beam.

9002. Control an optical element to deflect the beam, to obtain an emergent beam.

9003. Control a beam selection device to select a beam in at least two polarization states from beams in each period of reflected beams of a target object, to obtain a received beam, and transmit the received beam to a receiving unit.

9004. Generate a depth map of the target object based on a TOF corresponding to the emergent beam.

The emergent beam is a beam that changes periodically. A value of a change period of the emergent beam is a first time interval. In the emergent beam, beams in adjacent periods have different tilt angles, beams in a same period have at least two polarization states, and the beams in the same period have a same tilt angle and different azimuths.

The TOF corresponding to the emergent beam may be specifically information about a time difference between a moment at which the reflected beam corresponding to the emergent beam is received by the receiving unit and an emergent moment of the light source. The reflected beam corresponding to the emergent beam may be specifically a beam generated after the emergent beam is processed by the optical element and the beam selection device, then arrives at the target object, and is reflected by the target object.

In this embodiment of this application, the direction and the polarization state of the beam emitted by the light source are adjusted by using the optical element and the beam selection device, so that emergent beams in adjacent periods have different tilt angles, and beams in a same period have at least two polarization states, to increase a scanning frequency of the TOF depth sensing module.

Optionally, the terminal device further includes a collimation lens group. The collimation lens group is disposed between the light source and the optical element. In this case, the method shown in FIG. 101 further includes:

9005. Perform collimation processing on the beam by using the collimation lens group, to obtain a beam obtained after collimation processing is performed.

The foregoing step 9002 in which the beam is deflected to obtain the emergent beam specifically includes: controlling the optical element to control a direction of the beam obtained after collimation processing is performed, to obtain the emergent beam.

An approximately parallel beam can be obtained by performing collimation processing on a beam by using the collimation lens group, so that a power density of the beam can be improved, and an effect of subsequently performing scanning by using the beam can be improved.

Optionally, the terminal device further includes a homogenizer. The homogenizer is disposed between the light source and the optical element. In this case, the method shown in FIG. 101 further includes:

9006. Adjust energy distribution of the beam by using the homogenizer, to obtain a beam obtained after homogenization processing is performed.

The foregoing step 9002 in which the beam is deflected to obtain the emergent beam specifically includes: controlling the optical element to control a direction of the beam obtained after homogenization processing is performed, to obtain the emergent beam.

Through homogenization processing, an optical power of a beam can be distributed in angle space more uniformly or according to a specified rule, to prevent a local optical power from being excessively small, and avoid a blind spot in a finally obtained depth map of the target object.

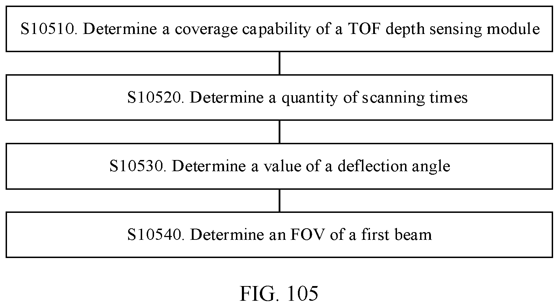

With reference to FIG. 102 to FIG. 104, the following describes the FOV that is of the first beam and that is obtained through processing by the beam shaping device in the TOF depth sensing module 300 and a total FOV obtained through scanning in the M different directions. In addition, an overall solution design is described with reference to FIG. 105.

It should be understood that the beam shaping device 330 in the TOF depth sensing module 300 adjusts a beam to obtain the first beam. The FOV of the first beam meets a first preset range.

Optionally, the first preset range may be [5°×5°, 20°×20°].

FIG. 102 is a schematic diagram of an FOV of a first beam.

As shown in FIG. 102, the first beam is emitted from a point O. An FOV of the first beam in a vertical direction is an angle A. An FOV of the first beam in a horizontal direction is an angle B. A rectangle E is a region in which the first beam is projected onto the target object (the region in which the first beam is projected onto the target object may be a rectangular region, or certainly may be of another shape). A value of the angle A ranges from 5° to 20° (which may include 5° and 20°). Similarly, a value of the angle B also ranges from 5° to 20° (which may include 5° and 20°).

In the TOF depth sensing module 300, the control unit 370 may be configured to control the first optical element to separately control a direction of the first beam at M different moments, to obtain emergent beams in M different directions. A total FOV covered by the emergent beams in the M different directions meets a second preset range.

Optionally, the second preset range may be [50°×50°, 80°×80°].

FIG. 103 is a schematic diagram of a total FOV covered by emergent beams in M different directions.

Specifically, as shown in FIG. 103, the emergent beams in the M different directions are emitted from a point O, and a covered region on the target object is a rectangle F. An angle C is a superposed value of FOVs of the emergent beams in the M different directions in a vertical direction. An angle D is a superposed value of FOVs of the emergent beams in the M different directions in a horizontal direction. A value of the angle C ranges from 50° to 80° (which may include 50° and 80°). Similarly, a value of the angle D also ranges from 50° to 80° (which may include 50° and 80°).

It should be understood that the total FOV covered by the emergent beams in the M different directions is obtained after scanning is performed by using the first beam in the M different directions. For example, FIG. 104 is a schematic diagram of performing scanning in M different directions by a TOF depth sensing module according to an embodiment of this application.

In this example, as shown in FIG. 104, an FOV of a first beam is E×F. A total FOV covered by the TOF depth sensing module is U×V. A quantity of scanning times is 6. In other words, scanning is performed in six different directions.

The six times of scanning are performed in the following manner. Scanning is separately performed on two rows, and three times of scanning are performed on each row (in other words, a quantity of scanned columns is 3, and a quantity of scanned rows is 2). Therefore, the quantity of scanning times may also be represented by 3×2.

In this example, a scanning track is first scanning the first row for three times from left to right, then deflecting to the second row, and scanning the second row for three times from right to left, to cover an entire FOV range.

It should be understood that the scanning track and the quantity of scanning times in this example are merely used as an example, and cannot constitute a limitation on this application.

It should be understood that, in an actual operation, when scanning is performed in two adjacent directions, transformation from one direction to another adjacent direction may be implemented by setting a specific deflection angle.

It should be further understood that, before actual scanning, a value of the deflection angle further needs to be determined based on an actual situation to be controlled within an appropriate range, so that the first beam covers an entire to-be-scanned region after a plurality of times of scanning. The following describes an entire solution design of the embodiments of this application with reference to FIG. 105.

FIG. 105 is a schematic flowchart of an entire solution design according to an embodiment of this application. As shown in FIG. 105, the entire solution design includes steps S10510 to S10540. It should be understood that a sequence of the foregoing steps is not limited in this application. Any solution that may implement this application through a combination of the foregoing steps falls within the protection scope of this application. The following describes the foregoing steps in detail.

S10510. Determine a coverage capability of a TOF depth sensing module.

It should be understood that during the solution design, the coverage capability of the TOF depth sensing module needs to be determined first, and then an appropriate deflection angle can be determined with reference to a quantity of scanning times.

It should be understood that the coverage capability of the TOF depth sensing module is a range that can be covered by an FOV of the TOF depth sensing module.

Optionally, in this embodiment of this application, the TOF depth sensing module is mainly designed for front facial recognition. To ensure unlocking requirements of a user in different scenarios, the FOV of the TOF depth sensing module should be greater than $50 \times 50$. In addition, an FOV range of the TOF depth sensing module should not be too large. If the FOV range is too large, aberration and distortion increase. Therefore, the FOV range of the TOF depth sensing module may generally range from $50 \times 50$ to $80 \times 80$.

In this example, the determined total FOV that can be covered by the TOF depth sensing module may be represented by $U \times V$.

S10520. Determine the quantity of scanning times.

It should be understood that an upper limit of the quantity of scanning times is determined by performance of a first optical element. For example, the first optical element is a liquid crystal polarization grating (LCPG). A response time of a liquid crystal molecule is approximately S ms (milliseconds). In this case, the first optical element performs scanning a maximum of 1000/S times within IS. Considering that a frame rate of a depth map generated by the TOF depth sensing module is T fps, each frame of picture may be scanned a maximum of $1000/(S \times T)$ times.

It should be understood that, under a same condition, a larger quantity of times of scanning each frame of picture indicates a higher intensity density of a scanning beam, and a longer scanning distance can be implemented.

It should be understood that a quantity of scanning times in an actual operation may be determined based on the determined upper limit of the quantity of scanning times, provided that it is ensured that the quantity of scanning times does not exceed the upper limit. This is not further limited in this application.

It should be understood that, in this example, the determined quantity of scanning times may be represented by $X \times Y$. Y indicates that a quantity of scanned rows is Y, and X indicates that a quantity of scanned columns is X. In other words, scanning is performed on Y rows, and X times of scanning are performed on each row.

S10530. Determine a value of the deflection angle.

It should be understood that, in this embodiment of this application, the value of the deflection angle may be determined based on the FOV coverage capability of the TOF depth sensing module and the quantity of scanning times that are determined in the foregoing two steps.

Specifically, if the total FOV that can be covered by the TOF depth sensing module is $U \times V$, the quantity of scanning times is $X \times Y$. Therefore, a deflection angle in a scanning process in a horizontal direction (namely, on each row) should be greater than or equal to U/X, and a deflection angle in a scanning process in a vertical direction (namely, a column direction that indicates a deflection from one row to another row) should be greater than or equal to V/Y.

It should be understood that, if the deflection angle is small, the total FOV of the TOF depth sensing module cannot be covered by a preset quantity of scanning times.

S10540. Determine an FOV of a first beam.

It should be understood that, after the value of the deflection angle is determined, the FOV of the first beam is determined based on the value of the deflection angle. In this example, the FOV of the first beam may be represented by $E \times F$.

It should be understood that the FOV of the first beam should be greater than or equal to the value of the deflection angle, to ensure that there is no slit (namely, a missed region that is not scanned) in an adjacent scanning region. In this case, E should be greater than or equal to a value of a horizontal deflection angle, and F should be greater than or equal to a value of a vertical deflection angle.

Optionally, the FOV of the first beam may be slightly greater than the value of the deflection angle, for example, by 5%. This is not limited in this application.

It should be understood that the coverage capability of the TOF depth sensing module, the quantity of scanning times, the FOV of the first beam, and the value of the deflection angle may be determined through mutual coordination in an actual operation, to be controlled within an appropriate range. This is not limited in this application.

It should be understood that, with reference to FIG. 102 to FIG. 104, the foregoing descriptions of the first beam generated by the TOF depth sensing module 300 and the FOVs of the emergent beams in the M different directions are also applicable to the first beam generated by the TOF depth sensing module 400 and the emergent beams in the M different directions. Details are not described herein again.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

**EP 4 080 246 A1**

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The software product is stored in a storage medium, and includes several instructions for instructing a computer device (which may be a personal computer, a server, or a network device) to perform all or some of the steps of the methods described in the embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A time of flight TOF depth sensing module, wherein the TOF depth sensing module comprises an array light source, a beam splitter, a collimation lens group, a receiving unit, and a control unit, the array light source comprises N light emitting regions, the N light emitting regions do not overlap each other, each light emitting region is used to generate a beam, and the collimation lens group is located between the array light source and the beam splitter;

   the control unit is configured to control M light emitting regions of the N light emitting regions of the array light source to emit light, wherein M is less than or equal to N, M is a positive integer, and N is a positive integer greater than 1;
   the collimation lens group is configured to perform collimation processing on beams from the M light emitting regions;
   the beam splitter is configured to perform beam splitting processing on beams obtained after the collimation lens group performs collimation processing, to obtain an emergent beam, wherein the beam splitter is specifically configured to split each received beam of light into a plurality of beams of light; and
   the receiving unit is configured to receive reflected beams of a target object, wherein the reflected beam of the target object is a beam obtained by the target object by reflecting the emergent beam.

2. The TOF depth sensing module according to claim 1, wherein the receiving unit comprises a receiving lens group and a sensor, and the receiving lens group is configured to converge the reflected beams to the sensor.

3. The TOF depth sensing module according to claim 2, wherein resolution of the sensor is greater than or equal to $P \times Q$, and a quantity of beams obtained after the beam splitter performs beam splitting on a beam from one light emitting region of the array light source is $P \times Q$, wherein both P and Q are positive integers.

4. The TOF depth sensing module according to any one of claims 1 to 3, wherein a beam receiving surface of the

68

beam splitter is parallel to a beam emission surface of the array light source.

5. The TOF depth sensing module according to any one of claims 1 to 4, wherein the beam splitter is any one of a cylindrical lens array, a microlens array, and a diffraction optical device.

6. The TOF depth sensing module according to any one of claims 1 to 5, wherein the array light source is a vertical cavity surface emitting laser.

7. The TOF depth sensing module according to any one of claims 1 to 6, wherein a light emitting area of the array light source is less than or equal to $5 \times 5$ mm$^2$;

an area of a beam incident end face of the beam splitter is less than $5 \times 5$ mm$^2$; and
a clear aperture of the collimation lens group is less than or equal to 5 mm.

8. The TOF depth sensing module according to any one of claims 1 to 7, wherein an average output optical power of the TOF depth sensing module is less than 800 mw.

9. A time of flight TOF depth sensing module, wherein the TOF depth sensing module comprises an array light source, a beam splitter, a collimation lens group, a receiving unit, and a control unit, the array light source comprises N light emitting regions, the N light emitting regions do not overlap each other, each light emitting region is used to generate a beam, and the beam splitter is located between the array light source and the collimation lens group;

the control unit is configured to control M light emitting regions of the N light emitting regions of the array light source to emit light, wherein M is less than or equal to N, M is a positive integer, and N is a positive integer greater than 1;
the beam splitter is configured to perform beam splitting processing on beams from the M light emitting regions, wherein the beam splitter is specifically configured to split each received beam of light into a plurality of beams of light;
the collimation lens group is configured to perform collimation processing on beams from the beam splitter, to obtain an emergent beam; and
the receiving unit is configured to receive reflected beams of a target object, wherein the reflected beam of the target object is a beam obtained by the target object by reflecting the emergent beam.

10. The TOF depth sensing module according to claim 9, wherein the receiving unit comprises a receiving lens group and a sensor, and the receiving lens group is configured to converge the reflected beams to the sensor.

11. The TOF depth sensing module according to claim 10, wherein resolution of the sensor is greater than or equal to $P \times Q$, and a quantity of beams obtained after the beam splitter performs beam splitting on a beam from one light emitting region of the array light source is $P \times Q$, wherein both P and Q are positive integers.

12. The TOF depth sensing module according to any one of claims 9 to 11, wherein a beam receiving surface of the beam splitter is parallel to a beam emission surface of the array light source.

13. The TOF depth sensing module according to any one of claims 9 to 12, wherein the beam splitter is any one of a cylindrical lens array, a microlens array, and a diffraction optical device.

14. The TOF depth sensing module according to any one of claims 9 to 13, wherein the array light source is a vertical cavity surface emitting laser.

15. The TOF depth sensing module according to any one of claims 9 to 14, wherein a light emitting area of the array light source is less than or equal to $5 \times 5$ mm$^2$;

an area of a beam incident end face of the beam splitter is less than $5 \times 5$ mm$^2$; and
a clear aperture of the collimation lens group is less than or equal to 5 mm.

16. The TOF depth sensing module according to any one of claims 9 to 15, wherein an average output optical power of the TOF depth sensing module is less than 800 mw.

17. An image generation method, wherein the image generation method is applied to a terminal device that comprises a time of flight TOF depth sensing module, the TOF depth sensing module comprises an array light source, a beam splitter, a collimation lens group, a receiving unit, and a control unit, the array light source comprises N light emitting regions, the N light emitting regions do not overlap each other, each light emitting region is used to generate a beam, and the collimation lens group is located between the array light source and the beam splitter; and the image generation method comprises:

controlling, by using the control unit, M light emitting regions of the N light emitting regions of the array light source to respectively emit light at M different moments, wherein M is less than or equal to N, M is a positive integer, and N is a positive integer greater than 1;
performing, by using the collimation lens group, collimation processing on beams that are respectively generated by the M light emitting regions at the M different moments, to obtain beams obtained after collimation processing is performed;
performing, by using the beam splitter, beam splitting processing on the beams obtained after collimation processing is performed, to obtain an emergent beam, wherein the beam splitter is specifically configured to split each received beam of light into a plurality of beams of light;
receiving reflected beams of a target object by using the receiving unit, wherein the reflected beam of the target object is a beam obtained by the target object by reflecting the emergent beam;
obtaining TOFs corresponding to the beams that are respectively emitted by the M light emitting regions at the M different moments;
generating M depth maps based on the TOFs corresponding to the beams that are respectively emitted by the M light emitting regions at the M different moments; and
obtaining a final depth map of the target object based on the M depth maps.

18. The image generation method according to claim 17, wherein the M depth maps are respectively depth maps corresponding to M region sets of the target object, and there is no overlapping region between any two region sets in the M region sets.

19. The image generation method according to claim 17 or 18, wherein the receiving unit comprises a receiving lens group and a sensor, and the receiving reflected beams of a target object by using the receiving unit comprises:
converging the reflected beams of the target object to the sensor by using the receiving lens group.

20. The image generation method according to claim 19, wherein resolution of the sensor is greater than or equal to $P \times Q$, and a quantity of beams obtained after the beam splitter performs beam splitting on a beam from one light emitting region of the array light source is $P \times Q$, wherein both P and Q are positive integers.

21. The image generation method according to any one of claims 17 to 20, wherein the performing, by using the beam splitter, beam splitting processing on the beams obtained after collimation processing is performed comprises:
performing, by using the beam splitter, one-dimensional or two-dimensional beam splitting processing on the beams generated after collimation processing is performed.

22. An image generation method, wherein the image generation method is applied to a terminal device that comprises a time of flight TOF depth sensing module, the TOF depth sensing module comprises an array light source, a beam splitter, a collimation lens group, a receiving unit, and a control unit, the array light source comprises N light emitting regions, the N light emitting regions do not overlap each other, each light emitting region is used to generate a beam, and the beam splitter is located between the array light source and the collimation lens group; and the image generation method comprises:

controlling, by using the control unit, M light emitting regions of the N light emitting regions of the array light source to respectively emit light at M different moments, wherein M is less than or equal to N, M is a positive integer, and N is a positive integer greater than 1;
performing, by using the beam splitter, beam splitting processing on beams that are respectively generated by the M light emitting regions at the M different moments, wherein the beam splitter is specifically configured to split each received beam of light into a plurality of beams of light;
performing collimation processing on beams from the beam splitter by using the collimation lens group, to obtain an emergent beam;
receiving reflected beams of a target object by using the receiving unit, wherein the reflected beam of the target object is a beam obtained by the target object by reflecting the emergent beam;

obtaining TOFs corresponding to the beams that are respectively emitted by the M light emitting regions at the M different moments;

generating M depth maps based on the TOFs corresponding to the beams that are respectively emitted by the M light emitting regions at the M different moments; and

obtaining a final depth map of the target object based on the M depth maps.

23. The image generation method according to claim 22, wherein the M depth maps are respectively depth maps corresponding to M region sets of the target object, and there is no overlapping region between any two region sets in the M region sets.

24. The image generation method according to claim 22 or 23, wherein the receiving unit comprises a receiving lens group and a sensor, and the receiving reflected beams of a target object by using the receiving unit comprises:

converging the reflected beams of the target object to the sensor by using the receiving lens group.

25. The image generation method according to claim 24, wherein resolution of the sensor is greater than or equal to P×Q, and a quantity of beams obtained after the beam splitter performs beam splitting on a beam from one light emitting region of the array light source is P×Q, wherein both P and Q are positive integers.

26. The image generation method according to any one of claims 22 to 25, wherein the performing, by using the beam splitter, beam splitting processing on beams that are respectively generated by the M light emitting regions at the M different moments comprises:

respectively performing, by using the beam splitter, one-dimensional or two-dimensional beam splitting processing on the beams that are generated by the M light emitting regions at the M different moments.

27. An image generation method, wherein the image generation method is applied to a terminal device that comprises a time of flight TOF depth sensing module, the TOF depth sensing module comprises an array light source, a beam splitter, a collimation lens group, a receiving unit, and a control unit, the array light source comprises N light emitting regions, the N light emitting regions do not overlap each other, each light emitting region is used to generate a beam, and the collimation lens group is located between the array light source and the beam splitter; and the image generation method comprises:

determining a working mode of the terminal device, wherein the working mode of the terminal device comprises a first working mode and a second working mode;

in the first working mode, the image generation method further comprises:

controlling L light emitting regions of the N light emitting regions of the array light source to simultaneously emit light, wherein L is less than or equal to N, L is a positive integer, and N is a positive integer greater than 1;

performing, by using the collimation lens group, collimation processing on beams emitted by the L light emitting regions;

performing, by using the beam splitter, beam splitting processing on beams generated after the collimation lens group performs collimation processing, to obtain an emergent beam, wherein the beam splitter is specifically configured to split each received beam of light into a plurality of beams of light;

receiving reflected beams of a target object by using the receiving unit, wherein the reflected beam of the target object is a beam obtained by the target object by reflecting the emergent beam;

obtaining TOFs corresponding to the beams emitted by the L light emitting regions; and

obtaining a final depth map of the target object based on the TOFs corresponding to the beams emitted by the L light emitting regions; or

in the second working mode, the image generation method further comprises:

controlling M light emitting regions of the N light emitting regions of the array light source to emit light at M different moments, wherein M is less than or equal to N, and both M and N are positive integers;

performing, by using the collimation lens group, collimation processing on beams that are respectively generated by the M light emitting regions at the M different moments, to obtain beams obtained after collimation processing is performed;

performing, by using the beam splitter, beam splitting processing on the beams obtained after collimation processing is performed, to obtain an emergent beam, wherein the beam splitter is specifically configured to split each received beam of light into a plurality of beams of light;

receiving reflected beams of a target object by using the receiving unit, wherein the reflected beam of the target object is a beam obtained by the target object by reflecting the emergent beam;

obtaining TOFs corresponding to the beams that are respectively emitted by the M light emitting regions at the M different moments;

generating M depth maps based on the TOFs corresponding to the beams that are respectively emitted by the M light emitting regions at the M different moments; and

obtaining a final depth map of the target object based on the M depth maps.

28. The image generation method according to claim 27, wherein the M depth maps are respectively depth maps corresponding to M region sets of the target object, and there is no overlapping region between any two region sets in the M region sets.

29. The image generation method according to claim 27 or 28, wherein the receiving unit comprises a receiving lens group and a sensor, and in the first working mode or the second working mode, the receiving reflected beams of a target object by using the receiving unit comprises:

converging the reflected beams of the target object to the sensor by using the receiving lens group.

30. The image generation method according to claim 29, wherein resolution of the sensor is greater than or equal to $P \times Q$, and a quantity of beams obtained after the beam splitter performs beam splitting on a beam from one light emitting region of the array light source is $P \times Q$, wherein both P and Q are positive integers.

31. The image generation method according to any one of claims 27 to 30, wherein the determining a working mode of the terminal device comprises:

determining the working mode of the terminal device based on working mode selection information of a user, wherein the working mode selection information of the user is used to select one of the first working mode and the second working mode as the working mode of the terminal device.

32. The image generation method according to any one of claims 27 to 30, wherein the determining a working mode of the terminal device comprises:

determining the working mode of the terminal device based on a distance between the terminal device and the target object or a scenario in which the target object is located.

33. The image generation method according to claim 32, wherein the determining the working mode of the terminal device based on a distance between the terminal device and the target object or a scenario in which the target object is located comprises:

when the distance between the terminal device and the target object is less than or equal to a preset distance, determining that the terminal device works in the first working mode;

when the distance between the terminal device and the target object is greater than a preset distance, determining that the terminal device works in the second working mode;

when the terminal device is in an indoor scenario, determining that the terminal device works in the first working mode; or

when the terminal device is in an outdoor scenario, determining that the terminal device works in the second working mode.

34. An image generation method, wherein the image generation method is applied to a terminal device that comprises a time of flight TOF depth sensing module, the TOF depth sensing module comprises an array light source, a beam splitter, a collimation lens group, a receiving unit, and a control unit, the array light source comprises N light emitting regions, the N light emitting regions do not overlap each other, each light emitting region is used to generate a beam, and the beam splitter is located between the array light source and the collimation lens group; and the image generation method comprises:

determining a working mode of the terminal device, wherein the working mode of the terminal device comprises a first working mode and a second working mode;

in the first working mode, the image generation method further comprises:

controlling L light emitting regions of the N light emitting regions of the array light source to simultaneously emit light, wherein L is less than or equal to N, L is a positive integer, and N is a positive integer greater than 1;

performing beam splitting processing on beams from the L light emitting regions by using the beam splitter, wherein the beam splitter is specifically configured to split each received beam of light into a plurality of beams of light;

performing collimation processing on beams from the beam splitter by using the collimation lens group, to obtain an emergent beam;

receiving reflected beams of a target object by using the receiving unit, wherein the reflected beam of the target object is a beam obtained by the target object by reflecting the emergent beam;

obtaining TOFs corresponding to the beams emitted by the L light emitting regions; and

obtaining a final depth map of the target object based on the TOFs corresponding to the beams emitted by the L light emitting regions; or

in the second working mode, the image generation method further comprises:

controlling M light emitting regions of the N light emitting regions of the array light source to emit light at M different moments, wherein M is less than or equal to N, and both M and N are positive integers;

performing, by using the beam splitter, beam splitting processing on beams that are respectively generated by the M light emitting regions at the M different moments, wherein the beam splitter is specifically configured to split each received beam of light into a plurality of beams of light;

performing collimation processing on beams from the beam splitter by using the collimation lens group, to obtain an emergent beam;

receiving reflected beams of a target object by using the receiving unit, wherein the reflected beam of the target object is a beam obtained by the target object by reflecting the emergent beam;

obtaining TOFs corresponding to the beams that are respectively emitted by the M light emitting regions at the M different moments;

generating M depth maps based on the TOFs corresponding to the beams that are respectively emitted by the M light emitting regions at the M different moments; and

obtaining a final depth map of the target object based on the M depth maps.

35. The image generation method according to claim 34, wherein the M depth maps are respectively depth maps corresponding to M region sets of the target object, and there is no overlapping region between any two region sets in the M region sets.

36. The image generation method according to claim 34 or 35, wherein the receiving unit comprises a receiving lens group and a sensor, and in the first working mode or the second working mode, the receiving reflected beams of a target object by using the receiving unit comprises:
converging the reflected beams of the target object to the sensor by using the receiving lens group.

37. The image generation method according to claim 36, wherein resolution of the sensor is greater than or equal to P×Q, and a quantity of beams obtained after the beam splitter performs beam splitting on a beam from one light emitting region of the array light source is P×Q, wherein both P and Q are positive integers.

38. The image generation method according to any one of claims 34 to 37, wherein the determining a working mode of the terminal device comprises:
determining the working mode of the terminal device based on working mode selection information of a user, wherein the working mode selection information of the user is used to select one of the first working mode and the second working mode as the working mode of the terminal device.

39. The image generation method according to any one of claims 34 to 37, wherein the determining a working mode of the terminal device comprises:
determining the working mode of the terminal device based on a distance between the terminal device and the target object or a scenario in which the target object is located.

40. The image generation method according to claim 39, wherein the determining the working mode of the terminal device based on a distance between the terminal device and the target object or a scenario in which the target object is located comprises:

when the distance between the terminal device and the target object is less than or equal to a preset distance, determining that the terminal device works in the first working mode;

when the distance between the terminal device and the target object is greater than a preset distance, determining that the terminal device works in the second working mode;

when the terminal device is in an indoor scenario, determining that the terminal device works in the first working mode; or

when the terminal device is in an outdoor scenario, determining that the terminal device works in the second working mode.

41. A terminal device, comprising the time of flight TOF depth sensing module according to any one of claims 1 to 8.

42. A terminal device, comprising the time of flight TOF depth sensing module according to any one of claims 9 to 16.

Laser pulse

Reflected laser pulse

Transmitter

Detector

Timer

**FIG. 1**

Target scenario

Distance =
Time × Beam

Emit beam

Receive beam

Projection lens group
(optional)

Beam splitter

Collimation lens group

Light source

**Transmit end**

Receiving lens group

Sensor array

**Receive end**

**Control Unit**

**TOF depth sensing module**

**FIG. 2**

**TOF depth sensing module 100**

Collimation lens group 120

Array light
source
110

Beam splitter 130

Receiving unit 140

Control unit
150

Receiving lens
group 141

Sensor array 142

FIG. 3

FIG. 4

FIG. 5

FIG. 6

FIG. 7

FIG. 8

FIG. 9

FIG. 10

Beam splitter 130

**TOF depth sensing module 100**

Collimation lens group 120

Array light source 110

Collimation lens group 120

**Receiving unit 140**

Control unit 150

Receiving lens group 141

Sensor array 142

FIG. 11

Beam splitter

Array light source

FIG. 12

**TOF depth sensing module 100**

Optical element 160    Beam splitter 130

Array light
source
110

Receiving unit 140

Collimation
lens group 120

Control unit
150

Receiving lens
group 141

Sensor array 142

FIG. 13

**TOF depth sensing module 100**

Collimation lens group 120

Optical element 160

Beam splitter 130

Array light source 110

Control unit 150

**Receiving unit 140**

Receiving lens group 141

Sensor array 142

FIG. 14

| Projection lens group (optional) |
| Beam splitter 130 |
| Optical element 160 |
| Collimation lens group 120 |
| Array light source 110 |

**Projection end**

| Receiving lens group 141 |
| Sensor array 142 |

**Receive end**

**Control unit 150**

FIG. 15

FIG. 16

FIG. 17

Control, by using a control unit, M light emitting regions of N light emitting regions of an array light source to respectively emit light at M different moments ~ 2001

Perform, by using a collimation lens group, collimation processing on beams that are respectively generated by the M light emitting regions at the M different moments, to obtain beams obtained after collimation processing is performed ~ 2002

Perform, by using a beam splitter, beam splitting processing on the beams obtained after collimation processing is performed ~ 2003

Receive reflected beams of a target object by using a receiving unit ~ 2004

Generate M depth maps based on TOFs corresponding to the beams that are respectively emitted by the M light emitting regions of the array light source at the M different moments ~ 2005

Obtain a final depth map of the target object based on the M depth maps ~ 2006

FIG. 18

t0    t1

t2    t3

FIG. 19

Control, by using a control unit, M light emitting regions of N light emitting regions of an array light source to respectively emit light at M different moments ~ 3001

Perform, by using a beam splitter, beam splitting processing on beams that are respectively generated by the M light emitting regions at the M different moments ~ 3002

Perform collimation processing on beams from the beam splitter by using a collimation lens group ~ 3003

Receive reflected beams of a target object by using a receiving unit ~ 3004

Generate M depth maps based on TOFs corresponding to the beams that are respectively emitted by the M light emitting regions of the array light source at the M different moments ~ 3005

Obtain a final depth map of the target object based on the M depth maps ~ 3006

FIG. 20

4001. Determine a working mode of a terminal device

4002. Obtain a final depth map of a target object in a first working mode

4003. Obtain a final depth map of a target object in a second working mode

FIG. 21

Control L light emitting regions of N light emitting regions of an array light source to simultaneously emit light ~ 4002A

Perform, by using a collimation lens group, collimation processing on beams emitted by the L light emitting regions ~ 4002B

Perform, by using a beam splitter, beam splitting processing on beams generated after the collimation lens group performs collimation processing ~ 4002C

Receive reflected beams of a target object by using a receiving unit ~ 4002D

Obtain a final depth map of the target object based on TOFs corresponding to the beams emitted by the L light emitting regions ~ 4002E

FIG. 22

Control L light emitting regions of N light emitting regions of an array light source to simultaneously emit light ⎯⌇ 4002a

Perform beam splitting processing on beams from the L light emitting regions by using a beam splitter ⎯⌇ 4002b

Perform collimation processing on beams from the beam splitter by using a collimation lens group, to obtain beams obtained after collimation processing is performed ⎯⌇ 4002c

Receive reflected beams of a target object by using a receiving unit ⎯⌇ 4002d

Obtain a final depth map of the target object based on TOFs corresponding to the beams emitted by the L light emitting regions ⎯⌇ 4002e

FIG. 23

Control M light emitting regions of N light emitting regions of an array light source to emit light at M different moments   4003A

Perform, by using a collimation lens group, collimation processing on beams that are respectively generated by the M light emitting regions at the M different moments, to obtain beams obtained after collimation processing is performed   4003B

Perform, by using a beam splitter, beam splitting processing on the beams obtained after collimation processing is performed   4003C

Receive reflected beams of a target object by using a receiving unit   4003D

Generate M depth maps based on TOFs corresponding to the beams that are respectively emitted by the M light emitting regions at the M different moments   4003E

Obtain a final depth map of the target object based on the M depth maps   4003F

FIG. 24

| | |
|---|---|
| Control M light emitting regions of N light emitting regions of an array light source to emit light at M different moments | 4003a |
| Perform, by using a beam splitter, beam splitting processing on beams that are respectively generated by the M light emitting regions at the M different moments | 4003b |
| Perform collimation processing on beams from the beam splitter by using a collimation lens group | 4003c |
| Receive reflected beams of a target object by using a receiving unit | 4003d |
| Generate M depth maps based on TOFs corresponding to the beams that are respectively emitted by the M light emitting regions at the M different moments | 4003e |
| Obtain a final depth map of the target object based on the M depth maps | 4003f |

FIG. 25

Target scenario

Distance =
Time × Beam

Emit beam

Receive beam

| Projection lens group (optional) |
| Optical element |
| Polarization filtering device |
| Collimation lens group (optional) |
| Light source |
| **Projection end** |

| Receiving lens group (optional) |
| Two-dimensional sensor array |
| **Receive end** |

**Control Unit**

FIG. 26

**TOF depth sensing module 200**

Polarization
filtering device 220

Optical element 230

Light source
210

Receiving unit 240

Control unit
250

Receiving lens
group 241

Sensor array 242

FIG. 27

Z

Beam

θ

Projection
module

φ

Y

X

FIG. 28

**TOF depth sensing module 200**

Collimation lens
group 260

Polarization filtering
device 220

Light source
210

Optical element 230

Control unit
250

Receiving unit 240

Receiving lens group 241

Sensor array 242

FIG. 29

TOF depth sensing module 200

Polarization
filtering device 220

Optical element 230

Light source
210

Scanning
beam 1

Moment
T0

Scanning
beam 2

Moment
T1

Scanning
beam 3

Moment
T2

Target
object

Control unit
250

Receiving unit 240

Receiving lens
group 241

Sensor array 242

FIG. 30

Scanning point A          Scanning point C

Scanning light spot

Scanning direction

Scanning point B

FIG. 31

Scanning
manner A

Scanning
manner B

Scanning
manner C

Scanning
manner D

Scanning
manner E

Scanning
manner F

Scanning
manner G

Scanning
manner H

Scanning
manner I

Scanning
manner J

Scanning
manner K

FIG. 32

**TOF depth sensing module 200**

Polarization
filtering device 220

Liquid crystal
polarization grating

Light source
210

Receiving unit 240

Control unit
250

Receiving lens
group 241

Sensor array 242

FIG. 33

**TOF depth sensing module 200**

Polarization
filtering device 220

Light source
210

Optical element 230

2: Horizontal LCPG

4: Vertical LCPG

2    4

Receiving unit 240

Control unit
250

Receiving lens
group 241

Sensor array 242

FIG. 34

1 Horizontal polarization control sheet
2 Horizontal LCPG
3 Vertical polarization control sheet
4 Vertical LCPG

1    2    3    4

FIG. 35

**TOF depth sensing module 200**

Polarization filtering device 220

Light source 210

Optical element 230

1: Horizontal polarization control sheet
2: Horizontal LCPG
3: Vertical polarization control sheet
4: Vertical LCPG

1  2  3  4

**Receiving unit 240**

Control unit 250

Receiving lens group 241

Sensor array 242

FIG. 36

FIG. 37

V≥V$_{th}$      V=0V      V=0V

Arbitrary polarized light    Left-handed circularly polarized light    Right-handed circularly polarized light

FIG. 38

FIG. 39

FIG. 40

FIG. 41

FIG. 42

FIG. 43

FIG. 44

1: Control voltage signal applied to an electro-optic crystal for horizontal deflection

2: Control voltage signal applied to an electro-optic crystal for vertical deflection

FIG. 45

FIG. 46

**TOF depth sensing module 200**

Polarization filtering
device 220

Light source
210

Acousto-optic device

Receiving unit 240

Control unit
250

Receiving lens
group 241

Sensor array 242

FIG. 47

FIG. 48

**TOF depth sensing module 200**

Polarization filtering
device 220

OPA device

Light source
210

Control unit
250

**Receiving unit 240**

Receiving lens
group 241

Sensor array 242

FIG. 49

FIG. 50

**TOF depth sensing module 200**

Collimation lens group 260

Polarization filtering device 220

Light source 210

Optical element 230

Receiving unit 240

Control unit 250

Receiving lens group 241

Sensor array 242

FIG. 51

Control a light source to generate a beam 〜 5001

Filter the beam by using a polarization filtering device, to obtain a beam in a single polarization state 〜 5002

Control an optical element to separately have different birefringence parameters at M different moments, to obtain emergent beams in M different directions 〜 5003

Receive M reflected beams by using a receiving unit 〜 5004

Generate a depth map of a target object based on TOFs corresponding to the emergent beams in the M different directions 〜 5005

FIG. 52

t2

t3

t1

t9

t8

t4

t10

t7

t0

t14

t15

t16

t5

t11

t13

t17

t6

t12

| Projection lens group (optional) |
|---|

| Receiving lens group (optional) |
|---|

| First optical element |
|---|

| Second optical element |
|---|

| Collimation lens group (optional) |
|---|

| Sensor array |
|---|

**Receive end**

| Polarization filtering device |
|---|

| Light source |
|---|

**Projection end**

| Control Unit |
|---|

FIG. 53

Polarization filtering
device 320　　　　**TOF depth sensing module 300**

Beam shaping
device 330

Light source
310

First optical
element 340

**Receiving unit 360**

Second optical
element 350

Control unit
370

Receiving lens
group 361

Sensor array 362

FIG. 54

FIG. 55

FIG. 56

| Control a light source to generate a beam | 5001 |

| Filter the beam by using a polarization filtering device, to obtain a beam in a single polarization state | 5002 |

| Adjust the beam by using a beam shaping device, to obtain a first beam | 5003 |

| Control a first optical element to separately control a direction of the first beam from the beam shaping device at M different moments, to obtain emergent beams in M different directions | 5004 |

| Control a second optical element to separately deflect, to a receiving unit, M reflected beams obtained by a target object by reflecting the M emergent beams | 5005 |

| Generate a depth map of the target object based on TOFs respectively corresponding to the M emergent beams | 5006 |

FIG. 57

FIG. 58

Polarization filtering
device 420

**TOF depth sensing module 400**

Beam shaping
device 430

Collimation lens
group 470

Light source
410

Control unit
460

**Receiving unit 450**

Optical
element 440

Receiving lens group 451

Sensor array 452

FIG. 59

TOF depth sensing module 400

Polarization filtering
device 420

Beam shaping
device 430

Collimation lens
group 470

Light source
410

Receiving unit 450

Optical
element 440

Control unit
460

Receiving lens group 451

Sensor array 452

FIG. 60

Projection/Receiving FOV

Beam splitter

Light source

MEMS galvanometer

Homogenizer

Receiving lens group

Sensor array

FIG. 61

Control a light source to generate a beam — 6001

Filter the beam by using a polarization filtering device, to obtain a beam in a single polarization state — 6002

Adjust the beam by using a beam shaping device, to obtain a first beam — 6003

Control an optical element to separately control a direction of the first beam from the beam shaping device at M different moments, to obtain emergent beams in M different directions — 6004

Control the optical element to separately deflect, to a receiving unit, M reflected beams obtained by a target object by reflecting the M emergent beams — 6005

Generate a depth map of the target object based on TOFs respectively corresponding to the M emergent beams — 6006

FIG. 62

Projection FOV

Receiving FOV

Quarter-wave plate

A plurality of LCPGs

Homogenizer

Polarizer

Receiving lens group

Light source

Sensor array

FIG. 63

1  2  3  4  5

1. Horizontal single-angle LCPG
2. Horizontal double-angle LCPG
3. Vertical single-angle LCPG
4. Vertical double-angle LCPG
5. Polarization control sheet

FIG. 64

FIG. 65

FIG. 66

FIG. 67

FIG. 68

FIG. 69

State A

State B

Projection lens group
(optional)

Optical element
(Optional)

Optical element

Beam selection device

Homogenizer

Receiving unit

Collimation lens group
(optional)

**Receive end**

Light source

**Projection end**

**Control Unit**

FIG. 70

FIG. 71

**TOF depth sensing module 500**

Collimation lens group 560

Light source 510

Optical element 520

Receiving unit 540

Control unit 550

Beam selection device 530

Receiving lens group 541

Sensor array 542

FIG. 72

**TOF depth sensing module 500**

Homogenizer 570

Light source
510

Optical element 520

**Receiving unit 540**

Beam selection
device 530

Control unit
550

Receiving lens group 541

Sensor array 542

FIG. 73

**TOF depth sensing module 500**

Collimation lens group 560    Homogenizer 570

Light source 510

Optical element 520

Receiving unit 540

Control unit 550

Beam selection device 530

Receiving lens group 541

Sensor array 542

FIG. 74

**TOF depth sensing module 500**

Homogenizer 570    Collimation lens group 560

Light source 510

Optical element 520

**Receiving unit 540**

Control unit 550

Beam selection device 530

Receiving lens group 541

Sensor array 542

FIG. 75

FIG. 76

FIG. 77

| | |
|---|---|
| Control a light source to generate a beam | ～ 7001 |

| | |
|---|---|
| Control an optical element to control a direction of the beam to obtain a first emergent beam and a second emergent beam at a same moment | ～ 7002 |

| | |
|---|---|
| Control a beam selection device to propagate, to different regions of a receiving unit, a third reflected beam obtained by a target object by reflecting the first emergent beam and a fourth reflected beam obtained by the target object by reflecting the second emergent beam | ～ 7003 |

| | |
|---|---|
| Generate a first depth map of the target object based on a TOF corresponding to the first emergent beam | ～ 7004 |

| | |
|---|---|
| Generate a second depth map of the target object based on a TOF corresponding to the second emergent beam | ～ 7005 |

FIG. 78

**TOF depth sensing module 600**

Light source 610

Optical element 620

**Receiving unit 640**

Beam splitter 630

Control unit 650

Receiving lens group 641

Sensor array 642

FIG. 79

**TOF depth sensing module 600**

Collimation lens group 660

Optical element 620

Light source 610

Receiving unit 640

Beam splitter 630

Control unit 650

Receiving lens group 641

Sensor array 642

FIG. 80

**TOF depth sensing module 600**

Homogenizer 670

Light source 610

Optical element 620

**Receiving unit 640**

Control unit 650

Beam splitter 630

Receiving lens group 641

Sensor array 642

FIG. 81

TOF depth sensing module 600

Collimation lens group 660    Homogenizer 670

Light source
610

Optical element 620

Receiving unit 640

Beam splitter 630

Control unit
650

Receiving lens group 641

Sensor array 642

FIG. 82

**TOF depth sensing module 600**

Homogenizer 670    Collimation lens group 660

Light source 610

Optical element 620

Receiving unit 640

Beam splitter 630

Control unit 650

Receiving lens group 641

Sensor array 642

FIG. 83

Linearly polarized light parallel to paper

Linearly polarized light perpendicular to paper

Left-handed circularly polarized light

Right-handed circularly polarized light

Single LCPG

Receiving lens group

Sensor array

Quarter-wave plate

A plurality of LCPGs

Diffractive optical element diffuser

Array light source

and

FIG. 84

FIG. 85

Linearly polarized light parallel to paper

Linearly polarized light perpendicular to paper

Left-handed circularly polarized light

Right-handed circularly polarized light

Quarter-wave plate

A plurality of LCPGs

Diffractive optical element diffuser

Array light source

and

Receiving lens group

Polarization filter

Sensor array

FIG. 86

| | | | |
|---|---|---|---|
| H polarization | V polarization | H polarization | V polarization |
| V polarization | H polarization | V polarization | H polarization |
| H polarization | V polarization | H polarization | V polarization |
| V polarization | H polarization | V polarization | H polarization |
| H polarization | V polarization | H polarization | V polarization |
| V polarization | H polarization | V polarization | H polarization |
| H polarization | V polarization | H polarization | V polarization |
| V polarization | H polarization | V polarization | H polarization |

FIG. 87

| Control a light source to generate a beam | 8001 |

| Control an optical element to control a direction of the beam to obtain a first emergent beam and a second emergent beam at a same moment | 8002 |

| Control a beam splitter to propagate, to different regions of a receiving unit, a third reflected beam obtained by a target object by reflecting the first emergent beam and a fourth reflected beam obtained by the target object by reflecting the second emergent beam | 8003 |

| Generate a first depth map of the target object based on a TOF corresponding to the first emergent beam | 8004 |

| Generate a second depth map of the target object based on a TOF corresponding to the second emergent beam | 8005 |

FIG. 88

**TOF depth sensing module 700**

FIG. 89

**TOF depth sensing module 700**

Collimation lens group 760

Light source 710

Optical element 720

**Receiving unit 740**

Control unit 750

Beam selection device 730

Receiving lens group 741

Sensor array 742

FIG. 90

**TOF depth sensing module 700**

Homogenizer 770

Light source
710

Optical element 720

**Receiving unit 740**

Beam selection
device 730

Control unit
750

Receiving lens group 741

Sensor array 742

FIG. 91

FIG. 92

FIG. 93

1: Drive voltage of a liquid crystal of a transmit end
2: Drive voltage of a state selection liquid crystal of a receive end
3: Signal received by a detector

FIG. 94

FIG. 95

Linearly polarized light parallel to paper

Linearly polarized light perpendicular to paper

Left-handed circularly polarized light

Right-handed circularly polarized light

Quarter-wave plate

A plurality of LCPGs

DOE

Array light source

Quarter-wave plate

Electrically controlled half-wave plate

Polarizer

Receiving lens group

Sensor array

or

FIG. 96

Linearly polarized light parallel to paper
Linearly polarized light perpendicular to paper

Left-handed circularly polarized light

Right-handed circularly polarized light

Quarter-wave plate
A plurality of LCPGs

Optical diffuser

Array light source

Quarter-wave plate
Electrically controlled half-wave plate
Polarizer
Receiving lens group
Sensor array

or

FIG. 97

FIG. 98

Oriented film                                    ITO electrode

z

x   Support   Wedge-shaped              Glass        Liquid crystal
               polymer                  substrate    molecule

◄─► : Polarization direction
      parallel to paper
●   : Polarization direction
      perpendicular to paper

FIG. 99

Oriented film                                    ITO electrode

z

x   Support   Wedge-shaped              Glass        Liquid crystal
               polymer                  substrate    molecule

◄─► : Polarization direction
      parallel to paper
●   : Polarization direction
      perpendicular to paper

FIG. 100

| | |
|---|---|
| Control a light source to generate a beam | ~ 9001 |

| | |
|---|---|
| Control an optical element to deflect the beam, to obtain an emergent beam | ~ 9002 |

| | |
|---|---|
| Control a beam selection device to select a beam in at least two polarization states from beams in each period of reflected beams of a target object, to obtain a received beam, and transmit the received beam to a receiving unit | ~ 9003 |

| | |
|---|---|
| Generate a depth map of the target object based on a TOF corresponding to the emergent beam | ~ 9004 |

FIG. 101

Rectangle E

Angle B

O

Angle A

FIG. 102

Rectangle F

Angle D

O

Angle C

FIG. 103

U

F

E

Scanning track

V

FIG. 104

S10510. Determine a coverage capability of a TOF depth sensing module

S10520. Determine a quantity of scanning times

S10530. Determine a value of a deflection angle

S10540. Determine an FOV of a first beam

FIG. 105

## INTERNATIONAL SEARCH REPORT

International application No.

**PCT/CN2020/142433**

### A. CLASSIFICATION OF SUBJECT MATTER

G01S 17/894(2020.01)i; G01S 7/481(2006.01)i; H01S 5/42(2006.01)i

According to International Patent Classification (IPC) or to both national classification and IPC

### B. FIELDS SEARCHED

Minimum documentation searched (classification system followed by classification symbols)

G01S; G02B; G03B; H01S

Documentation searched other than minimum documentation to the extent that such documents are included in the fields searched

Electronic data base consulted during the international search (name of data base and, where practicable, search terms used)

CNABS, CNTXT, VEN, USTXT, EPTXT, WOTXT: 深度, 相机, 飞行时间, 度越时间, 渡越时间, 阵列光源, 光源阵列, 垂直腔面发射激光器, 分束, 模式, 场景, 室内, 室外, 远, 近, depth, camera, TOF, time of flight, VCSEL, split+, mode, indoor, outdoor, far, near

### C. DOCUMENTS CONSIDERED TO BE RELEVANT

| Category* | Citation of document, with indication, where appropriate, of the relevant passages | Relevant to claim No. |
|---|---|---|
| Y | US 2019339364 A1 (QUALCOMM INCORPORATED) 07 November 2019 (2019-11-07) claims 1-30, description paragraphs [0043]-[0075] and figures 2-12 | 1-26, 41-42 |
| Y | CN 107257931 A (APPLE INC.) 17 October 2017 (2017-10-17) description paragraphs [0022], [0036]-[0051] and figure 1 | 1-26, 41-42 |
| A | CN 108106605 A (GOOGLE TECHNOLOGY HOLDINGS LLC) 01 June 2018 (2018-06-01) entire document | 1-42 |
| A | CN 106990659 A (SHENZHEN ORBBEC CO., LTD.) 28 July 2017 (2017-07-28) entire document | 1-42 |
| A | CN 107026392 A (SHENZHEN ORBBEC CO., LTD.) 08 August 2017 (2017-08-08) entire document | 1-42 |
| A | CN 107039885 A (SHENZHEN ORBBEC CO., LTD.) 11 August 2017 (2017-08-11) entire document | 1-42 |
| A | CN 109343070 A (SHENZHEN ORBBEC CO., LTD.) 15 February 2019 (2019-02-15) entire document | 1-42 |

☐ Further documents are listed in the continuation of Box C.  ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 March 2021** | **24 September 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088 China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2020/142433**

| Patent document cited in search report | | | Publication date (day/month/year) | Patent family member(s) | | | Publication date (day/month/year) |
|---|---|---|---|---|---|---|---|
| US | 2019339364 | A1 | 07 November 2019 | CN | 112055820 | A | 08 December 2020 |
| | | | | SG | 11202009416 X | A | 27 November 2020 |
| | | | | TW | 201945759 | A | 01 December 2019 |
| | | | | WO | 2019212786 | A1 | 07 November 2019 |
| | | | | IN | 202047046840 | A | 06 November 2020 |
| CN | 107257931 | A | 17 October 2017 | EP | 3259615 | B1 | 20 November 2019 |
| | | | | CN | 107257931 | B | 22 September 2020 |
| | | | | EP | 3259615 | A1 | 27 December 2017 |
| | | | | WO | 2016134321 | A1 | 25 August 2016 |
| | | | | US | 2016245903 | A1 | 25 August 2016 |
| | | | | US | 9921299 | B2 | 20 March 2018 |
| CN | 108106605 | A | 01 June 2018 | EP | 3527935 | A1 | 21 August 2019 |
| | | | | US | 2014240464 | A1 | 28 August 2014 |
| | | | | US | 9398287 | B2 | 19 July 2016 |
| | | | | EP | 2962062 | B1 | 30 October 2019 |
| | | | | WO | 2014133691 | A1 | 04 September 2014 |
| | | | | EP | 3527935 | B1 | 16 December 2020 |
| | | | | CN | 108106605 | B | 25 December 2020 |
| | | | | CN | 105393079 | A | 09 March 2016 |
| | | | | EP | 2962062 | A1 | 06 January 2016 |
| | | | | CN | 105393079 | B | 06 March 2018 |
| | | | | US | 10038893 | B2 | 31 July 2018 |
| | | | | US | 2017019658 | A1 | 19 January 2017 |
| CN | 106990659 | A | 28 July 2017 | CN | 206877029 | U | 12 January 2018 |
| CN | 107026392 | A | 08 August 2017 | US | 2019273905 | A1 | 05 September 2019 |
| | | | | WO | 2018209987 | A1 | 22 November 2018 |
| | | | | CN | 206908092 | U | 19 January 2018 |
| CN | 107039885 | A | 11 August 2017 | None | | | |
| CN | 109343070 | A | 15 February 2019 | CN | 209167538 | U | 26 July 2019 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010006472